# EUROPEAN PATENT APPLICATION

(11) **EP 4 769 480 A1**
(43) Date of publication of application: **01.07.2026**
(21) Application number: 24856339.7
(22) Date of filing: 09.08.2024
(51) Int. Cl.: H01L 21/02, H10D 30/01, H10D 62/80, H10D 30/60, H10N 30/06, H10N 30/853

(54) **ELECTRONIC DEVICE AND METHOD FOR MANUFACTURING SAME**

(30) Priority: 22.08.2023 JP 2023134583
(71) Applicant: Oki Electric Industry Co., Ltd., Minato-ku Tokyo 105-8460 (JP)
(72) Inventor: FURUTA, Hironori, Tokyo 105-8460 (JP); KOSAKA, Toru, Tokyo 105-8460 (JP); TANIGAWA, Kenichi, Tokyo 105-8460 (JP); HANAWA, Ryouhei, Tokyo 105-8460 (JP); ISHIKAWA, Takuma, Tokyo 105-8460 (JP); KITAJIMA, Yutaka, Tokyo 105-8460 (JP)
(74) Representative: Betten & Resch
(86) International application number: PCT/JP2024/028645
(87) International publication number: WO 2025/041648

(57) **Abstract**

An object of the present disclosure is to make it possible to excellently join a functional part to a substrate even when warpage of the functional part has occurred. An electronic device (10) includes a functional part (102), a substrate (130) that supports the functional part (102), a first metallic film (110) as an electrode deposited on a side of the functional part (102) facing the substrate (130), and a second metallic film (140) which is formed on the substrate (130) and to which the first metallic film (110) is joined. The functional part (102) includes a first surface (102a) that faces the substrate (130) via the first metallic film (110) and a second surface (102b) that extends from the first surface (102a) in a direction different from an extending direction of the first surface (102a). The first metallic film (110) is deposited from the first surface (102a) of the functional part (102) to a part of the second surface (102b).

## Description

### BACKGROUND OF THE INVENTION

### 1. Field of the Invention

The present disclosure relates to an electronic device and its manufacturing method.

### 2. Description of the Related Art

There has been known a technology of growing a functional part (functional layer) of a piezoelectric element layer, a semiconductor layer or the like on a growth substrate, peeling off the functional part from the growth substrate, and joining the functional part to a different substrate (see Patent Reference 1, for example).

Patent Reference 1: Japanese Patent Application Publication No. 2022-152676 (see abstract)

### SUMMARY OF THE INVENTION

In the conventional technology described above, when warpage of the functional part occurs, there is a possibility that the functional part cannot be excellently joined to the substrate.

The object of the present disclosure is to make it possible to excellently join the functional part to the substrate even when the warpage of the functional part occurs.

An electronic device in the present disclosure includes a functional part, a substrate that supports the functional part, a first metallic film as an electrode deposited on a side of the functional part facing the substrate, and a second metallic film which is formed on the substrate and to which the first metallic film is joined. The functional part includes a first surface that faces the substrate via the first metallic film and a second surface that extends from the first surface in a direction different from an extending direction of the first surface. The first metallic film is deposited from the first surface of the functional part to a part of the second surface.

A manufacturing method of an electronic device in the present disclosure includes depositing a first metallic film from a first surface of a functional part, which has the first surface and a second surface extending from the first surface in a direction different from an extending direction of the first surface, to a part of the second surface and joining the first metallic film deposited on the functional part and a second metallic film formed on a substrate together. A manufacturing method of an electronic device, includes separating a first substrate and a functional part, which is formed on the first substrate, from each other, depositing a first metallic film on a first surface of the functional part, the first surface being a surface separated from the first substrate, and joining the first metallic film deposited on the first substrate and a second metallic film formed on a second substrate different from the first substrate.

According to the present disclosure, even when the warpage of the functional part occurs, the functional part can be excellently joined to the substrate by joining the first metallic film deposited on the functional part and the second metallic film formed on the substrate together.

### BRIEF DESCRIPTION OF THE DRAWINGS

FIG. 1(A) is a cross-sectional view showing a growth substrate used for a manufacturing method of an electronic device in a first embodiment.
FIG. 1(B) is a cross-sectional view showing a process of forming a functional layer on a growth substrate.
FIG. 1(C) is a cross-sectional view (C) showing a process of patterning the growth substrate and the functional layer.
FIGS. 2(A) and 2(B) are cross-sectional views showing a process of etching the growth substrate in the manufacturing method of the electronic device in the first embodiment.
FIG. 2(C) is a cross-sectional view showing another example of the etching process in the manufacturing method of the electronic device in the first embodiment.
FIG. 3(A) is a cross-sectional view showing a process of separating the functional layer from the growth substrate in the manufacturing method of the electronic device in the first embodiment.
FIG. 3(B) is a cross-sectional view showing a process of forming a first metallic film in the manufacturing method of the electronic device in the first embodiment.
FIG. 4(A) is an enlarged cross-sectional view showing the functional layer and the first metallic film in the manufacturing method of the electronic device in the first embodiment.
FIG. 4(B) is a schematic diagram showing an angle between a first surface and a second surface of the functional layer in the manufacturing method of the electronic device in the first embodiment.
FIG. 5(A) is a cross-sectional view showing a process of transferring the functional layer to a device substrate in the manufacturing method of the electronic device in the first embodiment.
FIG. 5(B) is an enlarged cross-sectional view showing a second metallic film on the device substrate in the manufacturing method of the electronic device in the first embodiment.
FIG. 6(A) is a cross-sectional view showing a process of joining the metallic films of the functional layer and the device substrate together in the manufacturing method of the electronic device in the first embodiment.
FIG. 6(B) is a cross-sectional view showing a process of forming an electrode layer on the functional layer in the manufacturing method of the electronic device in the first embodiment.
FIGS. 7(A) and 7(B) are schematic diagrams showing a state of occurrence of peeling of the functional layer in a comparative example.
FIGS. 7(C) and 7(D) are schematic diagrams showing an effect of inhibiting the peeling of the functional layer in the first embodiment.
FIG. 8(A) is a cross-sectional view showing a growth substrate used for a manufacturing method of an electronic device in a second embodiment.
FIG. 8(B) is a cross-sectional view showing a process of forming a buffer layer and a functional part on the growth substrate in the manufacturing method of the electronic device in the second embodiment.
FIG. 8(C) is a cross-sectional view showing a process of patterning the growth substrate, the buffer layer and the functional part in the manufacturing method of the electronic device in the second embodiment.
FIG. 9(A) is a cross-sectional view showing a process of forming a Schottky electrode and a photoresist on the functional part in the manufacturing method of the electronic device in the second embodiment.
FIG. 9(B) is a cross-sectional view showing a process of patterning the Schottky electrode in the manufacturing method of the electronic device in the second embodiment.
FIG. 10(A) is a cross-sectional view showing a process of etching the growth substrate in the manufacturing method of the electronic device in the second embodiment.
FIG. 10(B) is a cross-sectional view showing a process of separating the functional part from the growth substrate in the manufacturing method of the electronic device in the second embodiment.
FIG. 11(A) is a cross-sectional view showing a process of removing the buffer layer in the manufacturing method of the electronic device in the second embodiment.
FIG. 11(B) is a cross-sectional view showing a process of depositing a first metallic film on an n+GaN layer of the functional part in the manufacturing method of the electronic device in the second embodiment.
FIGS. 12(A) to 12(E) are cross-sectional views showing the process of depositing the first metallic film in the manufacturing method of the electronic device in the second embodiment.
FIG. 13(A) is a cross-sectional view showing a process of transferring the functional part onto the device substrate in the manufacturing method of the electronic device in the second embodiment.
FIG. 13(B) is an enlarged cross-sectional view showing the second metallic film on the device substrate in the manufacturing method of the electronic device in the second embodiment.
FIG. 14(A) is a cross-sectional view showing a process of joining the metallic films of the functional part and the device substrate together in the manufacturing method of the electronic device in the second embodiment.
FIG. 14(B) is a cross-sectional view showing a process of forming an insulation layer and a wiring layer on the functional part in the manufacturing method of the electronic device in the second embodiment. .
FIG. 15(A) is a cross-sectional view showing a process of forming a buffer layer and a functional part on a growth substrate in a manufacturing method of an electronic device in a third embodiment.
FIG. 15(B) is a cross-sectional view showing a process of patterning the growth substrate, the buffer layer and the functional part in the manufacturing method of the electronic device in the third embodiment.
FIG. 16(A) is a cross-sectional view showing a process of etching the growth substrate in the manufacturing method of the electronic device in the third embodiment.
FIG. 16(B) is a cross-sectional view showing a process of separating the functional part from the growth substrate in the manufacturing method of the electronic device in the third embodiment.
FIG. 17(A) is a cross-sectional view showing a process of removing. the buffer layer in the manufacturing method of the electronic device in the third embodiment.
FIG. 17(B) is a cross-sectional view showing a process of depositing a first metallic film on the functional part in the manufacturing method of the electronic device in the third embodiment.
FIG. 17(C) is an enlarged cross-sectional view showing the first metallic film in the manufacturing method of the electronic device in the third embodiment.
FIG. 18(A) is a cross-sectional view showing a process of transferring the functional part onto the device substrate in the manufacturing method of the electronic device in the third embodiment.
FIG. 18(B) is an enlarged cross-sectional view showing the second metallic film on the device substrate in the manufacturing method of the electronic device in the third embodiment.
FIG. 19(A) is. a cross-sectional view showing a process of joining the metallic films of the functional part and the device substrate together in the manufacturing method of the electronic device in the third embodiment.
FIG. 19(B) is a cross-sectional view showing a process of forming a P electrode and an N electrode in the manufacturing method of the electronic device in the third embodiment.
FIG. 20(A) is a cross-sectional view showing a process of forming a buffer layer and a functional part on a growth substrate in a manufacturing method of an electronic device in a fourth embodiment.
FIG. 20(B) is a cross-sectional view showing a process of patterning the growth substrate, the buffer layer and the functional part in the manufacturing method of the electronic device in the fourth embodiment.
FIG. 21(A) is a cross-sectional view showing a process of etching the growth substrate in the manufacturing method of the electronic device in the fourth embodiment.
FIG. 21(B) is a cross-sectional view showing a process of separating the functional part from the growth substrate in the manufacturing method of the electronic device in the fourth embodiment.
FIG. 22(A) is a cross-sectional view showing a process of removing the buffer layer in the manufacturing method of the electronic device in the fourth embodiment.
FIG. 22(B) is a cross-sectional view showing a process of depositing a first metallic film on the functional part in the manufacturing method of the electronic device in the fourth embodiment.
FIG. 22(C) is an enlarged cross-sectional view showing the first metallic film in the manufacturing method of the electronic device in the fourth embodiment.
FIGS. 23(A) to 23(H) are cross-sectional views showing another example of the process of depositing the first metallic film in the manufacturing method of the electronic device in the fourth embodiment.
FIG. 24(A) is a cross-sectional view showing a process of transferring the functional part onto a device substrate in the manufacturing method of the electronic device in the fourth embodiment.
FIG. 24(B) is an enlarged cross-sectional view showing a second metallic film on the device substrate in the manufacturing method of the electronic device in the fourth embodiment.
FIG. 25(A) is a cross-sectional view showing a process of joining the metallic films of the functional part and the device substrate together in the manufacturing method of the electronic device in the fourth embodiment.
FIG. 25(B) is a cross-sectional view showing a process of forming an oxide film on the functional part in the manufacturing method of the electronic device in the fourth embodiment.
FIG. 26(A) is a cross-sectional view showing a process of forming an opening in the oxide film in the manufacturing method of the electronic device in the fourth embodiment.
FIG. 26(B) is a cross-sectional view showing a process of forming a trench in the functional part in the manufacturing method of the electronic device in the fourth embodiment.
FIG. 27(A) is a cross-sectional view showing a process of forming an oxide film and a photoresist in the trench in the manufacturing method of the electronic device in the fourth embodiment.
FIG. 27(B) is a cross-sectional view showing a process of forming openings in the photoresist in the manufacturing method of the electronic device in the fourth embodiment.
FIG. 28(A) is a cross-sectional view showing a process of exposing a pGaN layer of the functional part in the manufacturing method of the electronic device in the fourth embodiment. .
FIG. 28(B) is a cross-sectional view showing a process of forming openings in the photoresist in the manufacturing method of the electronic device in the fourth embodiment.
FIG. 29(A) is a cross-sectional view showing a process of forming source electrodes and a gate electrode in the manufacturing method of the electronic device in the fourth embodiment.
FIG. 29(B) is a cross-sectional view showing a process of removing the photoresist in the manufacturing method of the electronic device in the fourth embodiment.
FIG. 30(A) is a cross-sectional view showing a process of forming a buffer layer and a functional part on a growth substrate in a manufacturing method of an electronic device in a fifth embodiment.
FIG. 30(B) is a cross-sectional view showing a process of patterning the growth substrate, the buffer layer and the functional part in the manufacturing method of the electronic device in the fifth embodiment.
FIG. 31(A) is a cross-sectional view showing a process of forming a photoresist on the functional part in the manufacturing method of the electronic device in the fifth embodiment.
FIG. 31(B) is a cross-sectional view showing a process of forming a trench in the functional part in the manufacturing method of the electronic device in the fifth embodiment.
FIG. 32(A) is a cross-sectional view showing a process of forming an oxide film and the photoresist in the trench in the manufacturing method of the electronic device in the fifth embodiment.
FIG. 32(B) is a cross-sectional view showing a process of etching the growth substrate in the manufacturing method of the electronic device in the fifth embodiment.
FIG. 33(A) is a cross-sectional view showing a process of separating the functional part from the growth substrate in the manufacturing method of the electronic device in the fifth embodiment.
FIG. 33(B) is a cross-sectional view showing a process of removing the buffer layer in the manufacturing method of the electronic device in the fifth embodiment.
FIG. 34(A) is a cross-sectional view showing a process of depositing a first metallic film on the functional part in the manufacturing method of the electronic device in the fifth embodiment.
FIG. 34(B) is a cross-sectional view showing a process of transferring the functional part onto a device substrate in the manufacturing method of the electronic device in the fifth embodiment.
FIG. 35(A) is a cross-sectional view showing a process of forming a buffer layer and a functional part on a growth substrate in a manufacturing method of an electronic device in a sixth embodiment.
FIG. 35(B) is a cross-sectional view showing a first patterning process for the functional part in the manufacturing method of the electronic device in the sixth embodiment.
FIG. 36(A) is a cross-sectional view showing a second patterning process for the growth substrate, the buffer layer and the functional part in the manufacturing method of the electronic device in the sixth embodiment.
FIG. 36(B) is a cross-sectional view showing a process of etching the growth substrate in the manufacturing method of the electronic device in the sixth embodiment.
FIG. 37(A) is a cross-sectional view showing a process of separating the functional part from the growth substrate in the manufacturing method of the electronic device in the sixth embodiment.
FIG. 37(B) is a cross-sectional view showing a process of removing the buffer layer in the manufacturing method of the electronic device in the sixth embodiment.
FIG. 38(A) is a cross-sectional view showing a process of depositing a first metallic film on the functional part in the manufacturing method of the electronic device in the sixth embodiment.
FIG. 38(B) is an enlarged cross-sectional view showing the first metallic film in the manufacturing method of the electronic device in the sixth embodiment.
FIG. 39(A) is a cross-sectional view showing a process of transferring the functional part onto a device substrate in the manufacturing method of the electronic device in the sixth embodiment.
FIG. 39(B) is an enlarged cross-sectional view showing a second metallic film on the device substrate in the manufacturing method of the electronic device in the sixth embodiment.
FIG. 40(A) is a cross-sectional view showing a process of joining the metallic films of the functional part and the device substrate together in the manufacturing method of the electronic device in the sixth embodiment.
FIG. 40(B) is a cross-sectional view showing a process of forming an oxide film on the functional part in the manufacturing method of the electronic device in the sixth embodiment.
FIG. 41(A) is a cross-sectional view showing a process of forming an opening in the oxide film in the manufacturing method of the electronic device in the sixth embodiment.
FIG. 41(B) is a cross-sectional view showing a process of forming a trench in the functional part in the manufacturing method of the electronic device in the sixth embodiment.
FIG. 42(A) is a cross-sectional view showing a process of forming the oxide film and the photoresist in the trench in the manufacturing method of the electronic device in the sixth embodiment.
FIG. 42(B) is a cross-sectional view showing a process of forming openings in the photoresist in the manufacturing method of the electronic device in the sixth embodiment.
FIG. 43(A) is a cross-sectional view showing a process of exposing a pGaN layer of the functional part in the manufacturing method of the electronic device in the sixth embodiment.
FIG. 43(B) is a cross-sectional view showing a process of forming openings in the photoresist in the manufacturing method of the electronic device in the sixth embodiment.
FIG. 44 (A) is a cross-sectional view showing a process of forming source electrodes and a gate electrode in the manufacturing method of the electronic device in the sixth embodiment.
FIG. 44(B) is a cross-sectional view showing a process of removing the photoresist in the manufacturing method of the electronic device in the sixth embodiment.
FIG. 45(A) is a cross-sectional view showing a process of forming a buffer layer and a functional part on a growth substrate in a manufacturing method of an electronic device in a seventh embodiment.
FIG. 45(B) is a cross-sectional view showing a process of patterning the growth substrate, the buffer layer and the functional part in the manufacturing method of the electronic device in the seventh embodiment.
FIG. 46(A) is a cross-sectional view showing a process of forming an oxide film on the functional part in the manufacturing method of the electronic device in the seventh embodiment.
FIG. 46(B) is a cross-sectional view showing a process of forming a groove portion in the functional part in the manufacturing method of the electronic device in the seventh embodiment.
FIG. 47(A) is a cross-sectional view showing a process of growing an n-GaN layer in the groove portion of the functional part in the manufacturing method of the electronic device in the seventh embodiment.
FIG. 47(B) is a cross-sectional view showing a process of forming openings in the insulation film in the manufacturing method of the electronic device in the seventh embodiment.
FIG. 48(A) is a cross-sectional view showing a process of implanting ions into the n-GaN layer of the functional part in the manufacturing method of the electronic device in the seventh embodiment.
FIG. 48(B) is a cross-sectional view showing a process of forming the oxide film on the functional part in the manufacturing method of the electronic device in the seventh embodiment.
FIG. 49(A) is a cross-sectional view showing a process of etching the growth substrate in the manufacturing method of the electronic device in the seventh embodiment.
FIG. 49(B) is a cross-sectional view showing a process of separating the functional part from the growth substrate in the manufacturing method of the electronic device in the seventh embodiment.
FIG. 50(A) is a cross-sectional view showing a process of removing the buffer layer in the manufacturing method of the electronic device in the seventh embodiment.
FIG. 50(B) is a cross-sectional view showing a process of forming a first metallic film on the functional part in the manufacturing method of the electronic device in the seventh embodiment.
FIG. 50(C) is an enlarged cross-sectional view showing the first metallic film in the manufacturing method of the electronic device in the seventh embodiment.
FIG. 51(A) is a cross-sectional view showing a process of transferring the functional part onto a device substrate in the manufacturing method of the electronic device in the seventh embodiment.
FIG. 51(B) is an enlarged cross-sectional view showing a second metallic film on the device substrate in the manufacturing method of the electronic device in the seventh embodiment.
FIG. 52(A) is a cross-sectional view showing a process of forming an insulation film on the functional part in the manufacturing method of the electronic device in the seventh embodiment.
FIG. 52(B) is a cross-sectional view showing a process of patterning the insulation film in the manufacturing method of the electronic device in the seventh embodiment.
FIG. 53 is a cross-sectional view showing a process of forming source electrodes and a gate electrode in the manufacturing method of the electronic device in the seventh embodiment.

### DETAILED DESCRIPTION OF THE INVENTION

An electronic device and its manufacturing method in each embodiment will be described below with reference to the drawings. The electronic device is a piezoelectric device, a photoelectric conversion device, a semiconductor device or the like, for example. The photoelectric conversion device is an LED (Light-Emitting Diode) device or the like, for example. The semiconductor device is a Schottky barrier diode, a field effect transistor or the like, for example.

### (First Embodiment)

A first embodiment relates to an electronic device 10 as an AlN piezoelectric device and its manufacturing method.

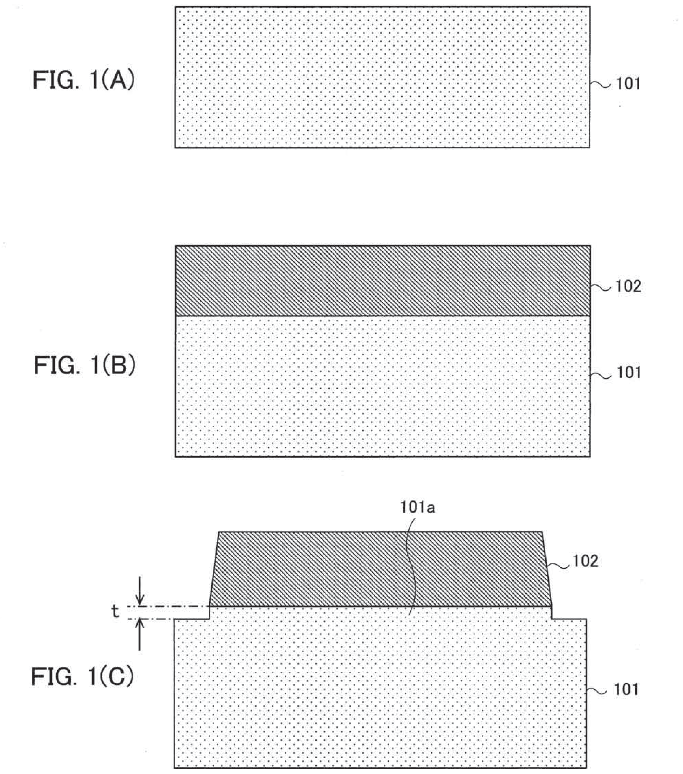

FIG. 1(A) is a cross-sectional view showing a growth substrate 101 as a first substrate used for the manufacturing method of the electronic device in the first embodiment. The growth substrate 101 shown in FIG. 1(A) is a Si (111) substrate, for example. Incidentally, the growth substrate 101 is not limited to Si (111); the growth substrate 101 only needs to be a substrate on which a functional layer 102 described next can be grown.

The following description will be given by defining a main surface (upper surface in FIG. 1(A)) of the growth substrate 101 as a reference and defining a stacking direction of layers stacked on the main surface as an upward direction.

FIG. 1(B) is a cross-sectional view showing a process of forming the functional layer 102. As shown in FIG. 1(B), the functional layer 102 which is an AlN (aluminum nitride) layer is epitaxially grown on the main surface of the growth substrate 101. The thickness of the functional layer 102 is 2 to 50 µm.

FIG. 1(C) is a cross-sectional view showing a process of patterning the growth substrate 101 and the functional layer 102. As shown in FIG. 1(C), the growth substrate 101 and the functional layer 102 are patterned into an element shape. The patterning is executed by forming a not-shown photoresist (mask) on the functional layer 102 and performing dry etching.

The dry etching is performed until a depth t of the growth substrate 101 from its main surface reaches 50 nm to 10000 nm. The depth t is referred to also as an over-etching amount. By this process, a sacrificial layer 101a having approximately the same area as the lower surface of the functional layer 102 is formed at the main surface of the growth substrate 101. A dry etching condition is set so that side faces of the functional layer 102 are formed as inclined surfaces.

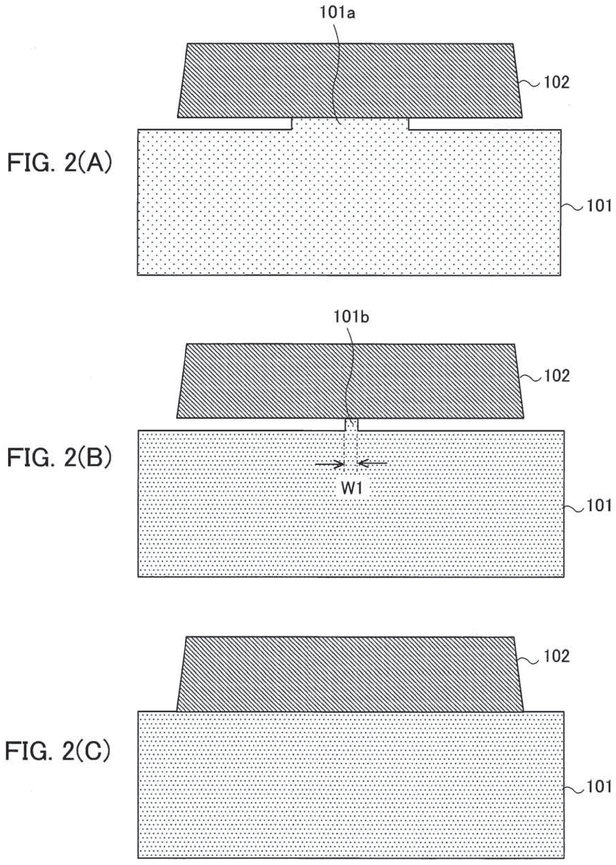

FIGS. 2(A) and 2(B) are cross-sectional views showing a process of etching the growth substrate 101. As shown in FIG. 2(A), the growth substrate 101 is etched in its surface direction, namely, a (100) direction, by means of wet etching using KOH (potassium hydroxide).

With the progress of the etching, the area of the sacrificial layer 101a of the growth substrate 101 decreases. As shown in FIG. 2(B), the etching is ended in a state where the sacrificial layer 101a of the growth substrate 101 remains only at the center of the lower surface of the functional layer 102. Accordingly, the functional layer 102 is supported at its central part by a part (referred to as a connection part 101b) of the sacrificial layer 101a of the growth substrate 101.

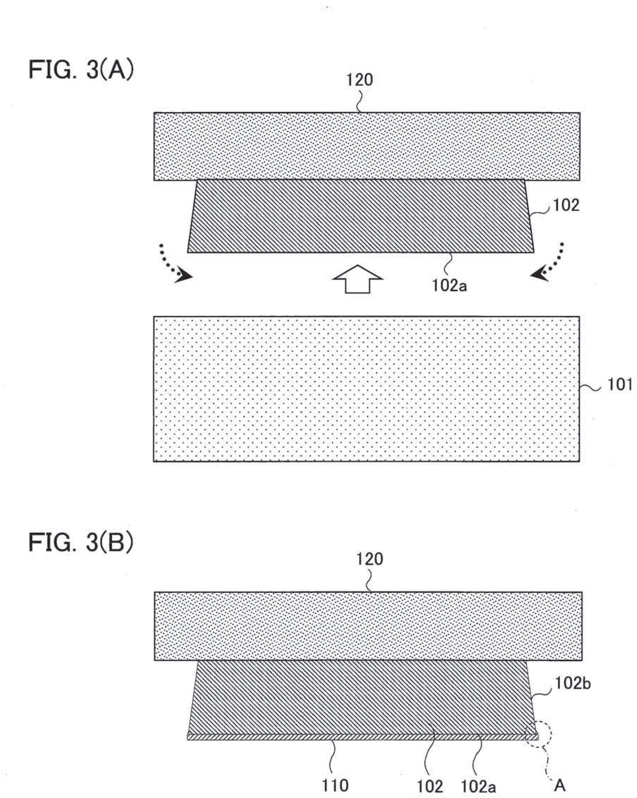

Since the connection part 101b is a part to be broken in a separation process (FIG. 3(A)) which will be described later, the area W1 of the connection part 101b is desired to be less than or equal to 10 % of the area of the lower surface of the functional layer 102.

Incidentally, while a part of the sacrificial layer 101a of the growth substrate 101 is left as the connection part 101b in FIG. 2(B), it is also possible to entirely remove the sacrificial layer 101a as shown in FIG. 2(C). In this case, by the removal of the sacrificial layer 101a, the functional layer 102 drops onto the main surface of the growth substrate 101 and is supported in the state where the functional layer 102 is placed on the main surface of the growth substrate 101.

FIG. 3(A) is a cross-sectional view showing a process of separating the functional layer 102 from the growth substrate 101. As shown in FIG. 3(A), a stamp 120 as a holding member is stuck onto the upper surface (surface on a side opposite to the growth substrate 101) of the functional layer 102. The stamp 120 is formed of an organic material, such as an organic resist, for example. The stamp 120 is desired to be a member having adhesiveness or tackiness on its surface.

By moving the stamp 120 in a direction away from the growth substrate 101, the connection part 101b (FIG. 2(B)) is broken and the lower surface 102a of the functional layer 102 separates from the main surface of the growth substrate 101. Namely, the functional layer 102 separates from the growth substrate 101.

Here, an a-axis lattice constant L₁₀₁ of the Si (111) substrate forming the growth substrate 101 is 3.89 [Å]. An a-axis lattice constant L₁₀₂ of AlN forming the functional layer 102 is 3.11 [Å]. These lattice constants are in a relationship L₁₀₁ > L₁₀₂.

Further, a thermal expansion coefficient T₁₀₁ of the Si (111) substrate forming the growth substrate 101 at room temperature is 2.4 × 10⁻⁶ to 4.4 × 10⁻⁶ [/K]. A thermal expansion coefficient T₁₀₂ of AlN forming the functional layer 102 at room temperature is 4.3 × 10⁻⁶ to 4.8 × 10⁻⁶ [/K]. These thermal expansion coefficients are in a relationship T₁₀₂ > T₁₀₁.

In the epitaxial growth process (FIG. 1(B)) described earlier, the functional layer 102 epitaxially grows in a state where tensile stress acts thereon so that its lattice constant coincides with the lattice constant of the growth substrate 101. When the functional layer 102 is thereafter cooled down to room temperature, the functional layer 102 contracts more than the growth substrate 101 due to a thermal expansion difference and the warpage of the functional layer 102 occurs. The warpage of the functional layer 102 becomes obvious in a state where the functional layer 102 has been separated from the growth substrate 101 as shown in FIG. 3(A).

FIG. 3(B) is a cross-sectional view showing a process of forming a first metallic film 110. As shown in FIG. 3(B), the first metallic film 110 is deposited on the lower surface 102a (i.e., the surface separated from the growth substrate 101) of the functional layer 102.

The first metallic film 110 is an electrode for the functional layer 102, is a single layer of Mo (molybdenum), for example, and is deposited by sputtering or vapor deposition. For example, in a state where the functional layer 102 has been separated from the growth substrate 101 as shown in FIG. 3(A), metallic atoms for forming the first metallic film 110 are successively applied to the lower surface 102a, by which the first metallic film 110 is formed from the lower surface 102a to side faces 102b of the functional layer 102. Therefore, the first metallic film 110 can be deposited without the need of heating the functional layer 102 to a high temperature, and the stress acting on the functional layer 102 can be reduced.

Incidentally, the first metallic film 110 is not limited to a single layer of Mo but may also be formed of two layers of Mo and Ti (titanium) or two layers of Ti and Au (gold). The thickness of the first metallic film 110 is 100 nm to 10 µm, for example.

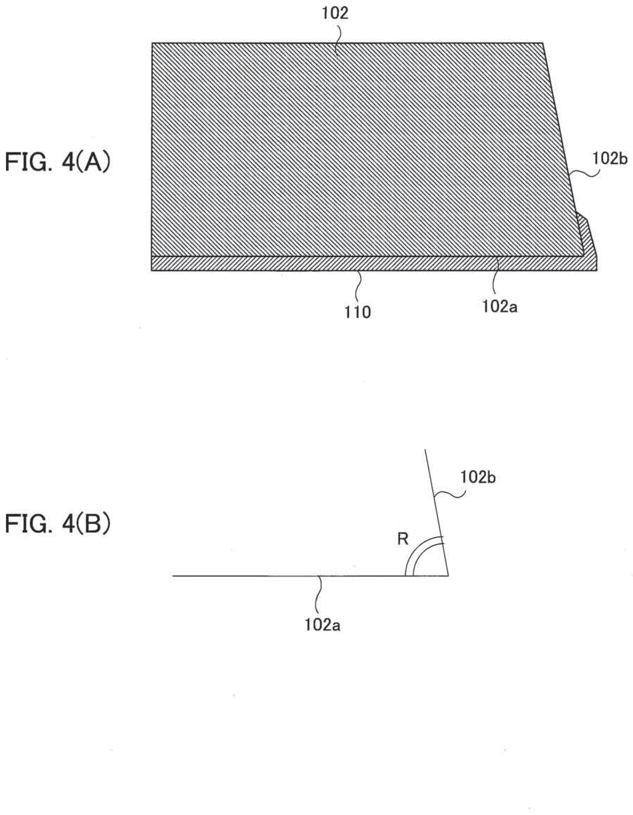

FIG. 4(A) is an enlarged diagram showing a part surrounded by a circle indicated by a reference character A in FIG. 3(B). The lower surface 102a of the functional layer 102 is the surface separated from the growth substrate 101. Each side face 102b of the functional layer 102 is a surface extending from the lower surface 102a in a direction different from an extending direction of the lower surface 102a. In this example, each side face 102b of the functional layer is an inclined surface that is inclined with respect to the lower surface 102a.

An inclination direction of the functional layer 102 is a direction with which the size of the functional layer 102 in a plane parallel to the lower surface 102a decreases as a distance from the lower surface 102a increases (i.e., decreases in an upward direction in FIGS. 4(A) and 4(B)).

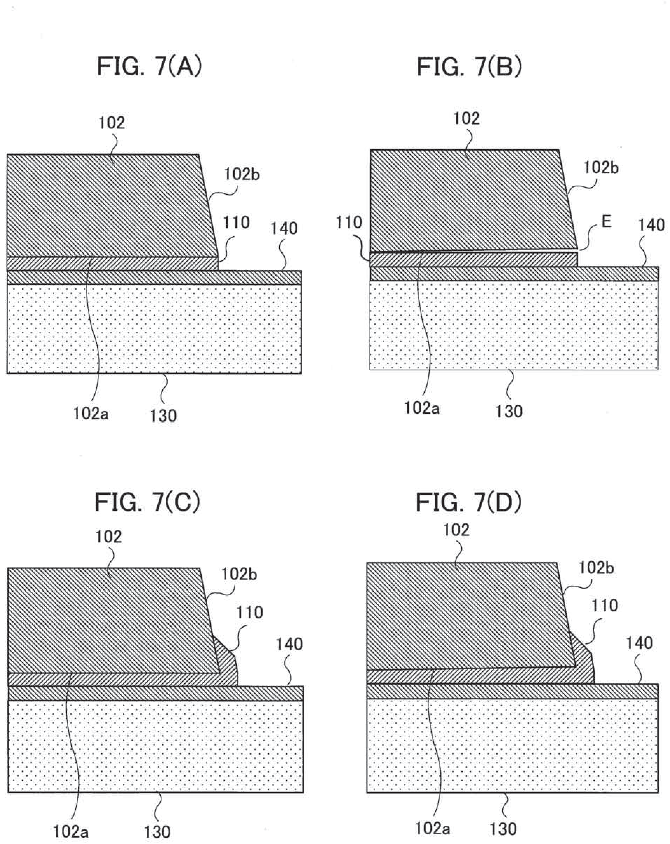

The first metallic film 110 is deposited on the lower surface 102a so as to extend to the side faces 102b of the functional layer 102. The first metallic film 110 functions to grip the lower surface 102a and the side faces 102b of the functional layer 102. Accordingly, unity of the first metallic film 110 and the functional layer 102 is increased and peeling of the functional layer 102 is prevented (see FIGS. 7(A) to 7(D) as will be explained later).

While the first metallic film 110 covers the whole of the lower surface 102a, it is sufficient that the first metallic film 110 covers at least a part of each side face 102b closer to the lower surface 102a.

FIG. 4(B) is a schematic diagram showing an angle formed by the lower surface 102a and the side face 102b of the functional layer 102. The angle R formed by the lower surface 102a and the side face 102b of the functional layer 102 is desired to be in a range of 45 [degrees] to 90 [degrees], and is especially desired to be greater than or equal to 60 [degrees] and less than 90 [degrees].

When the angle R is greater than 90 [degrees], the effect that the first metallic film 110 grips the lower surface 102a and the side faces 102b of the functional layer 102 is less likely to be obtained. When the angle R is less than 45 degrees, the area of the upper surface of the functional layer 102 is made small relative to the lower surface 102a, and thus a device area decreases. Therefore, the angle R is desired to be 45 [degrees] to 90 [degrees] as mentioned above.

Incidentally, this angle R can be adjusted by the setting of the dry etching condition in the patterning process of FIG. 1(C). The dry etching condition is, for example, the type and the flow rate of etching gas, density of plasma, bias voltage, the material and the thickness of the mask, or the like.

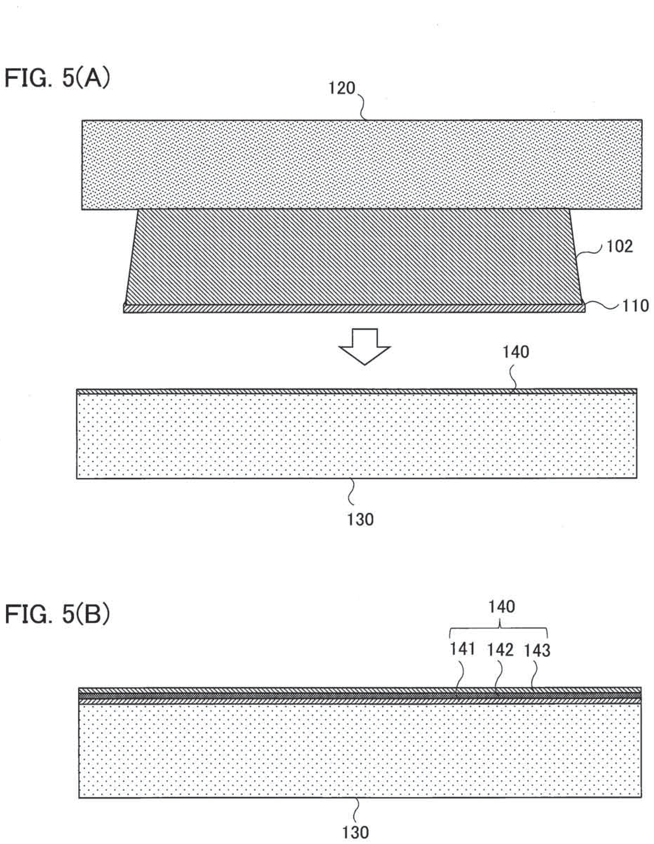

FIG. 5(A) is a cross-sectional view showing a process of transferring the functional layer 102 to a device substrate 130. As shown in FIG. 5(A), the functional layer 102 held by the stamp 120 is transferred onto the device substrate 130 as a second substrate. The device substrate 130 is a substrate different from the growth substrate 101 and is a Si substrate, for example. However, the device substrate 130 is not limited to Si, but may be made of SiC (silicon carbide), glass or the like, for example.

A second metallic film 140 is formed on the main surface of the device substrate 130. The second metallic film 140 is a multilayer film including a plurality of metallic layers. FIG. 5(B) is an enlarged cross-sectional view showing the second metallic film 140. As shown in FIG. 5(B), the second metallic film 140 includes a first layer 141 made of Ti, a second layer 142 made of Pt (platinum), and a third layer 143 made of Au that are successively stacked from the device substrate 130 side (lower side). .

The third layer 143 (Au) is a layer having excellent joinability to the aforementioned first metallic film 110. The first layer 141 (Ti) is a layer having excellent adhesiveness to the device substrate 130. Further, the second layer 142 (Pt) is provided between the third layer 143 and the first layer 141 so that Au in the third layer 143 and Ti in the first layer will not react with each other.

The thicknesses of each of the first layer 141 and the second layer 142 is 100 nm, for example. The thickness of the third layer 143 is 100 nm to 10 µm, for example. The first layer 141, the second layer 142 and the third layer 143 are formed by sputtering or vapor deposition. These layers hardly warp since these layers are not formed at high temperatures as in epitaxial growth. The second metallic film 140 is not limited to the combination of the Ti layer, the Pt layer and the Au layer but a different combination may be employed.

When the functional layer 102 is transferred onto the device substrate 130, the first metallic film 110 and the second metallic film 140 are stuck together by applying prescribed pressure thereto. Thereafter, the stamp 120 is peeled off and removed from the upper surface of the functional layer 102.

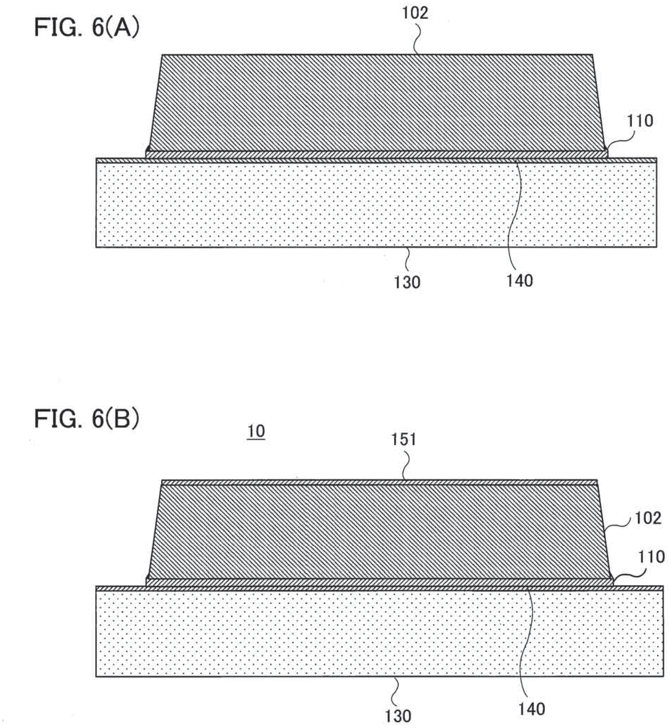

FIG. 6(A) is a cross-sectional view showing a process of joining the metallic films 110 and 140 of the functional layer 102 and the device substrate 130 together. In a state where the first metallic film 110 and the second metallic film 140 are stuck together as shown in FIG. 6(A), an annealing process is executed at 500 [°C] to 800 [°C].

By this process, the first metallic film 110 and the second metallic film 140 are joined together. By the pressing at the time of the sticking and the subsequent annealing process, the first metallic film 110 and the second metallic film 140 are excellently joined together with no gap even if the functional layer 102 has warpage.

FIG. 6(B) is a cross-sectional view showing a process of forming an electrode layer 151 on the functional layer 102. The electrode layer 151 is made of Pt, for example, and is formed by sputtering or vapor deposition. The electronic device 10 as a piezoelectric device (more specifically, a vertical type AlN piezoelectric device) is completed by connecting wiring respectively to the electrode layer 151 and the second metallic film 140 (the third layer 143) and connecting the wiring to a drive circuit or the like.

### <Function>

Functions of the first embodiment will be described below. In general, when the functional layer 102 is peeled off (separated) from the growth substrate 101 and transferred onto the device substrate 130, the warpage of the functional layer 102 may occur at the time of the peeling. Such warpage occurs not only in the case where the functional layer 102 is AlN but also in cases where the functional layer 102 is PZT (piezoelectric zirconate titanate), LN (lithium niobate) or LT (lithium tantalate). For electronic devices other than a piezoelectric element, such warpage may occur in cases where the functional layer 102 is a GaN (gallium nitride)-based or GaAs (gallium arsenide)-based semiconductor layer.

If the functional layer 102 having the warpage is joined to the device substrate 130, a gap occurs between the functional layer 102 and the device substrate 130, and an excellent joint condition cannot be obtained. This leads to deterioration in electric properties.

In contrast, in the first embodiment, the first metallic film 110 deposited on the functional layer 102 and the second metallic film 140 formed on the device substrate 130 are joined together by the pressing and the annealing process as shown in FIG. 6(A). Therefore, the first metallic film 110 and the second metallic film 140 can be excellently joined together even when the functional layer 102 has the warpage.

Further, in the first embodiment, the first metallic film 110 is deposited on the lower surface 102a so as to extend to the side faces 102b of the functional layer 102. Effects obtained by this deposition will be described below with reference to FIGS. 7(A) to 7(D).

FIGS. 7(A) and 7(B) are schematic diagrams showing the device substrate 130, the first metallic film 110 and the functional layer 102 in a comparative example. In the comparative example, the first metallic film 110 covers only the lower surface 102a of the functional layer 102. Residual stress that occurred at the time of the epitaxial growth remains in the functional layer 102 and acts in directions to cause the warpage of the functional layer 102. In the comparative example, the warpage of the functional layer 102 cannot be inhibited and the functional layer 102 may peel off from the first metallic film 110 as indicated by the reference character E in FIG. 7(B).

FIGS. 7(C) and 7(D) are schematic diagrams showing the device substrate 130, the first metallic film 110 and the functional layer 102 in the first embodiment. In the first embodiment, the first metallic film 110 is deposited on the lower surface 102a so as to extend to the side faces 102b of the functional layer 102 and functions to grip the lower surface 102a and the side faces 102b. Accordingly, the warpage of the functional layer 102 due to the residual stress can be inhibited and the peeling of the functional layer 102 can be prevented.

Further, since the first metallic film 110 (Mo) is situated between the third layer 143 (Au) of the second metallic film 140 and the functional layer 102 (AlN) , diffusion of Au into AlN is prevented and the functional layer 102 with stable properties can be obtained.

Especially since the first metallic film 110 extends to the side faces 102b of the functional layer 102, even if the second metallic film 140 is deformed in the annealing process, contact of the third layer 143 (Au) and the functional layer 102 (AlN) is prevented and the diffusion of Au into AlN is prevented more reliably.

### <Effect of First Embodiment>

As described above, the electronic device 10 in the first embodiment includes the functional layer 102 (functional part), the device substrate 130 as a substrate supporting the functional layer 102, the first metallic film 110 as an electrode deposited on a side of the functional layer 102 facing the device substrate 130, and the second metallic film 140 which is formed on the device substrate 130 and to which the first metallic film 110 is joined. The first metallic film 110 is deposited from the lower surface (first surface) 102a of the functional layer 102 to parts of the side faces (second surfaces) 102b.

Since the first metallic film 110 deposited on the functional layer 102 and the second metallic film 140 formed on the device substrate 130 are joined together as above, the functional layer 102 can be excellently joined to the device substrate 130 even when the warpage of the functional layer 102 has occurred. Especially since the first metallic film 110 is deposited from the lower surface 102a of the functional layer 102 to the parts of the side faces 102b, the unity of the first metallic film 110 and the functional layer 102 can be increased and the peeling of the functional layer 102 can be prevented.

Further, since the side face 102b of the functional layer 102 has the inclination with which the size of the functional layer 102 in a plane parallel to the lower surface 102a decreases in an upward direction (i.e., as a distance from the lower surface 102a increases), the first metallic film 110 is capable of performing the function of gripping the lower surface 102a and the side faces 102b of the functional layer 102 and the effect of preventing the peeling of the functional layer 102 can be enhanced.

Furthermore, since the functional layer 102 is a piezoelectric element layer containing AlN, the electronic device 10 can be formed as a piezoelectric device. Moreover, since the first metallic film 110 is deposited on the functional layer 102 (piezoelectric element layer), the functional layer 102 and the second metallic film 140 on the device substrate 130 can be electrically connected together via the first metallic film 110.

In addition, in the manufacturing method of the electronic device 10 in the first embodiment, the first metallic film 110 is deposited from the lower surface (first surface) 102a of the functional layer (functional part) 102, which is separated from the growth substrate 101 as the first substrate, to parts of the side faces (second surfaces) 102b, and the first metallic film 110 deposited on the functional layer 102 and the second metallic film 140 formed on the device substrate 130 as the second substrate different from the growth substrate 101 are joined together. Accordingly, even when the warpage of the functional layer 102 has occurred, the electronic device 10 in which the functional layer 102 is excellently joined to the device substrate 130 can be manufactured.

### (Second Embodiment)

A second embodiment relates to an electronic device 20 as a vertical type GaN semiconductor (more specifically, a Schottky barrier diode) and its manufacturing method.

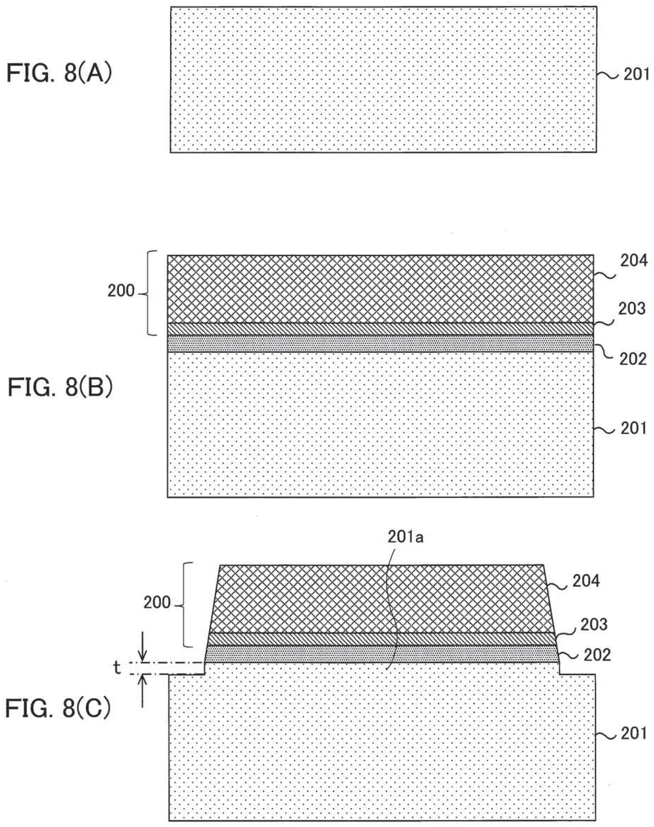

FIG. 8(A) is a cross-sectional view showing a growth substrate 201 used for the manufacturing method of the electronic device 20 in the second embodiment. The growth substrate 201 shown in FIG. 8(A) as a first substrate is a Si (111) substrate, for example. Incidentally, the growth substrate 201 is not limited to Si (111); the growth substrate 201 only needs to be a substrate on which a functional part 200 described below can be grown.

FIG. 8(B) is a cross-sectional view showing a process of forming a buffer layer 202 and the functional part 200. As shown in FIG. 8(B), the buffer layer 202 as an AlN layer is epitaxially grown on the main surface of the growth substrate 201. While the buffer layer 202 is a single layer of AlN in this example, the buffer layer 202 is not limited to this example. For example, the buffer layer 202 may also be a laminated body of an AlN layer and an AlGaN layer. The thickness of the buffer layer 202 is 200 nm to 1 µm, for example.

An n+GaN layer 203 as a contact layer is epitaxially grown on the buffer layer 202. The thickness of the n+GaN layer 203 is 500 nm to 3 µm, for example.

Further, an n-GaN layer 204 as a drift layer is epitaxially grown on the n+GaN layer 203. The thickness of the n-GaN layer 204 is 500 nm to 20 µm, for example.

The n+GaN layer 203 and the n-GaN layer 204 constitute the functional part (semiconductor thin film) 200.

FIG. 8(C) is a cross-sectional view showing a process of patterning the growth substrate 201, the buffer layer 202 and the functional part 200. As shown in FIG. 8(C), the growth substrate 201, the buffer layer 202 and the functional part 200 are patterned into the element shape. The patterning is executed by forming a not-shown photoresist on the n-GaN layer 204 and performing dry etching.

The dry etching is performed until the depth (over-etching amount) t of the growth substrate 201 from its main surface reaches 50 nm to 10000 nm. By this process, a sacrificial layer 201a having approximately the same area as the lower surface of the buffer layer 202 is formed at the main surface of the growth substrate 201.

The dry etching condition is set so that side faces of the functional part 200 are formed as inclined surfaces as explained in the first embodiment. Incidentally, the inclination direction of the functional part 200 is a direction with which the size of the functional part 200 in a plane parallel to the lower surface (lower surface 203a which will be described later) of the functional part 200 decreases in an upward direction (i.e., as a distance from the lower surface increases). While the description here is given of a case where the side faces of the functional part 200 are inclined surfaces, it is sufficient that at least side faces 203b (described later) of the n+GaN layer 203 (contact layer) are inclined surfaces.

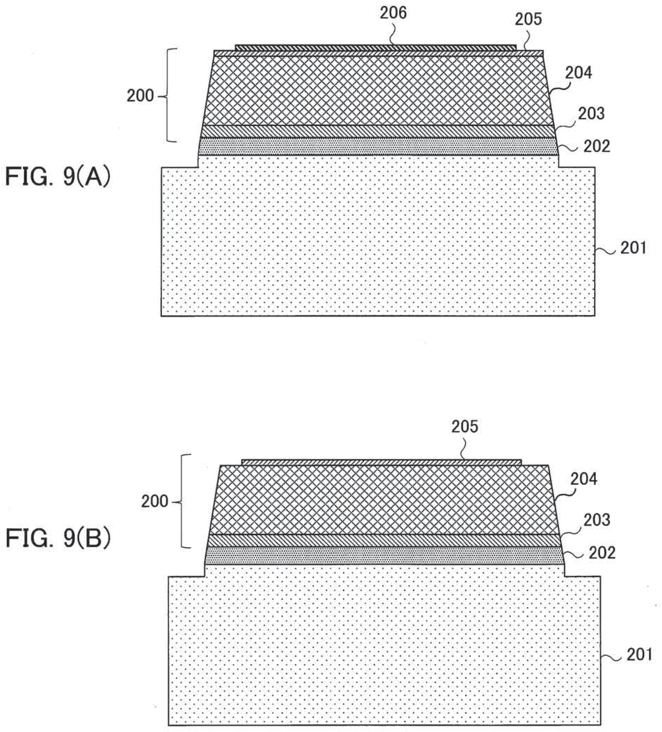

FIG. 9(A) is a cross-sectional view showing a process of forming a Schottky electrode 205 and a photoresist 206 on the functional part 200. As shown in FIG. 9(A), the Schottky electrode 205 is formed on the upper surface of the n-GaN layer 204. The Schottky electrode 205 is made of Ni (nickel), Pd (palladium), Mo or the like, for example, and is formed by sputtering or vapor deposition.

Further, the photoresist 206 for the patterning is formed on the Schottky electrode 205. The photoresist 206 is formed by spin coating, for example.

FIG. 9(B) is a cross-sectional view showing a process of patterning the Schottky electrode 205. As shown in FIG. 9(B), the Schottky electrode 205 is patterned via the photoresist 206 by dry etching or wet etching.

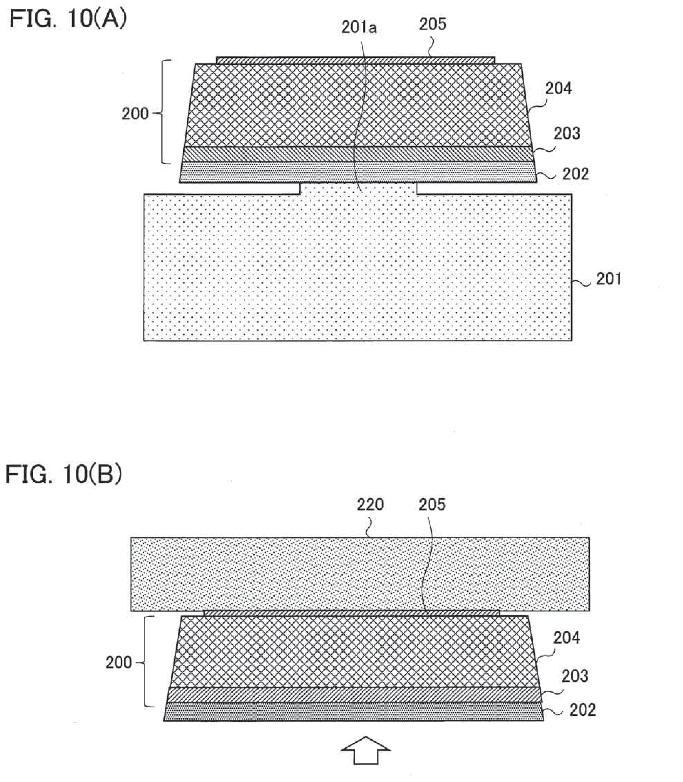

FIG. 10(A) is a cross-sectional view showing a process of etching the growth substrate 201. As shown in FIG. 10(A), the growth substrate 201 is etched in its surface direction, namely, the (100) direction, by means of wet etching using KOH.

The sacrificial layer 201a of the growth substrate 201 may be either partially etched as explained with reference to FIG. 2(B) in the first embodiment or entirely removed as explained with reference to FIG. 2(C). By this process, the functional part 200 becomes easily separable from the growth substrate 201. .

FIG. 10(B) is a cross-sectional view showing a process of separating the buffer layer 202, the functional part 200 and the Schottky electrode 205 from the growth substrate 201. As shown in FIG. 10(B), a stamp 220 as a holding member is stuck onto the upper surface of the Schottky electrode 205, and the buffer layer 202, the functional part 200 and the Schottky electrode 205 are separated from the growth substrate 201. The configuration of the stamp 220 is the same as that of the stamp 120 in the first embodiment.

Here, an a-axis lattice constant L₂₀₁ of the Si (111) substrate forming the growth substrate 201 is 3.89 [Å]. An a-axis lattice constant L₂₀₂ of AlN forming the buffer layer 202 is 3.11 [Å]. An a-axis lattice constant L₂₀₀ of GaN forming the functional part 200 (i.e., the n+GaN layer 203 and the n-GaN layer 204) is 3.19 [Å]. These lattice constants are in a relationship L₂₀₁ > L₂₀₀ > L₂₀₂.

Further, a thermal expansion coefficient T₂₀₁ of the Si (111) substrate forming the growth substrate 201 at room temperature is 2.4 × 10⁻⁶ to 4.4 × 10⁻⁶ [/K]. A thermal expansion coefficient T₂₀₂ of AlN forming the buffer layer 202 at room temperature is 4.3 × 10⁻⁶ to 4.8 × 10⁻⁶ [/K]. A thermal expansion coefficient T₂₀₀ of GaN forming the functional part 200 at room temperature is 3.72 × 10⁻⁶ to 5.45 × 10⁻⁶ [/K]. These thermal expansion coefficients are in a relationship T₂₀₀ > T₂₀₂ > T₂₀₁-

In the epitaxial growth process (FIG. 8(B)), the buffer layer 202 and the functional part 200 epitaxially grow in a state where tensile stress acts thereon so that their lattice constants coincide with the lattice constant of the growth substrate 201. When the buffer layer 202 and the functional part 200 are thereafter cooled down to room temperature, the buffer layer 202 and the functional part 200 contract more than the growth substrate 201 due to the thermal expansion difference and the warpage of the buffer layer 202 and the functional part 200 occurs. The warpage of the buffer layer 202 and the functional part 200 becomes obvious in a state where they have been separated from the growth substrate 201 as shown in FIG. 10(B).

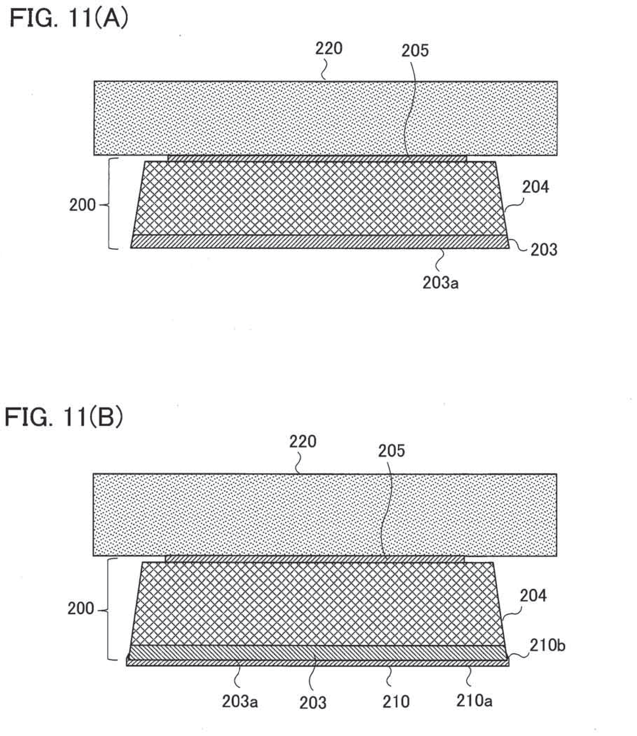

FIG. 11(A) is a cross-sectional view showing a process of removing the buffer layer 202. As shown in FIG. 11(A), the buffer layer 202 is removed from the functional part 200 by means of etching or polishing such as CMP (chemical mechanical polishing). By this process, the lower surface 203a of the n+GaN layer 203 of the functional part 200 is exposed. By the removal of the buffer layer 202, the warpage of the functional part 200 is mitigated, but is not totally eliminated.

FIG. 11(B) is a cross-sectional view showing a process of forming a first metallic film 210. As shown in FIG. 11(B), the first metallic film 210 is formed on the lower surface 203a of the n+GaN layer 203 of the functional part 200. The first metallic film 210 is an electrode for the n+GaN layer 203 and is formed of a multilayer film including a plurality of metallic layers.

The first metallic film 210 is deposited on the lower surface 203a so as to extend to the side faces 203b of the n+GaN layer 203. An angle formed by the lower surface 203a and the side face 203b of the n+GaN layer 203 is 45 [degrees] to 90 [degrees] and is preferably greater than or equal to 60 [degrees] and less than 90 [degrees] similarly to the angle R (FIG. 4(B)) explained in the first embodiment.

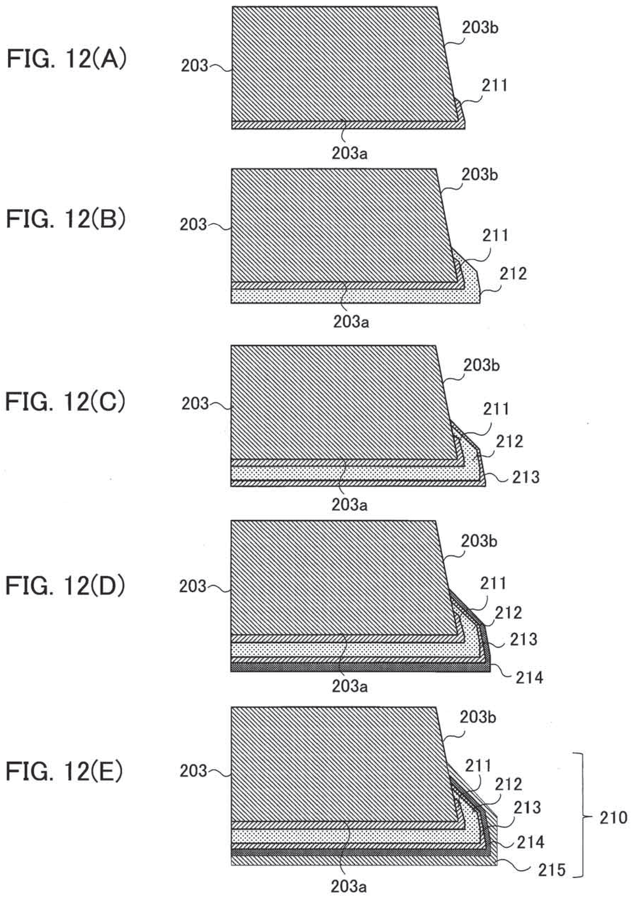

FIGS. 12(A) to 12(E) are cross-sectional views showing stepwise a method of forming the first metallic film 210. As shown in FIG. 12(A), a first layer 211 made of Ti is deposited on the lower surface 203a of the n+GaN layer 203 by sputtering or vapor deposition. The first layer 211 is deposited on the lower surface 203a so as to extend to the side faces 203b of the n+GaN layer 203.

Subsequently, as shown in FIG. 12(B), a second layer 212 made of Al is deposited on the first layer 211 by sputtering or vapor deposition. The second layer 212 is deposited so as to totally cover the first layer 211 and reach the side faces 203b of the n+GaN layer 203. .

Subsequently, as shown in FIG. 12(C), a third layer 213 made of Ti is deposited on the second layer 212 by sputtering or vapor deposition. The third layer 213 is deposited so as to totally cover the second layer 212 and reach the side faces 203b of the n+GaN layer 203.

Subsequently, as shown in FIG. 12(D), a fourth layer 214 made of Pt is deposited on the third layer 213 by sputtering or vapor deposition. The fourth layer 214 is deposited so as to totally cover the third layer 213 and reach the side faces 203b of the n+GaN layer 203. The fourth layer 214 is referred to also as a barrier metal layer.

Subsequently, as shown in FIG. 12(E), a fifth layer 215 made of Au is deposited on the fourth layer 214 by sputtering or vapor deposition. The fifth layer 215 is deposited so as to totally cover the fourth layer 214 and reach the side faces 203b of the n+GaN layer 203.

As above, the first layer 211 to the fifth layer 215 of the first metallic film 210 are respectively deposited that each layer totally covers its underlying layer and reaches the side faces 203b of the n+GaN layer 203.

Incidentally, in cases where a third layer 243 (Au) of a second metallic film 240 on a device substrate 230 which will be described later is thick, it is also possible to leave out the fifth layer 215 (Au) of the first metallic film 210 and form the first metallic film 210 in four-layer structure including the first layer 211 (Ti) to the fourth layer 214 (Pt).

The first metallic film 210 is deposited by sputtering, vapor deposition or the like. For example, in a state where the functional part 200 has been separated from the growth substrate 201 as shown in FIG. 11(A), metallic atoms for forming the first metallic film 210 are applied to the lower surface 203a, by which the first metallic film 210 is formed from the lower surface 203a to the side faces 203b.

In this case, since the side face 203b of the n+GaN layer 203 is an inclined surface having an angle of 45 [degrees] to 90 [degrees] (preferably, an angle greater than or equal to 60 [degrees] and less than 90 [degrees]) with respect to the lower surface 203a, the first metallic film 210 can be deposited so as not to contact the side face of the n-GaN layer 204. By preventing the first metallic film 210 from contacting the n-GaN layer 204, deterioration of voltage resistance of the n-GaN layer 204 (drift layer) can be prevented.

Further, since the fourth layer 214 (Pt) is formed between the second layer 212 (Al) and the fifth layer 215 (Au) of the first metallic film 210 so as to extend to the side faces 203b of the n+GaN layer as shown in FIGS. 12(D) and 12(E), an increase in electric resistance due to formation of a eutectic of Al and Au in the annealing process described later can be prevented.

It is also possible to use Mo instead of Pt as the fourth layer 214 as the barrier metal layer. In this case, the third layer 213 (Ti) may be left out.

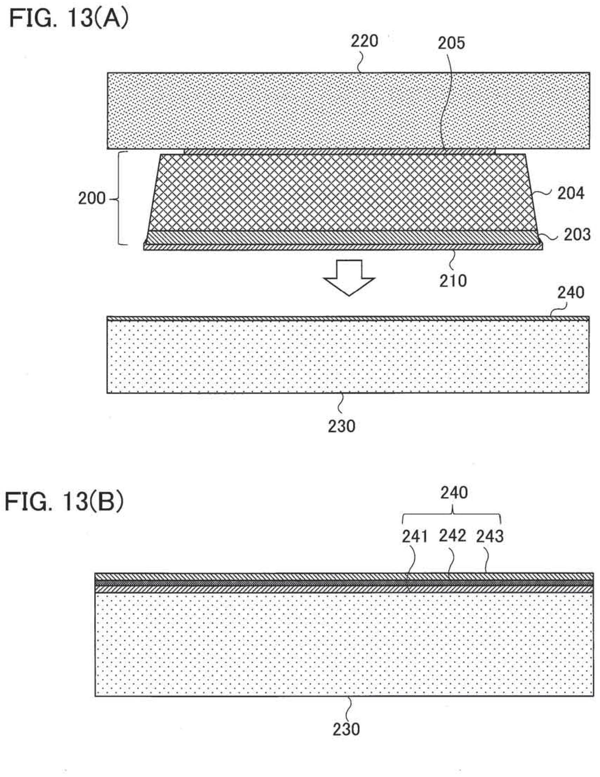

FIG. 13(A) is a cross-sectional view showing a process of transferring the functional part 200 onto the device substrate 230. As shown in FIG. 13(A), the functional part 200 held by the stamp 220 is transferred onto the device substrate 230 as a second substrate. The device substrate 230 is a substrate different from the growth substrate 201 and is a SiC substrate, for example. However, the device substrate 230 is not limited to SiC but may also be made of Si, glass or the like, for example.

The second metallic film 240 is formed on the main surface of the device substrate 230. FIG. 13(B) is an enlarged cross-sectional view showing the second metallic film 240 on the main surface of the device substrate 230. As shown in FIG. 13(B), the second metallic film 240 includes a first layer 241 made of Ti, a second layer 242 made of Pt, and a third layer 243 made of Au that are successively stacked from the device substrate 230 side (lower side).

The thickness of each of the first layer 241 and the second layer 242 is 100 nm, for example. The thickness of the third layer 243 is 100 nm to 10 µm, for example. The first layer 241, the second layer 242 and the third layer 243 are formed by sputtering or vapor deposition, and thus the warpage hardly occurs. Incidentally, the second metallic film 240 is not limited to the three layers of Ti, Pt and Au but may be a combination of different layers. .

When the functional part 200 is transferred onto the device substrate 230, the first metallic film 210 and the second metallic film 240 are stuck together by applying prescribed pressure thereto. Thereafter, the stamp 220 is peeled off and removed from the upper surface of the Schottky electrode 205.

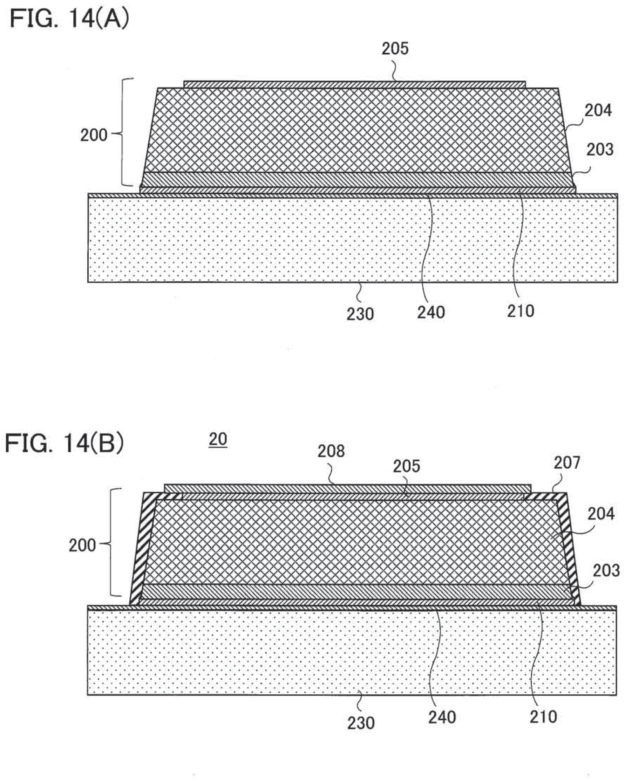

FIG. 14(A) is a cross-sectional view showing a process of joining the metallic films 210 and 240 of the functional part 200 and the device substrate 230 together. In a state where the first metallic film 210 and the second metallic film 240 are stuck together as shown in FIG. 14(A), the annealing process is executed at 500 [°C] to 800 [°C].

By this process, the first metallic film 210 and the second metallic film 240 are joined together. By the pressing at the time of the sticking and the subsequent annealing process, the first metallic film 210 and the second metallic film 240 are excellently joined together with no gap even if the functional part 200 has warpage.

Further, by the annealing process, ohmic contact is obtained between the n+GaN layer 203 of the functional part 200 and the first layer 211 (Ti) and the second layer 212 (Al) of the first metallic film 210. Furthermore, the fifth layer 215 (Au) as the outermost layer of the first metallic film 210 and the third layer 243 (Au) as the uppermost layer of the second metallic film 240 are integrated together.

FIG. 14(B) is a cross-sectional view showing a process of forming an insulation film 207 and a wiring layer 208 on the functional part 200. As shown in FIG. 14(B), the insulation film 207 is formed so as to cover parts of the functional part 200 other than the Schottky electrode 205. The insulation film 207 is an oxide film of SiO₂ (silicon dioxide) or the like, for example, and is formed by sputtering or vapor deposition.

Thereafter, the wiring layer 208 is formed so as to cover the upper surface of the Schottky electrode 205. The wiring layer 208 is formed of Au or Al, for example. The wiring layer 208 may also be a laminated body of a Ti layer and an Al layer.

Not-shown wiring is connected to the second metallic film 240 (the third layer 243) of the device substrate 230. By this process, the electronic device 20 as a vertical GaN semiconductor device (more specifically, a Schottky barrier diode) is completed.

While the Schottky electrode 205 is formed before separating the functional part 200 from the growth substrate 201 (see FIGS. 9(A) and 9(B)) in this example, it is also possible to form the Schottky electrode 205 after transferring the functional part 200 onto the device substrate 230. In this case, the Schottky electrode 205 and the wiring layer 208 may be formed integrally.

In the example described here, the first metallic film 210 deposited on the functional part 200 is formed of the Ti layer, the Al layer, the Ti layer, the Pt layer and the Au layer (the first layer 211 to the fifth layer 215) and the second metallic film 240 formed on the device substrate 230 is formed of the Au layer, the Pt layer and the Ti layer (the first layer 241 to the third layer 243).

However, the configuration of the metallic films 210 and 240 is not limited to the above-described example. As the configuration of the layers of the metallic films 210 and 240, 26 combinations shown in the following Table 1 are possible, for example:

In Table 1, regarding the layers of the first metallic film 210 on the functional part 200, a layer described more to the right is closer to a joint interface of the metallic films 210 and 240. Regarding the layers of the second metallic film 240 on the device substrate 230, a layer described more to the left is closer to the joint interface of the metallic films 210 and 240. For example, in a combination No. 1 shown below, the Au layer in the first metallic film 210 is the closest to the joint interface and the Au layer in the second metallic film 240 is the closest to the joint interface.

**TABLE 1.**

| No. | First Metal Film 210 | Second Metal Film 240 |
|---|---|---|
| 1 | Ti/Al/Ti/Pt/Au | Au/Pt/Ti |
| 2 | Ti/Al/Ti/Pt/Au | Pt/Ti |
| 3 | Ti/Al/Ti/Pt/Au | Au/Mo/Ti |
| 4 | Ti/Al/Ti/Pt/Au | Mo/Ti |
| 5 | Ti/Al/Ti/Pt/Au | Au/Mo |
| 6 | Ti/Al/Ti/Mo/Au | Au/Pt/Ti |
| 7 | Ti/Al/Ti/Mo/Au | Au/Mo/Ti |
| 8 | Ti/Al/Ti/Mo/Au | Pt/Ti |
| 9 | Ti/Al/Ti/Mo/Au | Mo/Ti |
| 10 | Ti/Al/Mo/Au | Au/Mo/Ti |
| 11 | Ti/Al/Mo/Au | Pt/Ti |
| 12 | Ti/Al/Mo/Au | Mo/Ti |
| 13 | Ti/Al/Mo/Au | Au/Pt/Ti |
| 14 | Ti/Al/Mo/Au | Au/Mo |
| 15 | Ti/Al/Mo/Au | Pt/Ti |
| 16 | Ti/Al/Mo/Au | Mo |
| 17 | Ti/Al/Mo/Au | Au/Mo |
| 18 | Ti/Al/Ti/Pt | Au/Pt/Ti |
| 19 | Ti/Al/Ti/Pt | Au/Mo/Ti |
| 20 | Ti/Al/Ti/Pt | Au/Mo |
| 21 | Ti/Al/Ti/Mo | Au/Pt/Ti |
| 22 | Ti/Al/Ti/Mo | Au/Mo/Ti |
| 23 | Ti/Al/Pt/Au | Mo |
| 24 | Ti/Al/Mo | Au/Pt/Ti |
| 25 | Ti/Al/Mo | Au/Mo/Ti |
| 26 | Ti/Al/Mo | Au/Mo |

The combinations shown in Table 1 are applicable not only to the metallic films 210 and 240 in the second embodiment but also to first and second metallic films in third to seventh embodiments which will be described later.

As described above, the electronic device 20 in the second embodiment includes the functional part 200, the device substrate 230 as a substrate supporting the functional part 200, the first metallic film 210 as an electrode deposited on a side of the functional part 200 facing the device substrate 230, and the second metallic film 240 which is formed on the device substrate 230 and to which the first metallic film 210 is joined. The first metallic film 210 is deposited from the lower surface (first surface) 202a of the functional part 200 to parts of the side faces (second surfaces) 203b. Therefore, similarly to the first embodiment, even when the warpage of the functional part 200 has occurred, the functional part 200 can be excellently joined to the device substrate 230 and the peeling of the functional part 200 can be prevented.

Further, the functional part 200 includes the n+GaN layer 203 as the contact layer and the n-GaN layer 204 as the drift layer, and the first metallic film 210 is formed on the n+GaN layer 203. Thus, the functional part 200 and the second metallic film 240 on the device substrate 230 can be electrically connected together via the first metallic film 210.

Furthermore, the fourth layer 214 (Pt) as the barrier metal layer is situated between the second layer 212 (Al) and the fifth layer 215 (Au) of the first metallic film 210 and situated also between the second layer 212 (Al) of the first metallic film 210 and the third layer 243 (Au) of the second metallic film 240. Therefore, eutectic reaction caused by contact of Al and Au can be prevented and a defective joint can be prevented.

### (Third Embodiment)

A third embodiment relates to an electronic device 30 as a vertical GaN light-emitting diode (LED) and its manufacturing method.

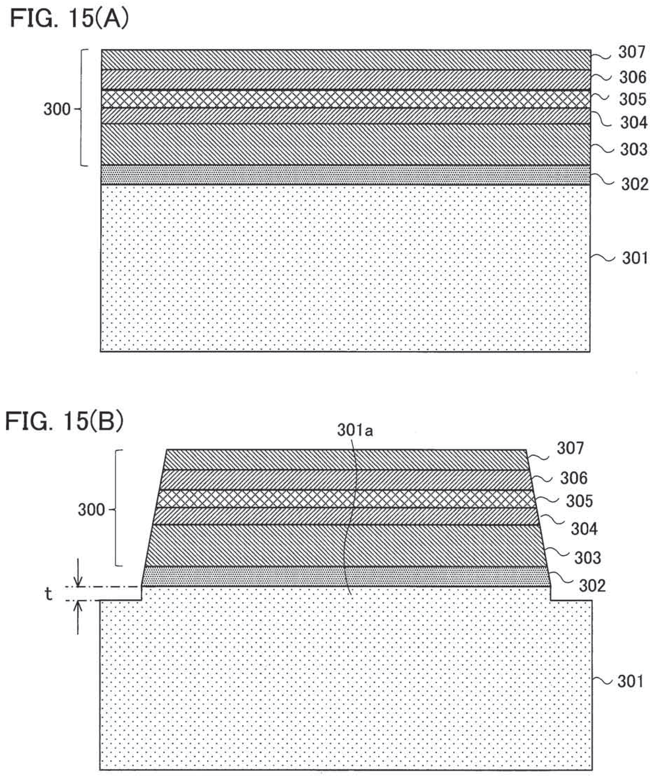

FIG. 15(A) is a cross-sectional view showing a process of forming a buffer layer 302 and a functional part 300 on a growth substrate 301 in the manufacturing method of the electronic device 30 in the third embodiment. The growth substrate 301 as a first substrate shown in FIG. 15(A) is a Si (111) substrate, for example. Incidentally, the growth substrate 301 is not limited to Si (111); the growth substrate 301 only needs to be a substrate on which the functional part 300 described later can be grown.

The buffer layer 302 as an AlN layer is epitaxially grown on the main surface of the growth substrate 301. While the buffer layer 302 is a single layer of AlN in this example, the buffer layer 302 is not limited to this example but may also be a laminated body of an AlN layer and an AlGaN layer, for example. The thickness of the buffer layer 302 is 200 nm to 1 µm, for example.

An nGaN layer 303 as a contact layer is epitaxially grown on the buffer layer 302. The thickness of the nGaN layer 303 is 2 µm, for example.

Subsequently, an nAlGaN layer 304 as a cladding layer is epitaxially grown on the nGaN layer 303. The thickness of the nAlGaN layer 304 is 100 nm to 300 nm, for example.

Further, an InGaN layer 305 as an active layer or a light emission layer is epitaxially grown on the nAlGaN layer 304. The InGaN layer 305 is an MQW (multiple quantum well) layer. The thickness of the InGaN layer 305 is 100 nm, for example.

Subsequently, a pAlGaN layer 306 as a cladding layer is epitaxially grown on the InGaN layer 305. The thickness of the pAlGaN layer 306 is 50 nm, for example.

Further, a pGaN layer 307 as a contact layer is epitaxially grown on the pAlGaN layer 306. The thickness of the pGaN layer 307 is 50 nm, for example.

The nGaN layer 303, the nAlGaN layer 304, the InGaN layer 305, the pAlGaN layer 306 and the pGaN layer 307 constitute the functional part (semiconductor thin film) 300.

FIG. 15(B) is a cross-sectional view showing a process of patterning the growth substrate 301, the buffer layer 302 and the functional part 300. As shown in FIG. 15(B), the growth substrate 301, the buffer layer 302 and the functional part 300 are patterned into the element shape. The patterning is executed by forming a not-shown photoresist on the pGaN layer 307 and performing dry etching.

The dry etching is performed until the depth (over-etching amount) t of the growth substrate 301 from its main surface reaches 50 nm to 10000 nm. By this process, a sacrificial layer 301a having approximately the same area as the lower surface of the buffer layer 302 is formed at the main surface of the growth substrate 301.

The dry etching condition is set so that side faces of the functional part 300 are formed as inclined surfaces as explained in the first embodiment. Incidentally, the inclination direction of the functional part 300 is a direction with which the size of the functional part 300 in a plane parallel to the lower surface (lower surface 303a which will be described later) of the functional part 300 decreases in an upward direction (i.e., as a distance from the lower surface increases). While the description here is given of a case where the side faces of the functional part 300 are inclined surfaces, it is sufficient that at least side faces 303b (described later) of the nGaN layer 303 (contact layer) are inclined surfaces.

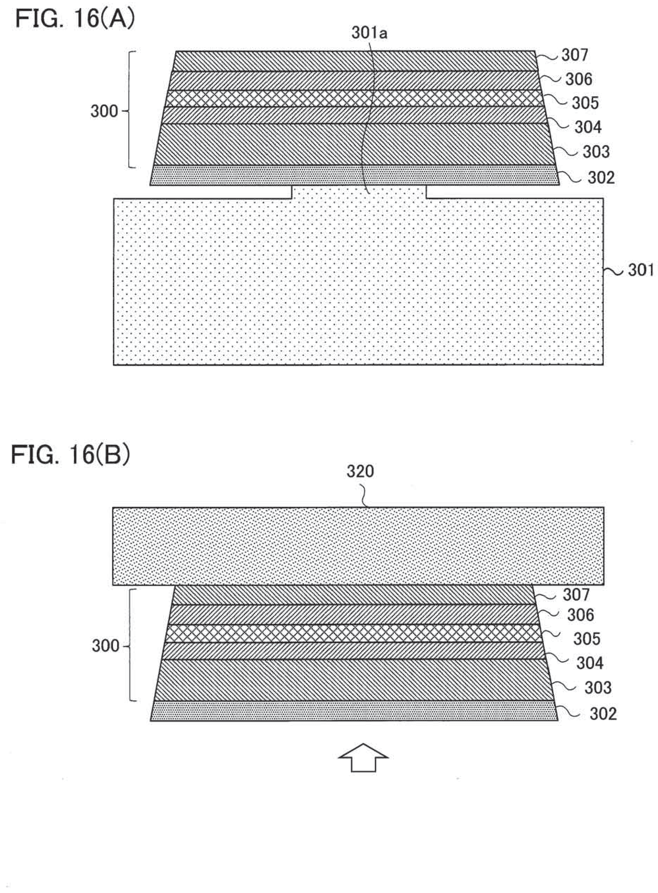

FIG. 16(A) is a cross-sectional view showing a process of etching the growth substrate 301. As shown in FIG. 16(A), the growth substrate 301 is etched in its surface direction, namely, the (100) direction, by means of wet etching using KOH.

The sacrificial layer 301a of the growth substrate 301 may be either partially etched as explained with reference to FIG. 2(B) in the first embodiment or entirely removed as explained with reference to FIG. 2(C). By this process, the functional part 300 becomes easily separable from the growth substrate 301.

FIG. 16(B) is a cross-sectional view showing a process of separating the buffer layer 302 and the functional part 300 from the growth substrate 301. As shown in FIG. 16(B), a stamp 320 as a holding member is stuck onto the upper surface (surface on a side opposite to the growth substrate 301) of the functional part 300, and the buffer layer 302 and the functional part 300 are separated from the growth substrate 301. The configuration of the stamp 320 is the same as that of the stamp 120 in the first embodiment.

Here, an a-axis lattice constant L₃₀₁ of the Si (111) substrate forming the growth substrate 301 is 3.89 [Å]. An a-axis lattice constant L₃₀₂ of AlN forming the buffer layer 302 is 3.11 [Å]. An a-axis lattice constant L₃₀₀ of GaN forming the layers of the functional part 300 is 3.19 [Å]. These lattice constants are in a relationship L₃₀₁ > L₃₀₀ > L₃₀₂.

Further, a thermal expansion coefficient T₃₀₁ of the Si (111) substrate forming the growth substrate 301 at room temperature is 2.4 × 10⁻⁶ to 4.4 × 10⁻⁶ [/K]. A thermal expansion coefficient T₃₀₂ of AlN forming the buffer layer 302 at room temperature is 4.3 × 10⁻⁶ to 4.8 × 10⁻⁶ [/K]. A thermal expansion coefficient T₃₀₀ of GaN forming the layers of the functional part 300 at room temperature is 3.72 × 10⁻⁶ to 5.45 × 10⁻⁶ [/K]. These thermal expansion coefficients are in a relationship T₃₀₀ > T₃₀₂ > T₃₀₁.

In the epitaxial growth process (FIG. 15(A)), the buffer layer 302 and the functional part 300 epitaxially grow in a state where tensile stress acts thereon so that their lattice constants coincide with the lattice constant of the growth substrate 301. When the buffer layer 302 and the functional part 300 are thereafter cooled down to room temperature, the buffer layer 302 and the functional part 300 contract more than the growth substrate 301 due to the thermal expansion difference and the warpage of the buffer layer 302 and the functional part 300 occurs. The warpage of the buffer layer 302 and the functional part 300 becomes obvious in a state where they have been separated from the growth substrate 301 as shown in FIG. 16(B).

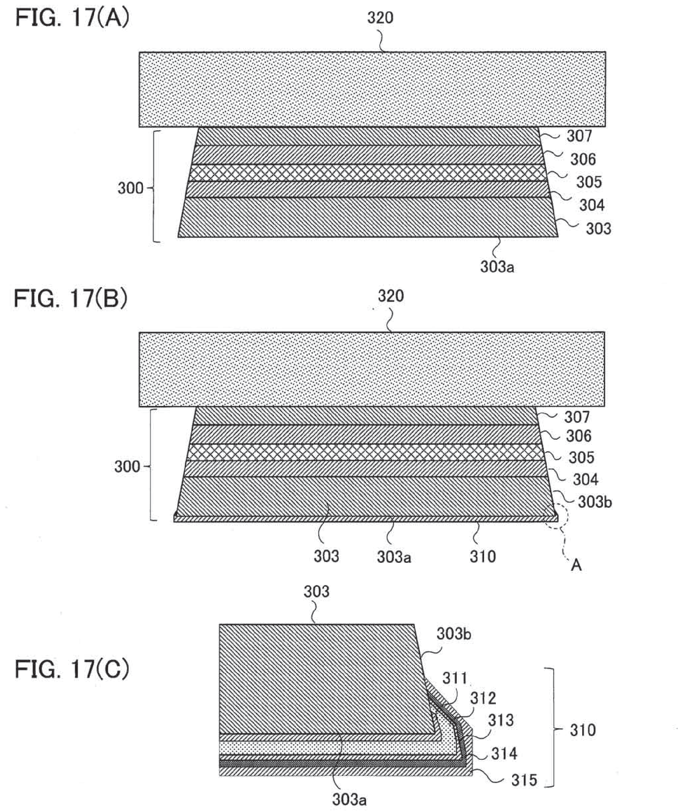

FIG. 17(A) is a cross-sectional view showing a process of removing the buffer layer 302. As shown in FIG. 17(A), the buffer layer 302 is removed from the functional part 300 by means of etching or polishing such as CMP. By this process, the lower surface 303a of the nGaN layer 303 of the functional part 300 is exposed. By the removal of the buffer layer 302, the warpage of the functional part 300 is mitigated, but is not totally eliminated. .

FIG. 17(B) is a cross-sectional view showing a process of forming a first metallic film 310. As shown in FIG. 17(B), the first metallic film 310 is deposited on the lower surface 303a of the nGaN layer 303 of the functional part 300. The first metallic film 310 is an electrode for the nGaN layer 303 and is formed of a multilayer film.

The first metallic film 310 is deposited on the lower surface 303a so as to extend to the side faces 303b of the nGaN layer 303. An angle formed by the lower surface 303a and the side face 303b of the nGaN layer 303 is 45 [degrees] to 90 [degrees] and is preferably greater than or equal to 60 [degrees] and less than 90 [degrees] similarly to the angle R (FIG. 4(B)) explained in the first embodiment.

FIG. 17(C) is an enlarged diagram showing a part surrounded by a circle indicated by the reference character A in FIG. 17(B). The first metallic film 310 includes a first layer 311 made of Ti, a second layer 312 made of Al, a third layer 313 made of Ti, a fourth layer 314 made of Pt, and a fifth layer 315 made of Au that are successively stacked from the nGaN layer 303 side. The fourth layer 314 is referred to also as a barrier metal layer. The method of depositing these layers is as explained earlier with reference to FIGS. 12(A) to 12(E) in the second embodiment.

As explained also in the second embodiment, the first metallic film 310 is deposited by sputtering, vapor deposition or the like. For example, in a state where the functional part 300 has been separated from the growth substrate 301 as shown in FIG. 17(A), metallic atoms for forming the first metallic film 310 are successively applied to the lower surface 303a, by which the first metallic film 310 is formed from the lower surface 303a to the side faces 303b.

In this case, since the side face 303b of the nGaN layer 303 is an inclined surface having an angle of 45 [degrees] to 90 [degrees] (preferably, an angle greater than or equal to 60 [degrees] and less than 90 [degrees]) with respect to the lower surface 303a, the first metallic film 310 can be deposited so as not to extend over the nAlGaN layer 304 and contact the side face of the InGaN layer 305.

Therefore, it is possible to prevent inflow of leak current into the InGaN layer 305 caused by the contact between the first metallic film 310 and the side face of the InGaN layer 305, and consequently, deterioration of luminous efficiency in the InGaN layer 305 (MQW layer) can be prevented. Incidentally, while the first metallic film 310 covers parts of the side faces 303b of the nGaN layer 303 in this example, the first metallic film 310 may further cover parts of side faces of the nAlGaN layer 304.

Further, since the fourth layer 314 (Pt) is formed between the second layer 312 (Al) and the fifth layer 315 (Au) of the first metallic film 310 extend to the side faces 303b of the nGaN layer 303 as shown in FIG. 17(C), the increase in the electric resistance due to the eutectic of Al and Au in the annealing process described later can be prevented.

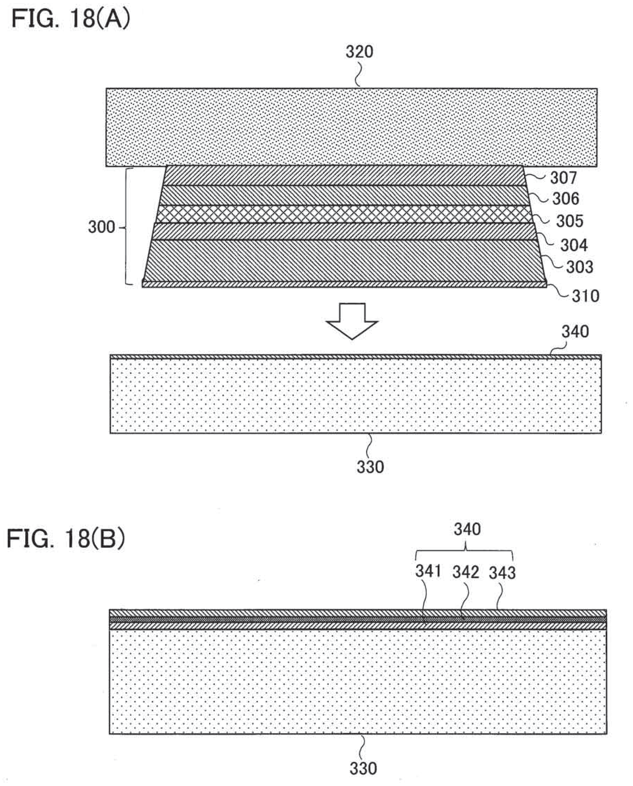

FIG. 18(A) is a cross-sectional view showing a process of transferring the functional part 300 onto a device substrate 330. As shown in FIG. 18(A), the functional part 300 held by the stamp 320 is transferred onto the device substrate 330 as a second substrate. The device substrate 330 is a substrate different from the growth substrate 301 and is a SiC substrate, for example. However, the device substrate 330 is not limited to SiC but may also be made of Si, glass or the like, for example.

A second metallic film 340 is formed on the main surface of the device substrate 330. FIG. 18(B) is an enlarged cross-sectional view showing the second metallic film 340 on the main surface of the device substrate 330. As shown in FIG. 18(B), the second metallic film 340 includes a first layer 341, a second layer 342 and a third layer 343 that are successively stacked from the device substrate 330 side (lower side).

The first layer 341 to the third layer 343 of the second metallic film 340 are respectively formed in the same way as the first layer 241 to the third layer 243 of the second metallic film 240 (FIG. 13(B)) in the second embodiment.

When the functional part 300 is transferred onto the device substrate 330, the first metallic film 310 and the second metallic film 340 are stuck together by applying prescribed pressure thereto. Thereafter, the stamp 320 is peeled off and removed from the upper surface of the functional part 300.

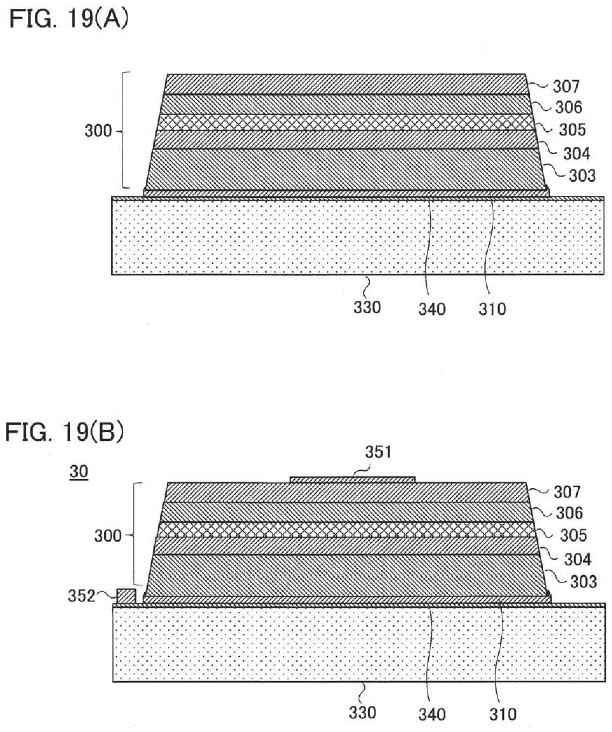

FIG. 19(A) is a cross-sectional view showing a process of joining the metallic films 310 and 340 of the functional part 300 and the device substrate 330 together. In a state where the first metallic film 310 and the second metallic film 340 are stuck together as shown in FIG. 19(A), the annealing process is executed at 500 [°C] to 800 [°C].

By this process, the first metallic film 310 and the second metallic film 340 are joined together. By the pressing at the time of the sticking and the subsequent annealing process, the first metallic film 310 and the second metallic film 340 are joined together with no gap even if the functional part 300 has warpage.

Further, by the annealing process, ohmic contact is obtained between the nGaN layer 303 of the functional part 300 and the first layer 311, the third layer 313 (Ti) and the second layer 312 (Al) of the first metallic film 310 (FIG. 17(C)). Furthermore, the fifth layer 315 (Au) as the outermost layer of the first metallic film 310 deposited on the functional part 300 and the third layer 343 (Au) as the uppermost layer of the second metallic film 340 on the device substrate 330 are integrated together.

FIG. 19(B) is a cross-sectional view showing a process of forming a P electrode 351 and an N electrode 352 on the functional part 300. As shown in FIG. 19(B), the P electrode 351 is formed on the pGaN layer 307 of the functional part 300. The P electrode 351 is formed of ITO (indium tin oxide) or Ni/Au, for example.

Further, the N electrode 352 is formed on the second metallic film 340 (the third layer 343) of the device substrate 330. The N electrode 352 is formed of Ti or a laminated body of Ti, Pt and Au. Incidentally, it is also possible to use the second metallic film 340 of the device substrate 330 as the electrode without forming the N electrode 352. By the above process, the electronic device 30 as a vertical GaN light-emitting diode is completed.

As described above, the electronic device 30 in the third embodiment includes the functional part 300, the device substrate 330 as a substrate supporting the functional part 300, the first metallic film 310 as an electrode deposited on a side of the functional part 300 facing the device substrate 330, and the second metallic film 340 which is formed on the device substrate 330 and to which the first metallic film 310 is joined. The first metallic film 310 is deposited from the lower surface (first surface) 303a to parts of the side faces (second surfaces) 303b of the functional part 300. Therefore, similarly to the first embodiment, even when the warpage of the functional part 300 has occurred, the functional part 300 can be excellently joined to the device substrate 330 and the peeling of the functional part 300 can be prevented.

Further, the functional part 300 includes the nGaN layer 303 as the contact layer and the semiconductor layers (the nAlGaN layer 304 to the pGaN layer 307) on the nGaN layer 303, and the first metallic film 310 is formed on the nGaN layer 303. Thus, the functional part 300 and the second metallic film 340 on the device substrate 330 can be electrically connected together via the first metallic film 310.

### (Fourth Embodiment)

A fourth embodiment relates to an electronic device 40 as a vertical GaN field effect transistor (FET) device having trench structure and its manufacturing method.

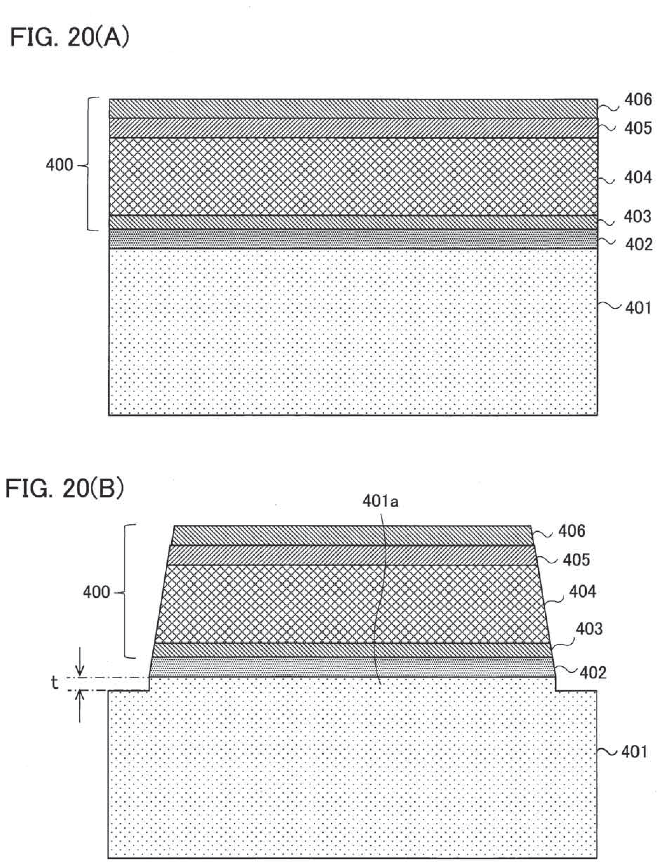

FIG. 20(A) is a cross-sectional view showing a process of forming a buffer layer 402 and a functional part 400 on a growth substrate 401 in the manufacturing method of the electronic device 40 in the fourth embodiment. The growth substrate 401 shown in FIG. 20(A) as a first substrate is a Si (111) substrate, for example. Incidentally, the growth substrate 401 is not limited to Si (111); the growth substrate 401 only needs to be a substrate on which the functional part 400 described later can be grown.

The buffer layer 402 as an AlN layer is epitaxially grown on the main surface of the growth substrate 401. While the buffer layer 402 is a single layer of AlN in this example, the buffer layer 402 is not limited to this example but may also be a laminated body of an AlN layer and an AlGaN layer, for example. The thickness of the buffer layer 402 is 200 nm to 1 µm, for example.

An n+GaN layer 403 as a contact layer is epitaxially grown on the buffer layer 402. The thickness of the n+GaN layer 403 is less than or equal to 5 µm, for example. Incidentally, while the thickness of the n+GaN layer 403 is greater than or equal to 100 µm when the n+GaN layer 403 is grown on a GaN substrate, the thickness can be made less than or equal to 5 µm by growing the n+GaN layer 403 on the growth substrate 401 (Si) via the buffer layer 402.

Subsequently, an n-GaN layer 404 as a drift layer is epitaxially grown on the n+GaN layer 403. The thickness of the n-GaN layer 404 is 2 µm to 50 µm, for example.

Further, a pGaN layer 405 as a contact layer is epitaxially grown on the n-GaN layer 404. The thickness of the pGaN layer 405 is less than or equal to 10 µm, for example.

Subsequently, an n+GaN layer 406 is epitaxially grown on the pGaN layer 405. The thickness of the n+GaN layer 406 is less than or equal to 1 µm, for example.

The n+GaN layer 403, the n-GaN layer 404, the pGaN layer 405 and the n+GaN layer 406 constitute the functional part (semiconductor thin film) 400.

FIG. 20(B) is a cross-sectional view showing a process of patterning the growth substrate 401, the buffer layer 402 and the functional part 400. As shown in FIG. 20(B), the growth substrate 401, the buffer layer 402 and the functional part 400 are patterned into the element shape. The patterning is executed by forming a not-shown photoresist on the functional part 400 and performing dry etching.

The dry etching is performed until the depth (over-etching amount) t of the growth substrate 401 from its main surface reaches 50 nm to 10000 nm. By this process, a sacrificial layer 401a having approximately the same area as the lower surface of the buffer layer 402 is formed at the main surface of the growth substrate 401.

The dry etching condition is set so that side faces of the functional part 400 are formed as inclined surfaces as explained in the first embodiment. Incidentally, the inclination direction of the functional part 400 is a direction with which the size of the functional part 400 in a plane parallel to the lower surface (lower surface 403a which will be described later) of the functional part 400 decreases in an upward direction (i.e., as a distance from the lower surface increases). While the description here is given of a case where the side faces of the functional part 400 are inclined surfaces, it is sufficient that at least side faces 403b (described later) of the n+GaN layer 403 (contact layer) are inclined surfaces.

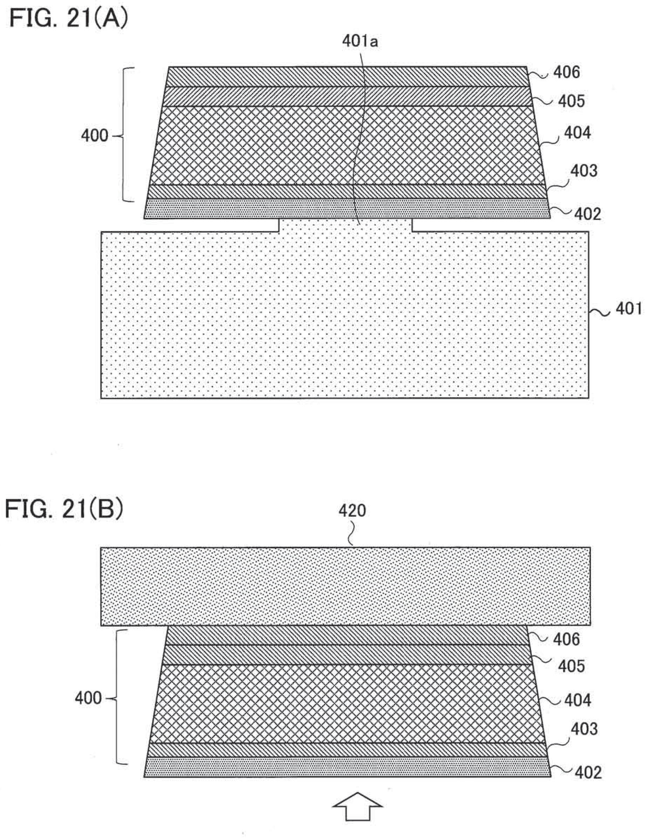

FIG. 21(A) is a cross-sectional view showing a process of etching the growth substrate 401. As shown in FIG. 21(A), the growth substrate 401 is etched in its surface direction, namely, the (100) direction, by means of wet etching using KOH.

The sacrificial layer 401a of the growth substrate 401 may be either partially etched as explained with reference to FIG. 2(B) in the first embodiment or entirely removed as explained with reference to FIG. 2(C). By this process, the functional part 400 becomes easily separable from the growth substrate 401.

FIG. 21(B) is a cross-sectional view showing a process of separating the buffer layer 402 and the functional part 400 from the growth substrate 401. As shown in FIG. 21(B), a stamp 420 as a holding member is stuck onto the upper surface (surface on a side opposite to the growth substrate 401) of the functional part 400, and the buffer layer 402 and the functional part 400 are separated from the growth substrate 401. The configuration of the stamp 420 is the same as that of the stamp 120 in the first embodiment.

Here, an a-axis lattice constant L₄₀₁ of the Si (111) substrate forming the growth substrate 401 is 3.89 [Å]. An a-axis lattice constant L₄₀₂ of AlN forming the buffer layer 402 is 3.11 [Å]. An a-axis lattice constant L₄₀₀ of GaN forming the layers of the functional part 400 is 3.19 [Å]. These lattice constants are in a relationship L₄₀₁ > L₄₀₀ > L₄₀₂.

Further, a thermal expansion coefficient T₄₀₁ of the Si (111) substrate forming the growth substrate 401 at room temperature is 2.4 × 10⁻⁶ [/K] to 4.4 × 10⁻⁶ [/K]. A thermal expansion coefficient T₄₀₂ of AlN forming the buffer layer 402 at room temperature is 4.3 × 10⁻⁶ [/K] to 4.8 × 10⁻⁶ [/K]. A thermal expansion coefficient T₄₀₀ of GaN forming the layers of the functional part 400 at room temperature is 3.72 × 10⁻⁶ [/K] to 5.45 × 10⁻⁶ [/K]. These thermal expansion coefficients are in a relationship T₄₀₀ > T₄₀₂ > T₄₀₁.

In the epitaxial growth process (FIG. 20(A)), the buffer layer 402 and the functional part 400 epitaxially grow in a state where tensile stress acts thereon so that their lattice constants coincide with the lattice constant of the growth substrate 401. When the buffer layer 402 and the functional part 400 are thereafter cooled down to room temperature, the buffer layer 402 and the functional part 400 contract more than the growth substrate 401 due to the thermal expansion difference and the warpage of the buffer layer 402 and the functional part 400 occurs. The warpage of the buffer layer 402 and the functional part 400 becomes obvious in a state where they have been separated from the growth substrate 401 as shown in FIG. 21(B).

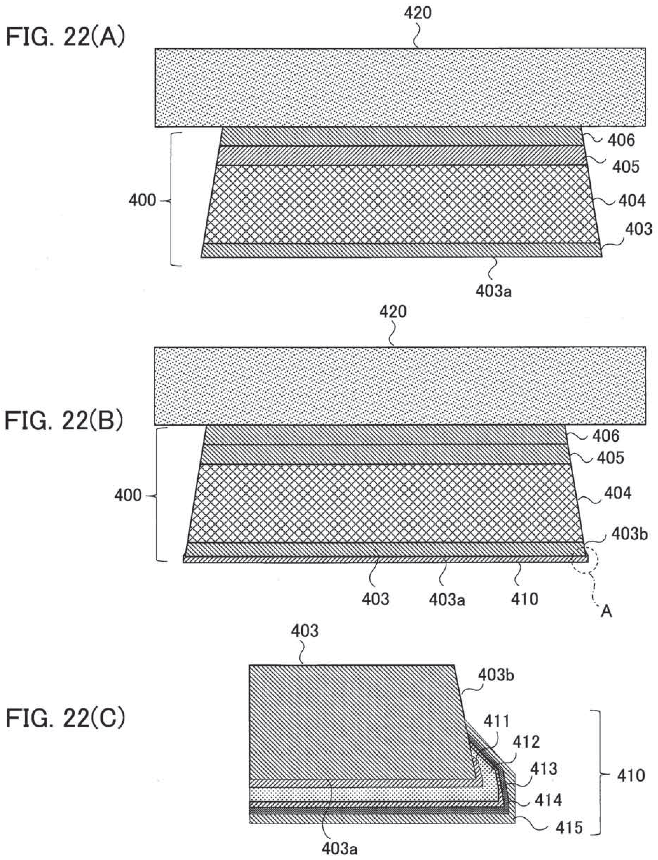

FIG. 22(A) is a cross-sectional view showing a process of removing the buffer layer 402. As shown in FIG. 22(A), the buffer layer 402 is removed from the functional part 400 by means of etching or polishing such as CMP. By this process, the lower surface 403a of the n+GaN layer 403 of the functional part 400 is exposed. By the removal of the buffer layer 402, the warpage of the functional part 400 is mitigated, but is not totally eliminated.

FIG. 22(B) is a cross-sectional view showing a process of depositing a first metallic film 410 on the functional part 400. As shown in FIG. 22(B), the first metallic film 410 is deposited on the lower surface 403a of the n+GaN layer 403 of the functional part 400. The first metallic film 410 is an electrode for the n+GaN layer 403 and is formed of a multilayer film.

The first metallic film 410 is deposited on the lower surface 403a so as to extend to the side faces 403b of the n+GaN layer 403. An angle formed by the lower surface 403a and the side face 403b of the n+GaN layer 403 is 45 [degrees] to 90 [degrees] and is preferably greater than or equal to 60 [degrees] and less than 90 [degrees] similarly to the angle R (FIG. 4(B)) explained in the first embodiment.

FIG. 22(C) is an enlarged diagram showing a part surrounded by a circle indicated by a reference character A in FIG. 22(B). The first metallic film 410 includes a first layer 411 made of Ti, a second layer 412 made of Al, a third layer 413 made of Ti, a fourth layer 414 made of Pt, and a fifth layer 415 made of Au that are successively stacked from the n+GaN layer 403 side. The method of depositing these layers is as explained earlier with reference to FIGS. 12(A) to 12(E) in the second embodiment.

As explained also in the second embodiment, the first metallic film 410 is deposited by sputtering, vapor deposition or the like. For example, in a state where the functional part 400 has been separated from the growth substrate 401 as shown in FIG. 22(A), for example, metallic atoms for forming the first metallic film 410 are successively applied to the lower surface 403a, by which the first metallic film 410 is formed from the lower surface 403a to the side faces 403b.

In this case, since the side face 403b of the n+GaN layer 403 is an inclined surface having an angle of 45 [degrees] to 90 [degrees] (preferably, an angle greater than or equal to 60 [degrees] and less than 90 [degrees]) with respect to the lower surface 403a, the first metallic film 410 can be deposited so as not to contact the side face of the n-GaN layer 404. By preventing the first metallic film 410 from contacting the n-GaN layer 404, deterioration of the voltage resistance of the n-GaN layer 404 (drift layer) can be prevented.

Further, since the fourth layer 414 (Pt) is formed between the second layer 412 (Al) and the fifth layer 415 (Au) of the first metallic film 410 so as to extend to the side faces 403b of the n+GaN layer 403 as shown in FIG. 22(C), the increase in the electric resistance due to the eutectic of Al and Au in the annealing process described later can be prevented.

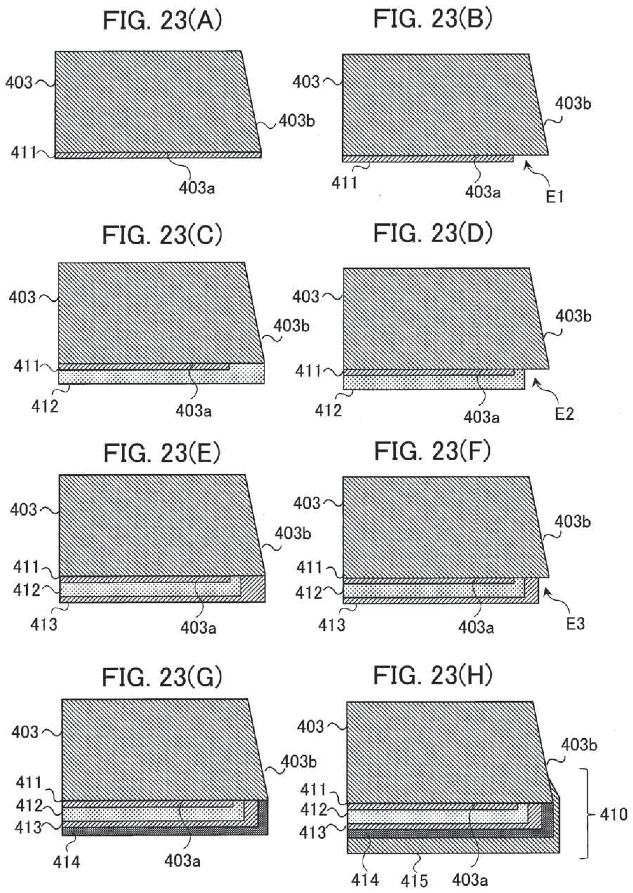

FIGS. 23(A) to 23(H) are cross-sectional views showing stepwise another example of the method of depositing the first metallic film 410. As shown in FIG. 23(A), the first layer 411 made of Ti is deposited on the lower surface 403a of the n+GaN layer 403 by sputtering or vapor deposition.

Thereafter, as shown in FIG. 23(B), an end part (more specifically, an end part close to the side face 403b of the n+GaN layer 403) E1 of the first layer 411 is removed by means of etching.

Subsequently, as shown in FIG. 23(C), the second layer 412 made of Al is deposited by sputtering or vapor deposition so as to cover the first layer 411. While the second layer 412 is deposited so as to cover the first layer 411 and cover the lower surface 403a exposed by the removal of the end part E1, the second layer 412 is not made to extend to the side face 403b.

Thereafter, as shown in FIG. 23(D), an end part E2 of the second layer 412 is removed by etching.

Subsequently, as shown in FIG. 23(E), the third layer 413 made of Ti is deposited by sputtering or vapor deposition so as to cover the second layer 412. While the third layer 413 is deposited so as to cover the second layer 412 and cover the lower surface 403a exposed by the removal of the end part E2, the third layer 413 is not made to extend to the side face 403b.

Thereafter, as shown in FIG. 23(F), an end part E3 of the third layer 413 is removed by etching.

Subsequently, as shown in FIG. 23(G), the fourth layer 414 made of Pt is deposited by sputtering or vapor deposition so as to cover the third layer 413. While the fourth layer 414 is deposited so as to cover the third layer 413 and cover the lower surface 403a exposed by the removal of the end part E3, the fourth layer 414 is not made to extend to the side face 403b.

Subsequently, as shown in FIG. 23(H), the fifth layer 415 made of Au is deposited by sputtering or vapor deposition so as to cover the fourth layer 414. The fifth layer 415 is deposited so as to cover the fourth layer 414, and extend to the side face 403b.

As above, the first layer 411 to the fifth layer 415 of the first metallic film 410 are deposited so that each layer totally covers its underlying layer. Among the first layer 411 to the fifth layer 415 of the first metallic film 410, only the fifth layer 415 extends to the side face 403b of the n+GaN layer 403.

Also in the case where the first metallic film 410 is deposited by the method shown in FIGS. 23(A) to 23(H), the angle formed by the lower surface 403a and the side face 403b of the n+GaN layer 403 is 45 [degrees] to 90 [degrees], and thus the first metallic film 410 can be prevented from contacting the side face of the n-GaN layer 404 and the deterioration of the voltage resistance of the n-GaN layer 404 can be prevented. Further, since the first metallic film 410 functions to grip the lower surface 102a and the side faces 403b of the n+GaN layer 403, the peeling of the functional part 400 can be prevented.

Furthermore, since the fourth layer 414 (Pt) is provided between the second layer 412 (Al) and the fifth layer 415 (Au) of the first metallic film 410, the increase in the electric resistance due to the eutectic of Al and Au in the annealing process can be prevented.

While only the fifth layer 415 among the first layer 411 to the fifth layer 415 of the first metallic film 410 extends to the side face 403b of the n+GaN layer 403 in the example shown in FIGS. 23(A) to 23(H), the configuration of the first metallic film 410 is not limited to this example and two or more layers including the fifth layer 415 may extend to the side face 403b.

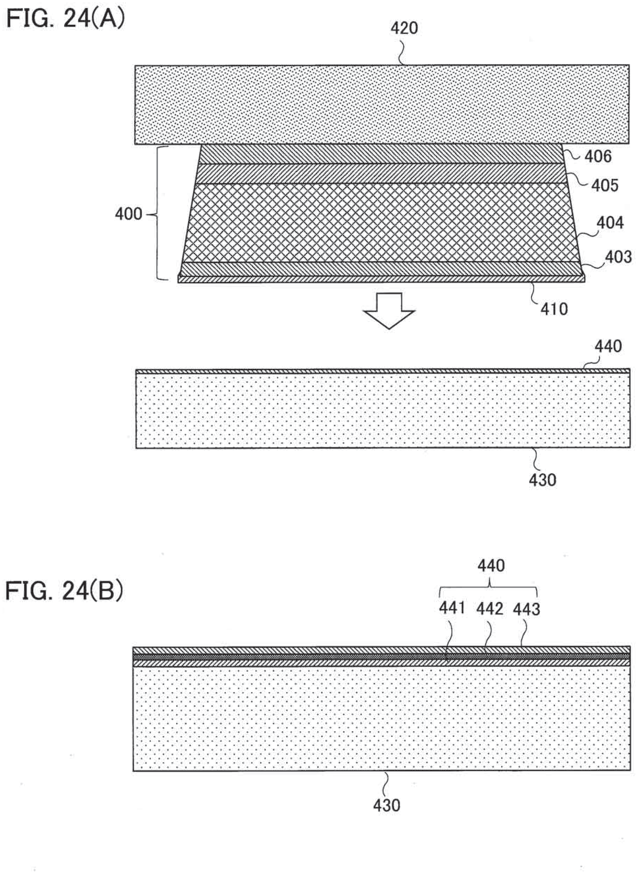

FIG. 24(A) is a cross-sectional view showing a process of transferring the functional part 400 onto a device substrate 430. As shown in FIG. 24(A), the functional part 400 held by the stamp 420 is transferred onto the device substrate 430 as a second substrate. The device substrate 430 is a substrate different from the growth substrate 401 and is a SiC substrate, for example. However, the device substrate 430 is not limited to SiC but may also be made of Si, glass or the like, for example.

A second metallic film 440 is formed on the main surface of the device substrate 430. FIG. 24(B) is an enlarged cross-sectional view showing the second metallic film 440 on the main surface of the device substrate 430. As shown in FIG. 24(B), the second metallic film 440 includes a first layer 441, a second layer 442 and a third layer 443 that are successively stacked from the device substrate 430 side (lower side).

The first layer 441 to the third layer 443 of the second metallic film 440 are respectively formed in the same way as the first layer 241 to the third layer 243 of the second metallic film 240 (FIG. 13(B)) in the second embodiment.

When the functional part 400 is transferred onto the device substrate 430, the first metallic film 410 and the second metallic film 440 are stuck together by applying prescribed pressure thereto. Thereafter, the stamp 420 is peeled off and removed from the upper surface of the functional part 400.

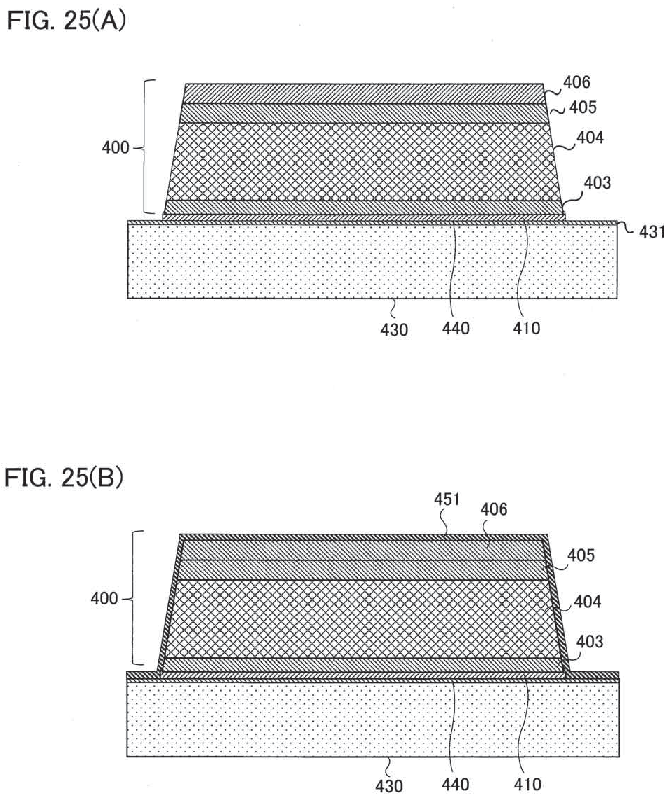

FIG. 25(A) is a cross-sectional view showing a process of joining the metallic films 410 and 440 of the functional part 400 and the device substrate 430 together. In a state where the first metallic film 410 deposited on the functional part 400 and the second metallic film 440 formed on the device substrate 430 are stuck together as shown in FIG. 25(A), the annealing process is executed at 500 [°C] to 800 [°C].

By this process, the first metallic film 410 and the second metallic film 440 are joined together. By the pressing at the time of the sticking and the subsequent annealing process, the first metallic film 410 and the second metallic film 440 are joined together with no gap even if the functional part 400 has warpage.

Further, by the annealing process, ohmic contact is obtained between the n+GaN layer 403 of the functional part 400 and the first layer 411 (Ti) and the second layer 412 (Al) of the first metallic film 410 (FIG. 22(C)). Furthermore, the fifth layer 415 (Au) as the outermost layer of the first metallic film 410 deposited on the functional part 400 and the third layer 443 (Au) as the uppermost layer of the second metallic film 440 on the device substrate 430 are integrated together.

FIG. 25(B) is a cross-sectional view showing a process of forming an insulation film 451 on the functional part 400. As shown in FIG. 25(B), the insulation film 451 is formed so as to cover the device substrate 430 and the functional part 400. The insulation film 451 is an oxide film of SiO₂, Al₂O₃ or the like, for example, has a thickness of approximately 10 nm to 1 µm, and is formed by sputtering or CVD (chemical vapor deposition).

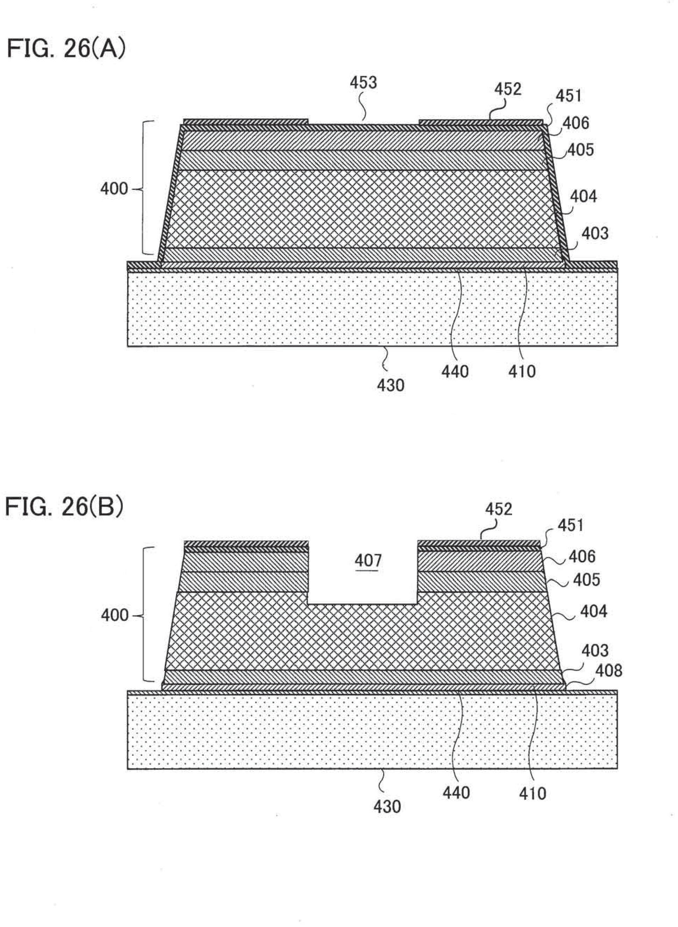

FIG. 26(A) is a cross-sectional view showing a process of forming a photoresist 452 on the insulation film 451 and executing the patterning. As shown in FIG. 26(A), the photoresist 452 is formed on the insulation film 451 covering the functional part 400 by spin coating, for example. Further, the photoresist 452 is patterned and an opening 453 is formed at a position of forming a trench which will be described below.

FIG. 26(B) is a cross-sectional view showing a process of forming a trench 407 in the functional part 400. As shown in FIG. 26(B), dry etching is performed via the photoresist 452 and thereby the trench 407 reaching the n-GaN layer 404 (drift layer) is formed in the functional part 400.

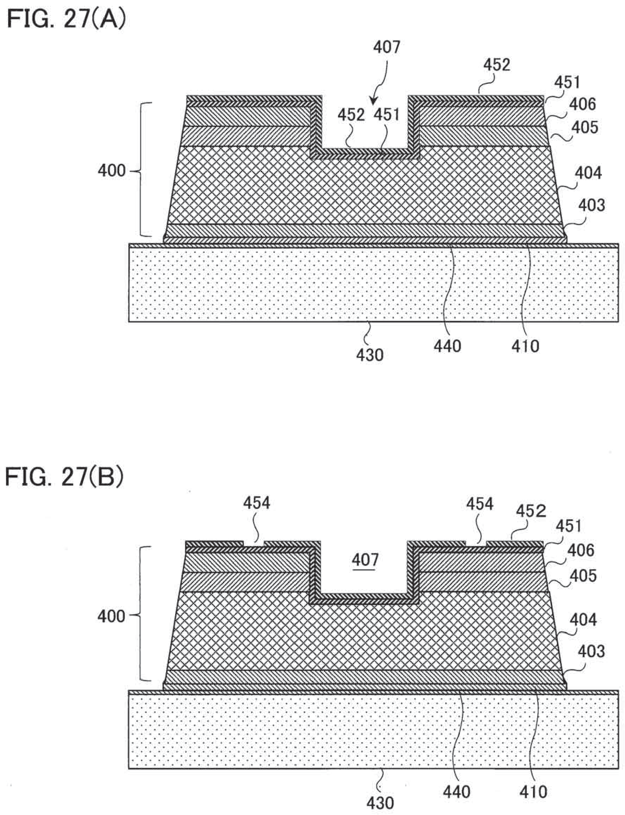

FIG. 27(A) is a cross-sectional view showing a process of forming the insulation film 451 and the photoresist 452 in the trench 407. As shown in FIG. 27(A), the insulation film 451 is formed so as to cover inner surfaces of the trench 407 by CVD or ALD (atomic layer deposition), for example. Further, the photoresist 452 is formed so as to cover the insulation film 451 in the trench 407 by spin coating, for example.

FIG. 27(B) is a cross-sectional view showing a process of forming openings 454 in the photoresist 452. As shown in FIG. 27(B), the photoresist 452 is exposed to light and developed and thereby the openings 454 are formed at positions of forming source electrodes 461 which will be described later.

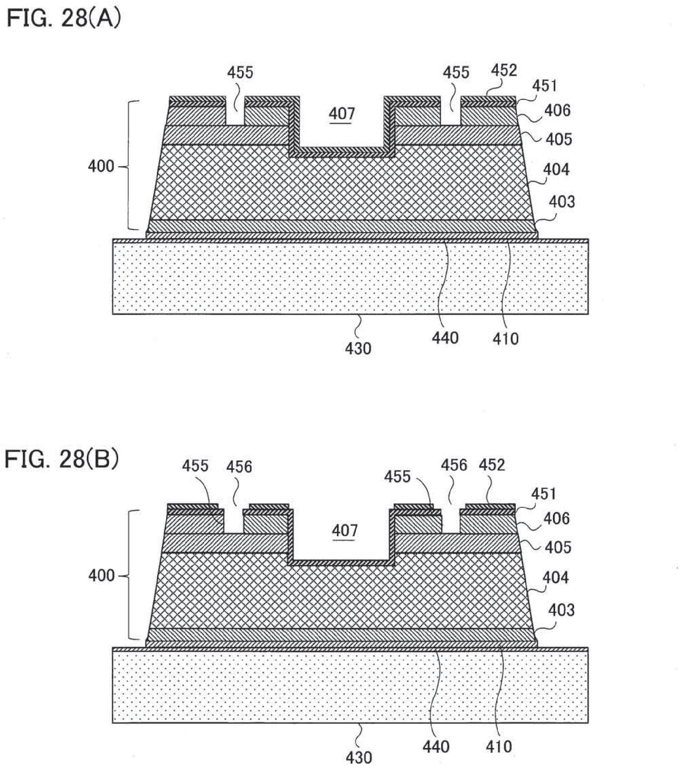

FIG. 28(A) is a cross-sectional view showing a process of forming groove portions 455 in the functional part 400. As shown in FIG. 28(A), dry etching is performed via the photoresist 452 and thereby the groove portions 455 for forming the source electrodes 461 are formed in the functional part 400. The groove portions 455 are formed on both sides of the trench 407 so as to reach the pGaN layer 405.

FIG. 28(B) is a cross-sectional view showing a process of forming openings 456 in the photoresist 452. As shown in FIG. 28(B), exposure and developing the photoresist 452 are performed, so that the openings 456 slightly larger than the above-described groove portions 455 are formed at positions to overlap with the groove portions 455.

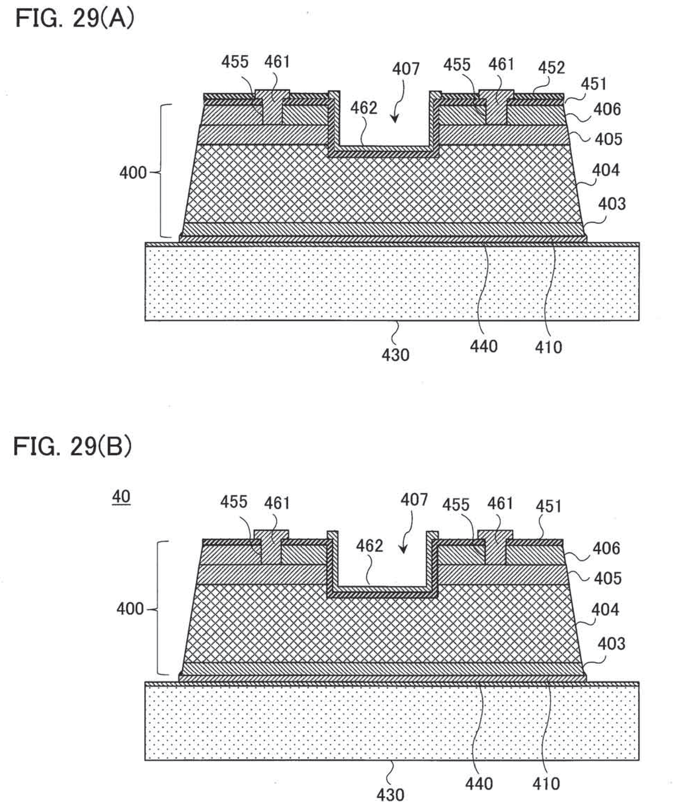

FIG. 29(A) is a cross-sectional view showing a process of forming the source electrodes 461 and a gate electrode 462. The source electrodes 461 are formed so as to fill in the groove portions 455 of the functional part 400 and the openings 456 of the photoresist 452. The source electrodes 461 are made of Ti or Al, for example, and are formed by sputtering or vapor deposition.

Further, the gate electrode 462 is formed in the trench 407 of the functional part 400. The gate electrode 462 is made of Pd or Mo, for example, and is formed by sputtering or vapor deposition.

FIG. 29(B) is a cross-sectional view showing a process of removing the photoresist 452. As shown in FIG. 29(B), the photoresist 452 covering the functional part 400 is removed by peeling off the photoresist 452 or by dissolving the photoresist 452 in an organic solvent.

As above, the source electrodes 461 and the gate electrode 462 are formed on the functional part 400. Further, the third layer 443 (Au) of the second metallic film 440 on the device substrate 430 turns into a drain electrode. By this process, the electronic device 40 as a vertical GaN field effect transistor having the trench structure is completed.

Since the functional part 400 (GaN) is grown on the growth substrate 401 made of Si or the like via the buffer layer 402 (AlN), it is unnecessary to use an expensive GaN substrate as the growth substrate 401 and the manufacturing cost can be reduced.

Further, by the removal of the buffer layer 402, the first metallic film 410 as a drain electrode can be formed directly on the n+GaN layer 403 and joined to the second metallic film 440 on the device substrate 430, and thus a GaN field effect transistor (GaN FET) in the vertical structure with low electric resistance can be realized.

Furthermore, since the thickness of the n+GaN layer 403 as the contact layer can be made sufficiently thinner than the n-GaN layer 404 as the drift layer, ohmic contact can be obtained between the n+GaN layer 403 and the first metallic film 410 as the drain electrode, on-resistance between the source electrode 461 and the drain electrode can be reduced, and operation efficiency of the electronic device 40 can be increased.

Moreover, since the SiC substrate can be used as the device substrate 430, heat radiation performance of the electronic device 40 can be increased as compared to cases where a GaN substrate is used.

As described above, the electronic device 40 in the fourth embodiment includes the functional part 400, the device substrate 430 as a substrate supporting the functional part 400, the first metallic film 410 as an electrode deposited on a side of the functional part 400 facing the device substrate 430, and the second metallic film 440 which is formed on the device substrate 430 and to which the first metallic film 410 is joined. The first metallic film 410 is deposited from the lower surface (first surface) 403a to parts of the side faces (second surfaces) 403b of the functional part 400. Therefore, similarly to the first embodiment, even when the warpage of the functional part 400 has occurred, the functional part 400 can be excellently joined to the device substrate 430 and the peeling of the functional part 400 can be prevented.

Further, the functional part 400 includes the n+GaN layer 403 as the contact layer and the semiconductor layers (the n-GaN layer 404, the pGaN layer 405 and the n+GaN layer 406) on the n+GaN layer 403, and the first metallic film 410 is formed on the n+GaN layer 403. Thus, the semiconductor layers and the second metallic film 440 on the device substrate 430 can be electrically connected together via the first metallic film 410.

### (Fifth Embodiment)

The structure of an electronic device in a fifth embodiment is the same as that of the electronic device 40 in the fourth embodiment. A manufacturing method of the electronic device in the fifth embodiment differs from the manufacturing method of the electronic device 40 in the fourth embodiment in that a trench 507 is formed before a functional part 500 is transferred onto a device substrate 530.

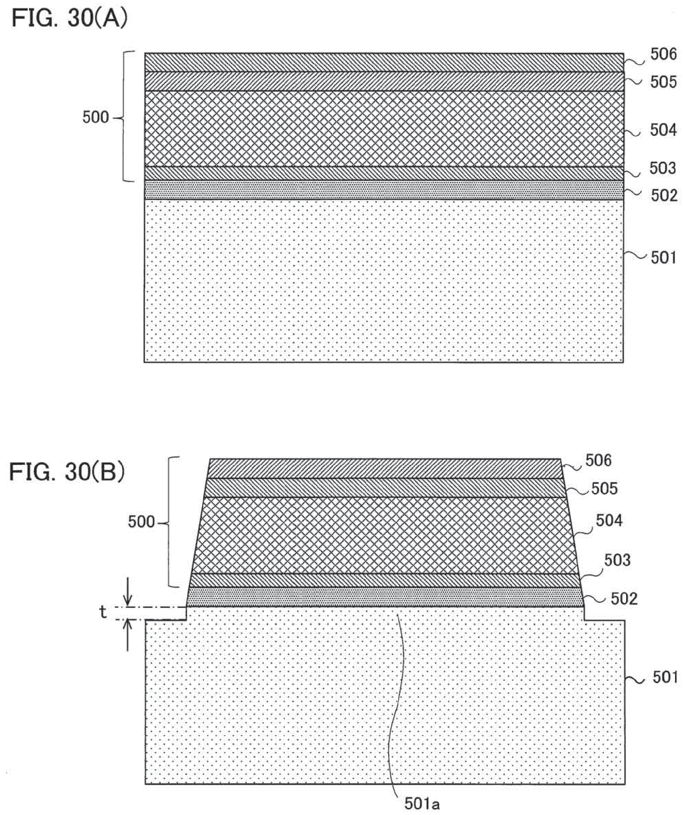

FIG. 30(A) is a cross-sectional view showing a process of forming a buffer layer 502 and the functional part 500 on a growth substrate 501 as a first substrate in the manufacturing method of the electronic device in the fifth embodiment.

The growth substrate 501, the buffer layer 502, an n+GaN layer 503, an n-GaN layer 504, a pGaN layer 505 and an n+GaN layer 506 shown in FIG. 30(A) are respectively formed in the same way as the growth substrate 401, the buffer layer 402, the n+GaN layer 403, the n-GaN layer 404, the pGaN layer 405 and the n+GaN layer 406 described in the fourth embodiment.

The n+GaN layer 503, the n-GaN layer 504, the pGaN layer 505 and the n+GaN layer 506 constitute the functional part 500.

FIG. 30(B) is a cross-sectional view showing a process of patterning the growth substrate 501, the buffer layer 502 and the functional part 500. As shown in FIG. 30(B), the growth substrate 501, the buffer layer 502 and the functional part 500 are patterned into the element shape. The method of the patterning is as explained earlier with reference to FIG. 20(B) in the fourth embodiment.

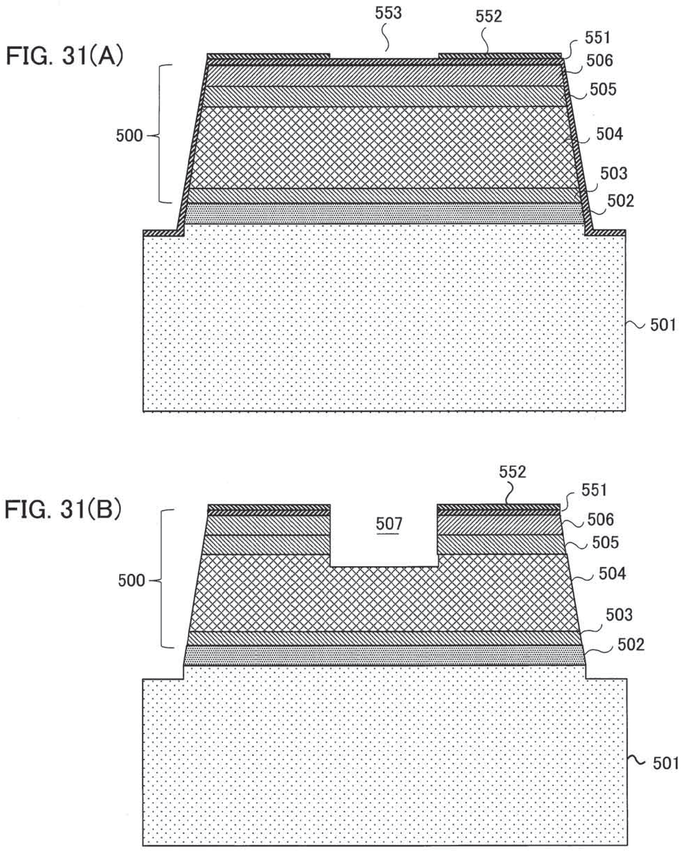

FIG. 31(A) is a cross-sectional view showing a process of forming an insulation film 551 and a photoresist 552 on the functional part 500. As shown in FIG. 31(A), the insulation film 551 is formed so as to cover the functional part 500. The insulation film 551 is an oxide film of SiO₂, Al₂O₃ or the like, for example, has a thickness of approximately 10 nm to 1 µm, and is formed by sputtering or vapor deposition.

Further, the photoresist 552 is formed on the insulation film 551 covering the functional part 500 by spin coating, for example. Furthermore, the photoresist 552 is patterned and an opening 553 is formed at a position of forming a trench which will be described below.

FIG. 31(B) is a cross-sectional view showing a process of forming a trench 507 in the functional part 500. As shown in FIG. 31(B), dry etching is performed via the photoresist 552 and thereby the trench 507 reaching the n-GaN layer 504 (drift layer) is formed in the functional part 500.

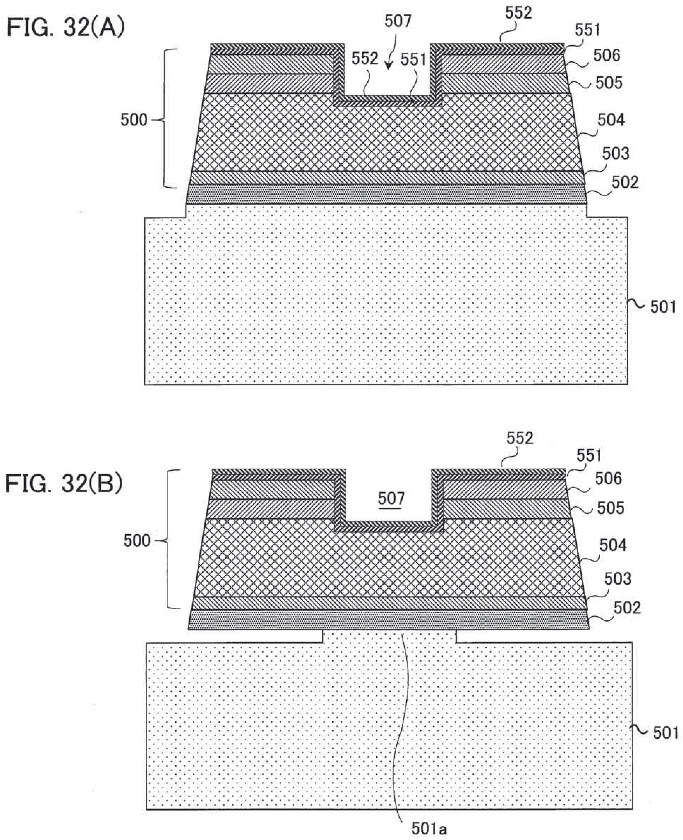

FIG. 32(A) is a cross-sectional view showing a process of forming the insulation film 551 and the photoresist 552 in the trench 507. As shown in FIG. 32(A), the insulation film 551 is formed so as to cover inner surfaces of the trench 507 by CVD or ALD, for example. Further, the photoresist 552 is formed so as to cover the insulation film 551 in the trench 507 by spin coating, for example.

FIG. 32(B) is a cross-sectional view showing a process of etching the growth substrate 501. As shown in FIG. 32(B), the growth substrate 501 is etched in its surface direction, namely, the (100) direction, by means of wet etching using KOH.

A sacrificial layer 501a of the growth substrate 501 may be either partially etched as explained with reference to FIG. 2(B) in the first embodiment or entirely removed as explained with reference to FIG. 2(C). By this process, the functional part 500 becomes easily separable from the growth substrate 501.

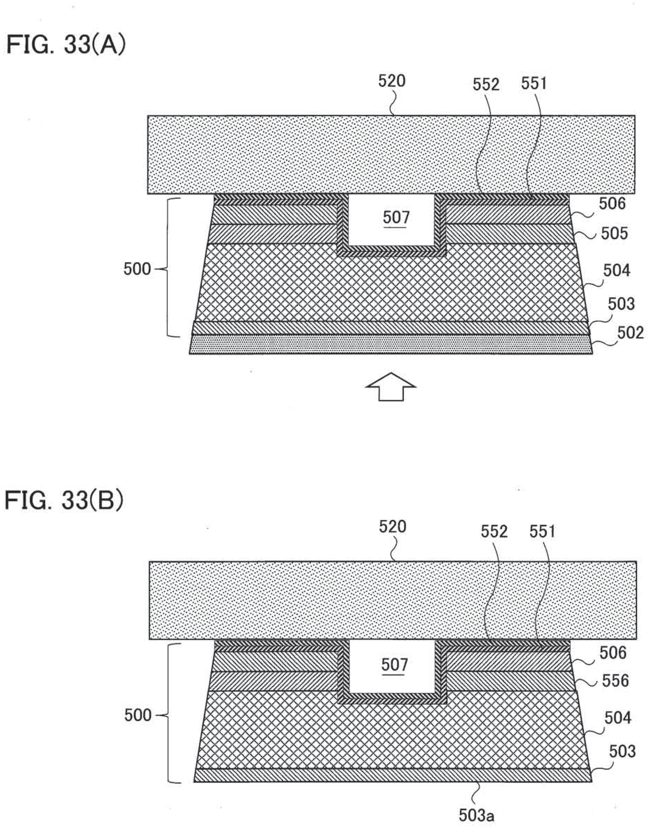

FIG. 33(A) is a cross-sectional view showing a process of separating the buffer layer 502 and the functional part 500 from the growth substrate 501. As shown in FIG. 33(A), a stamp 520 as a holding member is stuck onto the upper surface of the functional part 500, and the buffer layer 502 and the functional part 500 are separated from the growth substrate 501. The configuration of the stamp 520 is the same as that of the stamp 120 in the first embodiment.

The warpage of the buffer layer 502 and the functional part 500 becomes obvious in a state where they have been separated from the growth substrate 501 as explained in the fourth embodiment.

FIG. 33(B) is a cross-sectional view showing a process of removing the buffer layer 502. As shown in FIG. 33(B), the buffer layer 502 is removed by means of etching or polishing such as CMP. By this process, a lower surface 503a of the n+GaN layer 503 of the functional part 500 is exposed. By the removal of the buffer layer 502, the warpage of the functional part 500 is mitigated, but is not totally eliminated.

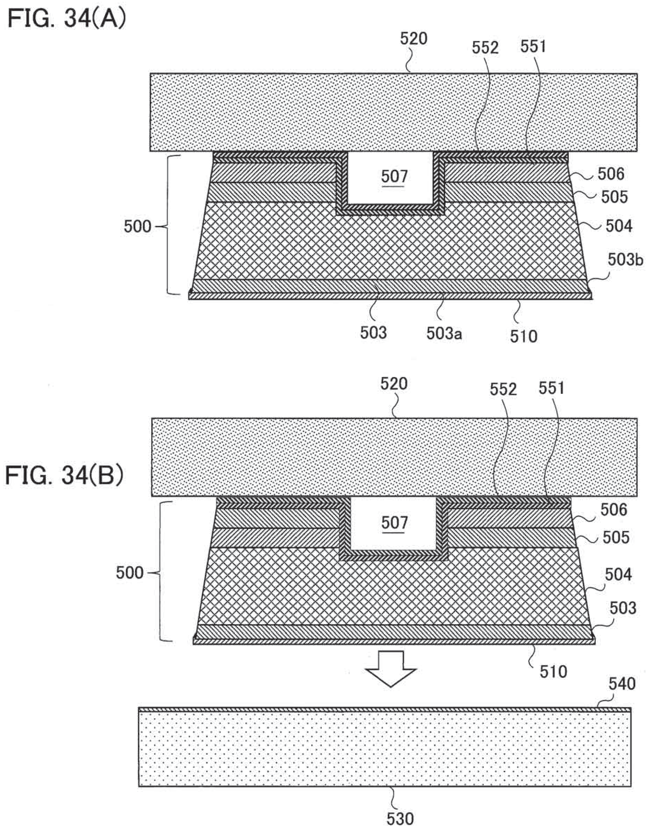

FIG. 34(A) is a cross-sectional view showing a process of depositing a first metallic film 510. As shown in FIG. 34(A), the first metallic film 510 is deposited on the lower surface 503a of the n+GaN layer 503 of the functional part 500. The first metallic film 510 is an electrode for the n+GaN layer 503. The configuration of the first metallic film 510 is the same as that of the first metallic film 410 (FIG. 22(C)) in the fourth embodiment.

FIG. 34(B) is a cross-sectional view showing a process of transferring the functional part 500 onto the device substrate 530. As shown in FIG. 34(B), the functional part 500 held by the stamp 520 is transferred onto the device substrate 530 as a second substrate. A second metallic film 540 is formed on the main surface of the device substrate 530.

The device substrate 530 and the second metallic film 540 are the same as the device substrate 430 and the second metallic film 440 (FIG. 24(B)) in the fourth embodiment. Further, it is also possible to use the combinations shown in Table 1 in the second embodiment for the layers of the metallic films 510 and 540 in the fifth embodiment.

A process after sticking the functional part 500 on the device substrate 530 is the same as the process explained with reference to FIG. 25(A) to FIG. 29(B) in the fourth embodiment. By this process, an electronic device as a vertical GaN field effect transistor having the trench structure is completed.

As described above, in the manufacturing method of the electronic device in the fifth embodiment, the trench 507 is formed before the functional part 500 is separated from the growth substrate 501, and thus process steps executed after transferring the functional part 500 onto the device substrate 530 decrease. Consequently, stress or the like acting on the metallic films 510 and 540 can be reduced and the defective joint can be prevented.

### (Sixth Embodiment)

Similarly to the fourth and fifth embodiments, a sixth embodiment relates to an electronic device 60 serving as a vertical GaN field effect transistor (FET) device having the trench structure and its manufacturing method.

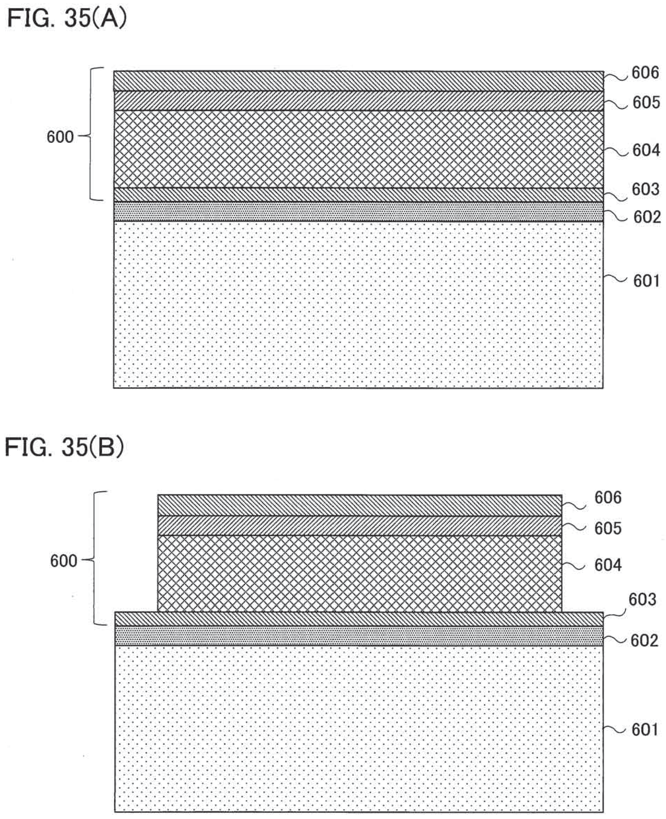

FIG. 35(A) is a cross-sectional view showing a process of forming a buffer layer 602 and a functional part 600 on a growth substrate 601 as a first substrate in the manufacturing method of the electronic device 60 in the sixth embodiment. The growth substrate 601, the buffer layer 602, an n+GaN layer 603, an n-GaN layer 604, a pGaN layer 605 and an n+GaN layer 606 shown in FIG. 35(A) are respectively formed in the same way as the growth substrate 401, the buffer layer 402, the n+GaN layer 403, the n-GaN layer 404, the pGaN layer 405 and the n+GaN layer 406 (FIG. 20(A)) described in the fourth embodiment.

The n+GaN layer 603, the n-GaN layer 604, the pGaN layer 605 and the n+GaN layer 606 constitute the functional part (semiconductor thin film) 600.

FIG. 35(B) is a cross-sectional view showing a first patterning process for the functional part 600. As shown in FIG. 35(B), the n-GaN layer 604, the pGaN layer 605 and the n+GaN layer 606 of the functional part 600 are patterned into a first element shape. The first patterning process is executed by forming a not-shown photoresist (mask) on the functional part 600 and performing dry etching.

The dry etching condition of the first patterning process is set so that side faces of the n-GaN layer 604, the pGaN layer 605 and the n+GaN layer 606 of the functional part 600 are formed as vertical surfaces (i.e., surfaces orthogonal to the main surface of the growth substrate 601).

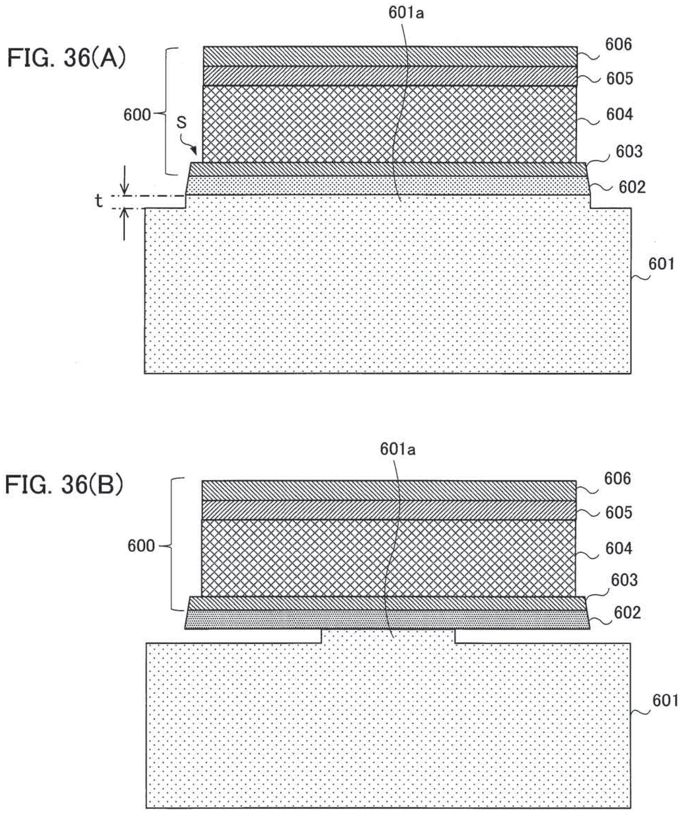

FIG. 36(A) is a cross-sectional view showing a second patterning process for the growth substrate 601, the buffer layer 602 and the functional part 600. As shown in FIG. 36(A), the growth substrate 601, the buffer layer 602 and the n+GaN layer 603 are patterned into a second element shape. The second patterning process is executed by forming a not-shown photoresist (mask) on the functional part 600 and performing dry etching.

In the second patterning process, the dry etching is performed until the depth (over-etching amount) t of the growth substrate 601 from its main surface reaches 50 nm to 10000 nm. By this process, a sacrificial layer 601a having approximately the same area as the lower surface of the buffer layer 602 is formed at the main surface of the growth substrate 601.

The dry etching condition of the second patterning process is set so that side faces of the buffer layer 602 and the n+GaN layer 603 are formed as inclined surfaces. This dry etching condition is desired to be set so that a step part S is formed between the n+GaN layer 603 and the n-GaN layer 604.

Due to these two steps of patterning processes, the functional part 600 includes a first part (the n+GaN layer 603) whose side faces are the inclined surfaces and a second part (the n-GaN layer 604, the pGaN layer 605 and the n+GaN layer 606) whose side faces are the vertical surfaces. Incidentally, the side faces of the second part are not limited to vertical surfaces but may also be inclined surfaces whose inclination angle is different from that of the side faces of the first part.

FIG. 36(B) is a cross-sectional view showing a process of etching the growth substrate 601. As shown in FIG. 36(B), the growth substrate 601 is etched in its surface direction, namely, the (100) direction, by means of wet etching using KOH.

The sacrificial layer 601a of the growth substrate 601 may be either partially etched as explained with reference to FIG. 2(B) in the first embodiment or entirely removed as explained with reference to FIG. 2(C). By this process, the functional part 600 becomes easily separable from the growth substrate 601.

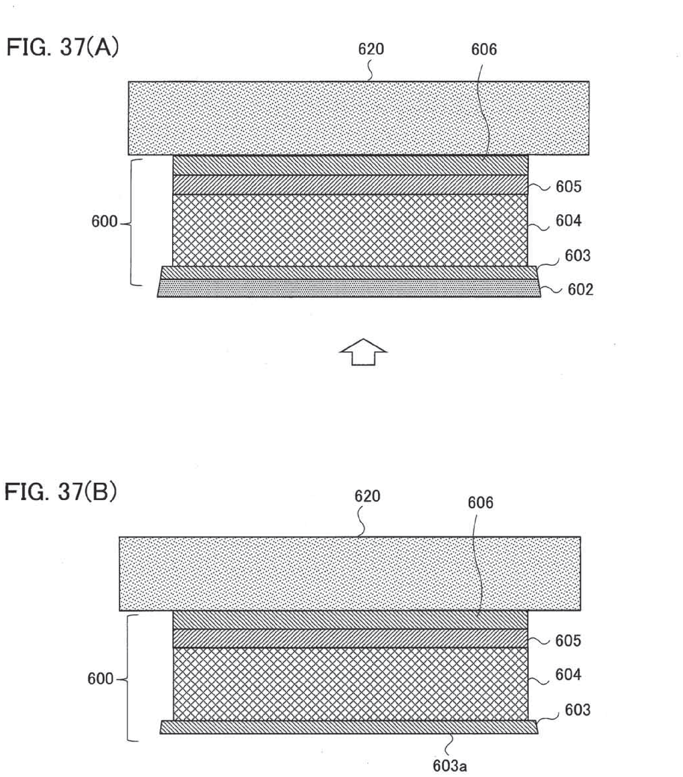

FIG. 37(A) is a cross-sectional view showing a process of separating the buffer layer 602 and the functional part 600 from the growth substrate 601. As shown in FIG. 37(A), a stamp 620 as a holding member is stuck onto the upper surface (surface on a side opposite to the growth substrate 601) of the functional part 600, and the buffer layer 602 and the functional part 600 are separated from the growth substrate 601. The configuration of the stamp 620 is the same as that of the stamp 120 in the first embodiment.

The warpage of the buffer layer 602 and the functional part 600 becomes obvious in a state where they have been separated from the growth substrate 601 as explained in the fourth embodiment.

FIG. 37(B) is a cross-sectional view showing a process of removing the buffer layer 602. As shown in FIG. 37(B), the buffer layer 602 is removed by means of etching or polishing such as CMP. By this process, a lower surface 603a of the n+GaN layer 603 of the functional part 600 is exposed. By the removal of the buffer layer 602, the warpage of the functional part 600 is mitigated, but is not totally eliminated.

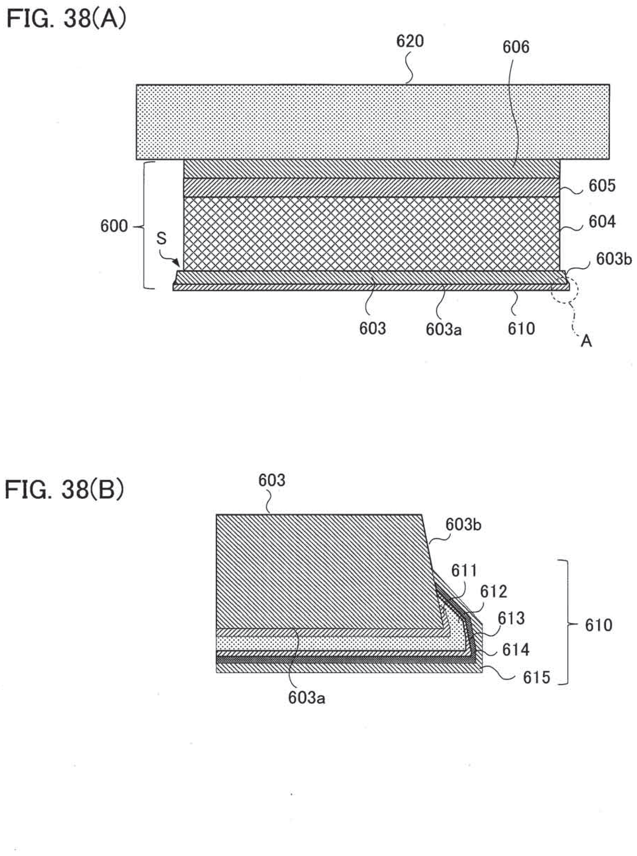

FIG. 38(A) is a cross-sectional view showing a process of forming a first metallic film 610. As shown in FIG. 38(A), the first metallic film 610 is formed on the lower surface 603a of the n+GaN layer 603 of the functional part 600. The first metallic film 610 is an electrode for the n+GaN layer 603 and is formed of a multilayer film.

The first metallic film 610 is deposited on the lower surface 603a so as to extend to the side faces 603b of the n+GaN layer 603. An angle formed by the lower surface 603a and the side face 603b of the n+GaN layer 603 is larger than the angle R (FIG. 4(B)) explained in the first embodiment, and is 80 [degrees] to 90 [degrees], for example.

FIG. 38(B) is an enlarged diagram showing a part surrounded by a circle indicated by the reference character A in FIG. 38(A). The first metallic film 610 includes a first layer 611 made of Ti, a second layer 612 made of Al, a third layer 613 made of Ti, a fourth layer 614 made of Pt, and a fifth layer 615 made of Au that are successively stacked from the n+GaN layer 603 side. The method of depositing these layers is as explained earlier with reference to FIGS. 12(A) to 12(E) in the second embodiment.

As explained also in the second embodiment, the first metallic film 610 is deposited by sputtering, vapor deposition or the like. For example, in a state where the functional part 600 has been separated from the growth substrate 601 as shown in FIG. 37(B), metallic atoms for forming the first metallic film 610 are successively applied to the lower surface 603a, by which the first metallic film 610 is formed from the lower surface 603a to the side faces 603b.

In this case, since the side face 603b of the n+GaN layer 603 is an inclined surface having an angle of 80 [degrees] to 90 [degrees] with respect to the lower surface 603a, the first metallic film 610 can be deposited so as not to contact the side face of the n-GaN layer 604. By preventing the first metallic film 610 from contacting the n-GaN layer 604, the deterioration of the voltage resistance of the n-GaN layer 604 (active layer) can be prevented.

Further, since the two-step etching is performed (FIG. 35(B), FIG. 36(A)) in the sixth embodiment, the step part S can be formed between the n+GaN layer 603 and the n-GaN layer 604. By this, the side face of the n-GaN layer 604 can be withdrawn towards the inside of the functional part 600 relative to the side face 603b of the n+GaN layer 603. Accordingly, the first metallic film 610 becomes unlikely to contact the n-GaN layer 604 and the effect of preventing the deterioration of the voltage resistance of the n-GaN layer 604 can be enhanced.

Furthermore, since the fourth layer 614 (Pt) is formed between the second layer 612 (Al) and the fifth layer 615 (Au) of the first metallic film 610 so as to extend to the side faces 603b of the n+GaN layer 603 as shown in FIG. 38(B), the increase in the electric resistance due to the eutectic of Al and Au in the annealing process described later can be prevented.

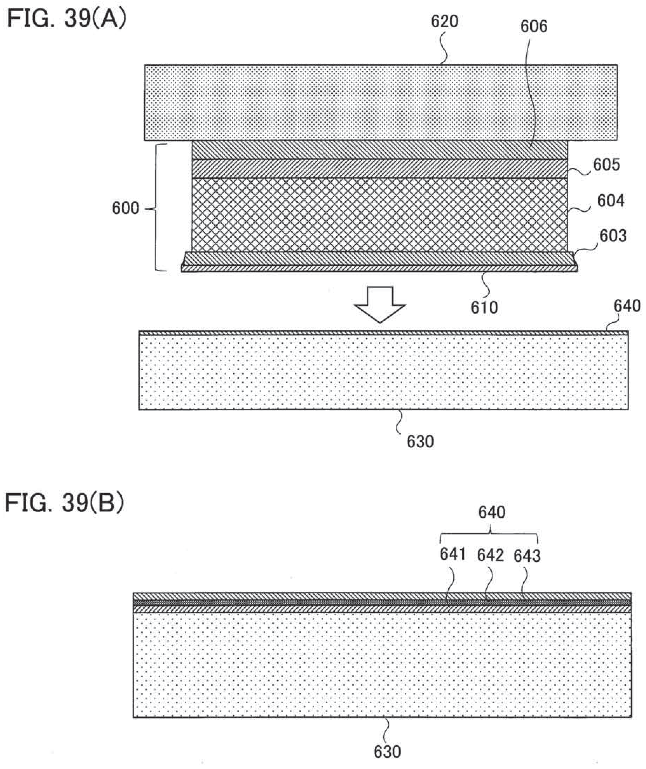

FIG. 39(A) is a cross-sectional view showing a process of transferring the functional part 600 onto a device substrate 630. As shown in FIG. 39(A), the functional part 600 held by the stamp 620 is transferred onto the device substrate 630 as a second substrate. The device substrate 630 is the same as the device substrate 430 described in the fourth embodiment.

A second metallic film 640 is formed on the main surface of the device substrate 630. FIG. 39(B) is an enlarged cross-sectional view showing the second metallic film 640 on the main surface of the device substrate 630. As shown in FIG. 39(B), the second metallic film 640 includes a first layer 641, a second layer 642 and a third layer 643 that are successively stacked from the device substrate 630 side (lower side).

The first layer 641 to the third layer 643 of the second metallic film 640 are respectively formed in the same way as the first layer 441 to the third layer 443 of the second metallic film 440 described in the fourth embodiment. Further, it is also possible to use the combinations shown in Table 1 in the second embodiment for the layers of the metallic films 610 and 640.

When the functional part 600 is transferred onto the device substrate 630, the first metallic film 610 and the second metallic film 640 are stuck together by applying prescribed pressure thereto. Thereafter, the stamp 620 is peeled off and removed from the upper surface of the functional part 600.

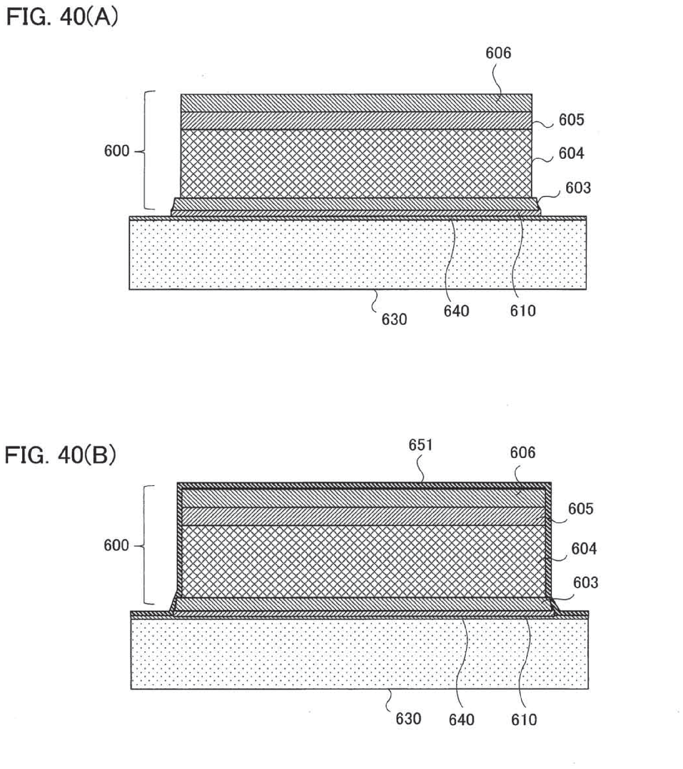

FIG. 40(A) is a cross-sectional view showing a process of joining the metallic films 610 and 640 of the functional part 600 and the device substrate 630 together. In a state where the first metallic film 610 and the second metallic film 640 are stuck together as shown in FIG. 40(A), the annealing process is executed at 500 [°C] to 800 [°C].

By this process, the first metallic film 610 and the second metallic film 640 are joined together. By the pressing at the time of the sticking and the subsequent annealing process, the first metallic film 610 and the second metallic film 640 are joined together with no gap even if the functional part 600 has warpage.

Further, by the annealing process, ohmic contact is obtained between the n+GaN layer 603 of the functional part 600 and the first layer 611 (Ti) and the second layer 612 (Al) of the first metallic film 610. Furthermore, the fifth layer 615 (Au) as the outermost layer of the first metallic film 610 deposited on the functional part 600 and the third layer 643 (Au) as the uppermost layer of the second metallic film 640 on the device substrate 630 are integrated together.

FIG. 40(B) is a cross-sectional view showing a process of forming an insulation film 651 on the functional part 600. As shown in FIG. 40(B), the insulation film 651 is formed so as to cover the device substrate 630 and the functional part 600. The insulation film 651 is an oxide film of SiO₂, Al₂O₃ or the like, for example, has a thickness of approximately 10 nm to 1 µm, and is formed by sputtering or vapor deposition.

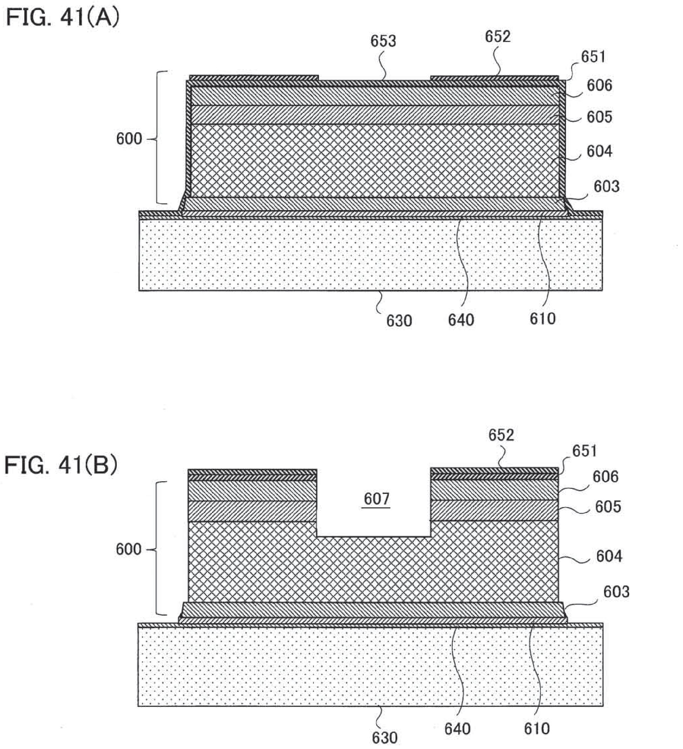

FIG. 41(A) is a cross-sectional view showing a process of forming a photoresist 652 on the insulation film 651 and executing the patterning. As shown in FIG. 41(A), the photoresist 652 is formed on the insulation film 651 covering the functional part 600 by spin coating, for example. Further, the photoresist 652 is patterned and an opening 653 is formed at a position of forming a trench which will be described below.

FIG. 41(B) is a cross-sectional view showing a process of forming a trench 607 in the functional part 600. As shown in FIG. 41(B), dry etching is performed via the photoresist 652 and thereby the trench 607 reaching the n-GaN layer 604 (drift layer) is formed in the functional part 600.

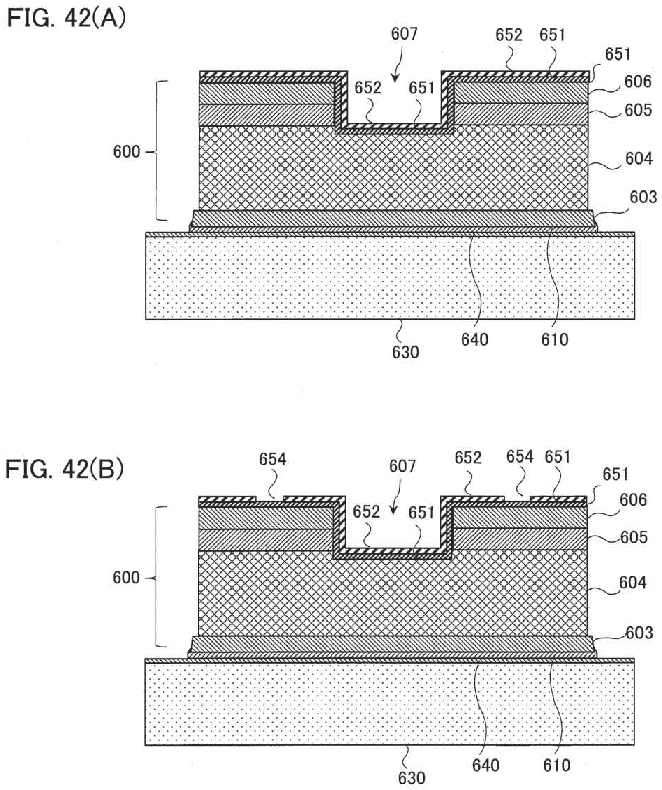

FIG. 42(A) is a cross-sectional view showing a process of forming the insulation film 651 and the photoresist 652 in the trench 607. As shown in FIG. 42(A), the insulation film 651 is formed so as to cover inner surfaces of the trench 607 by CVD or ALD, for example. Further, the photoresist 652 is formed so as to cover the insulation film 651 in the trench 607 by spin coating, for example.

FIG. 42(B) is a cross-sectional view showing a process of forming openings 654 in the photoresist 652. As shown in FIG. 42(B), the photoresist 652 is exposed to light and developed and thereby the openings 654 are formed at positions of forming source electrodes 661 which will be described later.

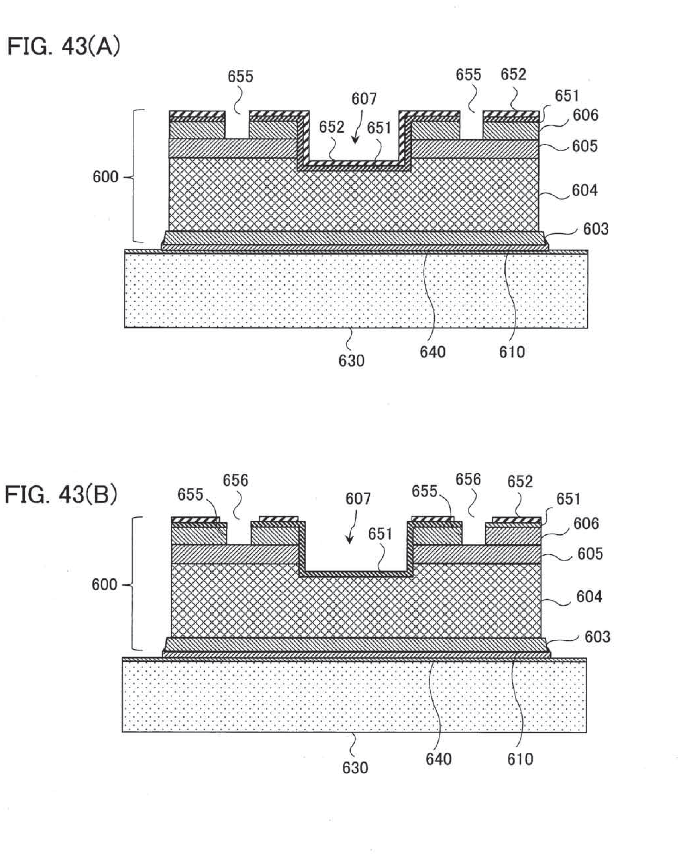

FIG. 43(A) is a cross-sectional view showing a process of forming groove portions 655 in the functional part 600. As shown in FIG. 43(A), dry etching is performed via the photoresist 652 and thereby the groove portions 655 for forming the source electrodes 661 are formed in the functional part 600. The groove portions 655 are formed so as to reach the pGaN layer 605.

In FIG. 43(B), openings 656 slightly larger than the above-described groove portions 655 are formed at positions to overlap with the groove portions 655 by exposing and developing the photoresist 652. Further, the photoresist 652 in the trench 607 is removed.

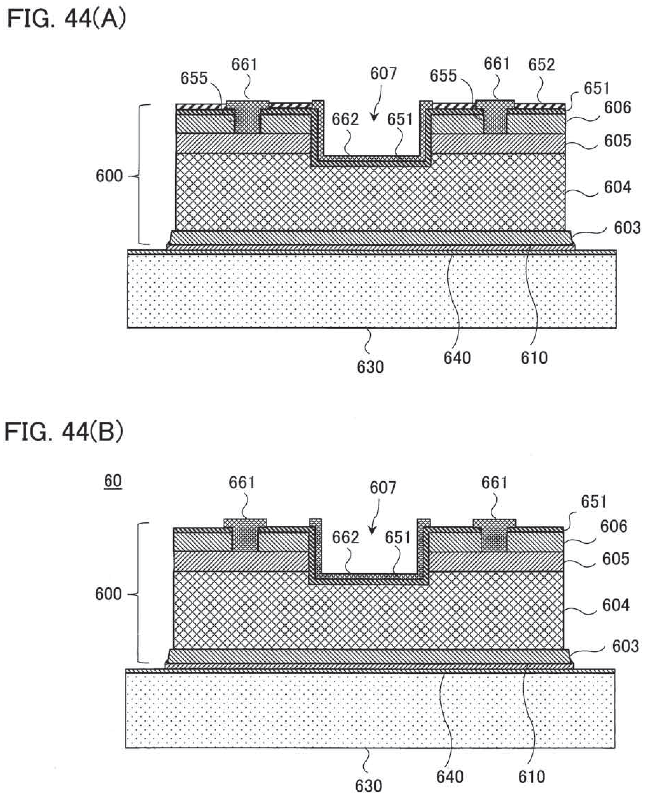

FIG. 44(A) is a cross-sectional view showing a process of forming the source electrodes 661 and a gate electrode 662. The source electrodes 661 are formed so as to fill in the groove portions 655 of the functional part 600 and the openings 656 of the photoresist 652. The source electrodes 661 are made of Ti or Al, for example, and are formed by sputtering or vapor deposition.

Further, the gate electrode 662 is formed in the trench 607 of the functional part 600. The gate electrode 662 is made of Pd or Mo, for example, and is formed by sputtering or vapor deposition.

FIG. 44(B) is a cross-sectional view showing a process of removing the photoresist 652. As shown in FIG. 44(B), the photoresist 652 covering the functional part 600 is removed by peeling off the photoresist 652 or by dissolving the photoresist 652 in an organic solvent.

As above, the source electrodes 661 and the gate electrode 662 are formed on the functional part 600, and the third layer 643 (Au) of the second metallic film 640 on the device substrate 630 turns into a drain electrode. By this process, the electronic device 60 as a vertical GaN field effect transistor having the trench structure is completed.

As described above, the electronic device 60 in the sixth embodiment includes the functional part 600, the device substrate 630 as a substrate supporting the functional part 600, the first metallic film 610 as an electrode deposited on a side of the functional part 600 facing the device substrate 630, and the second metallic film 640 which is formed on the device substrate 630 and to which the first metallic film 610 is joined. The first metallic film 610 is deposited from the lower surface (first surface) 603a of the functional part 600 to parts of the side faces (second surfaces) 603b. Therefore, similarly to the first embodiment, even when the warpage of the functional part 600 has occurred, the functional part 600 can be excellently joined to the device substrate 630 and the peeling of the functional part 600 can be prevented.

Further, the side faces of the first part (the n+GaN layer 603) of the functional part 600 have the inclination whereas the side faces of the second part (i.e., the n-GaN layer 604, the pGaN layer 605 and the n+GaN layer 606) of the functional part 600 have no inclination. Thus, the functional part 600 can be formed in a large size compared to the functional parts 400 and 500 in the fourth and fifth embodiments.

Furthermore, since the n-GaN layer 604 of the functional part 600 can be formed at a position withdrawn relative to the n+GaN layer 603 in a direction parallel to the main surface of the device substrate 630, the first metallic film 610 or the second metallic film 640 can be prevented from contacting the n-GaN layer 604 and the deterioration of the voltage resistance of the n-GaN layer 604 can be prevented.

### (Seventh Embodiment)

A seventh embodiment relates to an electronic device 70 as a vertical GaN field effect transistor (FET) device having planar structure and its manufacturing method.

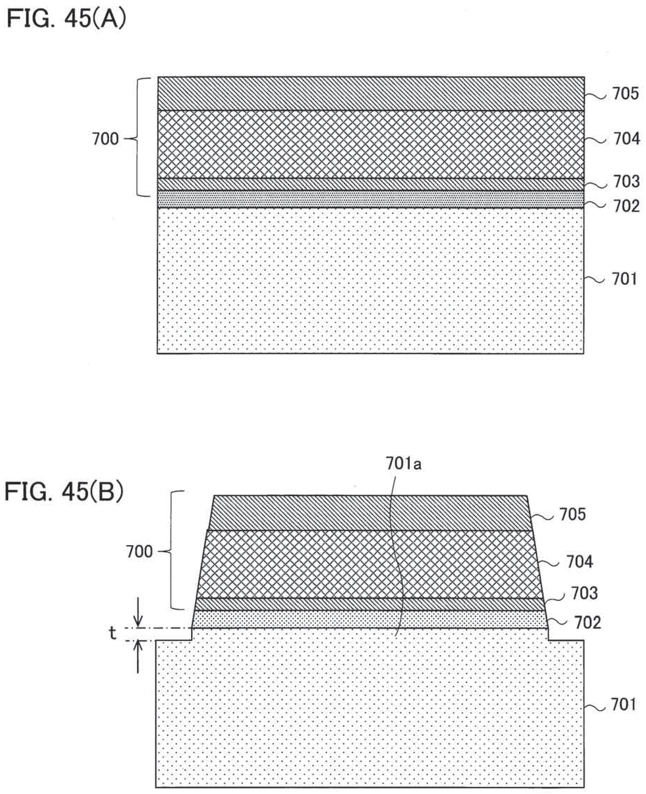

FIG. 45(A) is a cross-sectional view showing a process of forming a buffer layer 702 and a functional part 700 on a growth substrate 701 as a first substrate in the manufacturing method of the electronic device 70 in the seventh embodiment. The growth substrate 701 shown in FIG. 45(A) is a Si (111) substrate, for example. Incidentally, the growth substrate 701 is not limited to Si (111); the growth substrate 701 only needs to be a substrate on which the functional part 700 described later can be grown.

The buffer layer 702 as an AlN layer is epitaxially grown on the main surface of the growth substrate 701. While the buffer layer 702 is a single layer of AlN in this example, the buffer layer 702 is not limited to this example but may also be a laminated body of an AlN layer and an AlGaN layer, for example. The thickness of the buffer layer 702 is 200 nm to 1 µm, for example.

An n+GaN layer 703 as a contact layer is epitaxially grown on the buffer layer 702. The thickness of the n+GaN layer 703 is less than or equal to 5 µm, for example.

Subsequently, an n-GaN layer 704 as a drift layer is epitaxially grown on the n+GaN layer 703. The thickness of the n-GaN layer 704 is 2 µm to 50 µm, for example.

Further, a pGaN layer 705 is epitaxially grown on the n-GaN layer 704. The thickness of the pGaN layer 705 is less than or equal to 10 µm, for example.

The n+GaN layer 703, the n-GaN layer 704 and the pGaN layer 705 constitute the functional part 700.

FIG. 45(B) is a cross-sectional view showing a process of patterning the growth substrate 701, the buffer layer 702 and the functional part 700. As shown in FIG. 45(B), the growth substrate 701, the buffer layer 702 and the functional part 700 are patterned into the element shape. The patterning is executed by forming a not-shown photoresist (mask) on the functional part 700 and performing dry etching.

The dry etching is performed until the depth (over-etching amount) t of the growth substrate 701 from its main surface reaches 50 nm to 10000 nm. By this process, a sacrificial layer 701a having approximately the same area as the lower surface of the buffer layer 702 is formed at the main surface of the growth substrate 701.

The dry etching condition is set so that side faces of the functional part 700 are formed as inclined surfaces as explained in the first embodiment. Incidentally, the inclination direction of the functional part 700 is a direction with which the size of the functional part 700 in a plane parallel to the lower surface (lower surface 703a which will be described later) of the functional part 700 decreases in an upward direction (i.e., as a distance from the lower surface increases). While the description here is given of a case where the side faces of the functional part 700 are inclined surfaces, it is sufficient that at least side faces 703b of the n+GaN layer 703 (contact layer) described later are inclined surfaces.

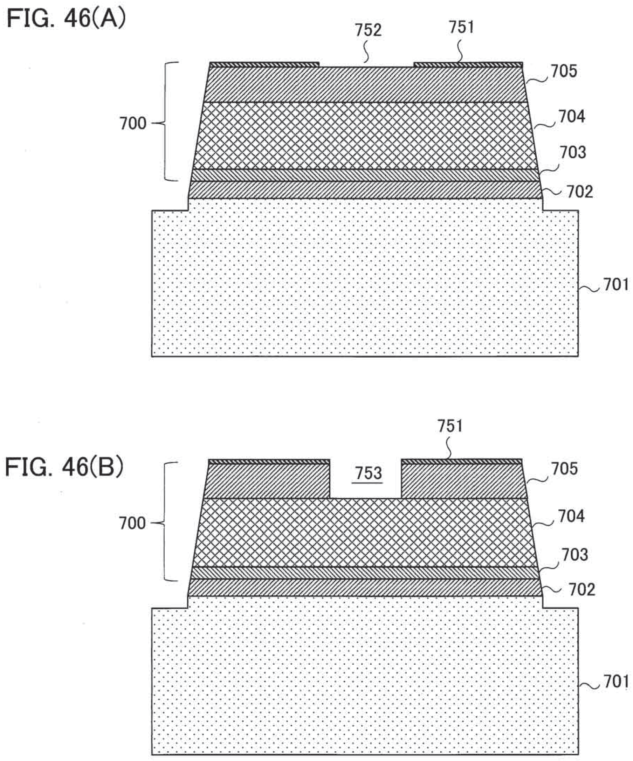

FIG. 46(A) is a cross-sectional view showing a process of forming an insulation film 751 on the functional part 700. As shown in FIG. 46(A), the insulation film 751 is formed so as to cover the functional part 700.. The insulation film 751 is an oxide film of SiO₂, Al₂O₃ or the like, for example, has a thickness of approximately 10 nm to 1 µm, and is formed by sputtering or vapor deposition.

Further, the insulation film 751 is patterned via a not-shown photoresist and an opening 752 is formed over a position of forming a groove portion 753 (FIG. 46(B)) which will be described below.

FIG. 46(B) is a cross-sectional view showing a process of forming the groove portion 753 in the functional part 700. As shown in FIG. 46(B), the groove portion 753 reaching the n-GaN layer 704 (drift layer) is formed in the functional part 700 by dry etching.

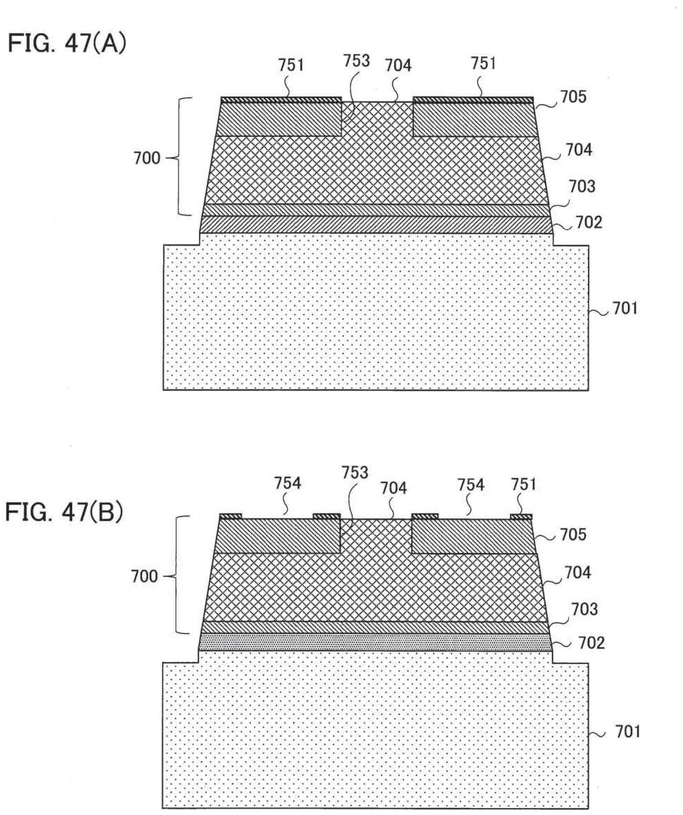

FIG. 47(A) is a cross-sectional view showing a process of epitaxially growing the n-GaN layer 704 in the groove portion 753. As shown in FIG. 47(A), the n-GaN layer 704 is epitaxially grown so as to fill in the groove portion 753 of the functional part 700.

FIG. 47(B) is a cross-sectional view showing a process of forming openings 754 in the insulation film 751. As shown in FIG. 47(B), the openings 754 are formed by patterning the insulation film 751 via a not-shown photoresist to remove parts situated over the pGaN layer 705. The openings 754 are formed on both sides of the n-GaN layer 704 filling in the groove portion 753 (FIG. 46(B)).

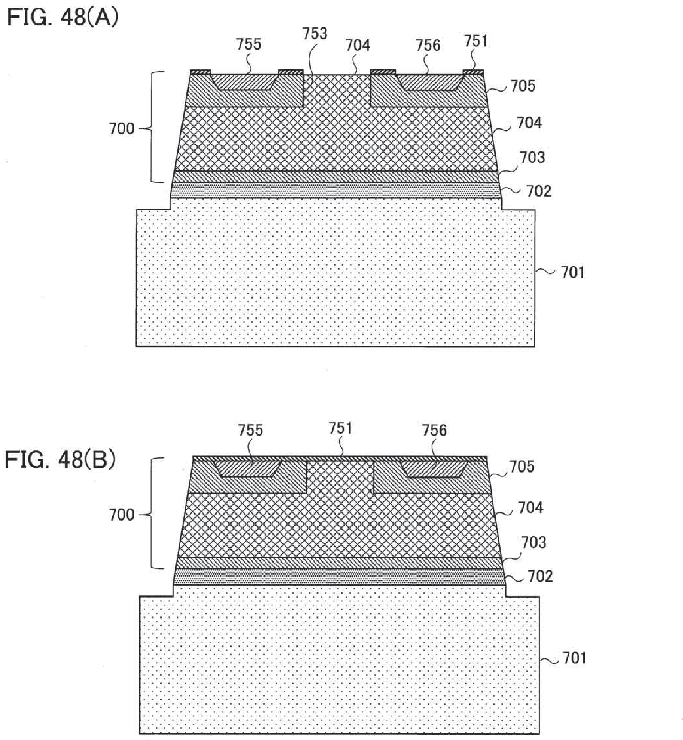

FIG. 48(A) is a cross-sectional view showing a process of forming n+GaN layers 755 and 756 by ion implantation into the pGaN layer 705. As shown in FIG. 48(A), the n+GaN layers 755 and 756 are formed by implanting Si ions into the pGaN layer 705 via the openings 754 of the insulation film 751.

FIG. 48(B) is a cross-sectional view showing a process of forming the insulation film 751 again. As shown in FIG. 48(B), the insulation film 751 is formed so as to cover the n-GaN layer 704 in the groove portion 753 and the n+GaN layers 755 and 756.

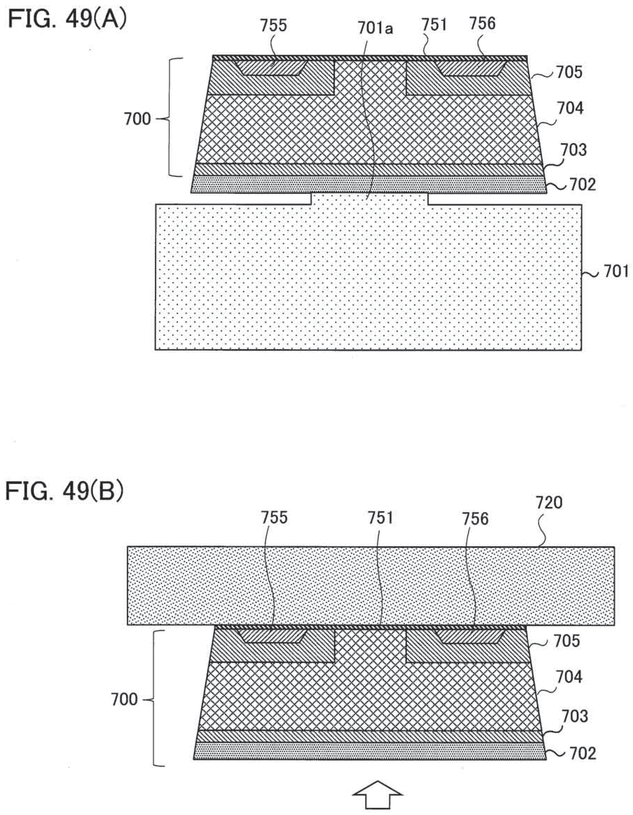

FIG. 49(A) is a cross-sectional view showing a process of etching the growth substrate 701. As shown in FIG. 49(A), the growth substrate 701 is etched in its surface direction, namely, the (100) direction, by means of wet etching using KOH.

The sacrificial layer 701a of the growth substrate 701 may be either partially etched as explained with reference to FIG. 2(B) in the first embodiment or entirely removed as explained with reference to FIG. 2(C). By this process, the functional part 700 becomes easily separable from the growth substrate 701.

FIG. 49(B) is a cross-sectional view showing a process of separating the buffer layer 702 and the functional part 700 from the growth substrate 701. As shown in FIG. 49(B), a stamp 720 as a holding member is stuck onto the upper surface (surface on a side opposite to the growth substrate 701) of the functional part 700, and the buffer layer 702 and the functional part 700 are separated from the growth substrate 701. The configuration of the stamp 720 is the same as that of the stamp 120 in the first embodiment.

The warpage of the buffer layer 702 and the functional part 700 becomes obvious in a state where they have been separated from the growth substrate 701 as explained in the fourth embodiment.

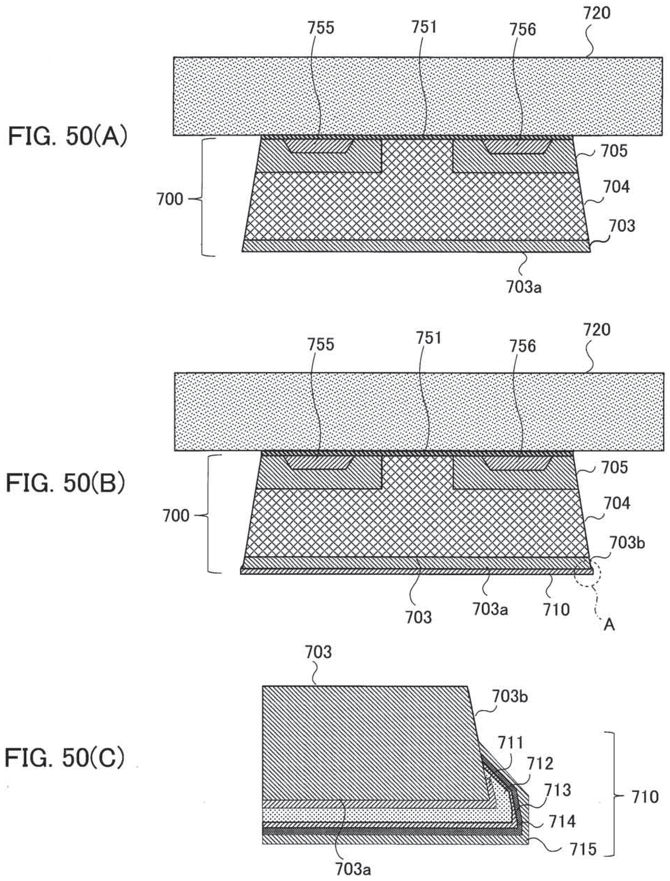

FIG. 50(A) is a cross-sectional view showing a process of removing the buffer layer 702 from the functional part 700. As shown in FIG. 50(A), the buffer layer 702 is removed by means of etching or polishing such as CMP. By this process, a lower surface 703a of the n+GaN layer 703 of the functional part 700 is exposed. By the removal of the buffer layer 702, the warpage of the functional part 700 is mitigated, but is not totally eliminated.

FIG. 50(B) is a cross-sectional view showing a process of forming a first metallic film 710. As shown in FIG. 50(B), the first metallic film 710 is formed on the lower surface 703a of the n+GaN layer 703 of the functional part 700. The first metallic film 710 is an electrode for the n+GaN layer 703 and is formed of a multilayer film.

The first metallic film 710 is deposited on the lower surface 703a so as to extend to the side faces 703b of the n+GaN layer 703. An angle formed by the lower surface 703a and the side face 703b of the n+GaN layer 703 is 45 [degrees] to 90 [degrees] and is preferably greater than or equal to 60 [degrees] and less than 90 [degrees] similarly to the angle R (FIG. 4(B)) explained in the first embodiment.

As explained also in the second embodiment, the first metallic film 710 is deposited by sputtering, vapor deposition or the like. For example, in a state where the functional part 700 is separated from the growth substrate 701 as shown in FIG. 50(A), metallic atoms for forming the first metallic film 710 are successively applied to the lower surface 703a, by which the first metallic film 710 is formed from the lower surface 703a to the side faces 703b.

In this case, since the side face 703b of the n+GaN layer 703 is an inclined surface having an angle of 45 [degrees] to 90 [degrees] (preferably, an angle greater than or equal to 60 [degrees] and less than 90 [degrees]) with respect to the lower surface 703a, the first metallic film 710 can be deposited so as not to contact the side face of the n-GaN layer 704. By preventing the first metallic film 710 from contacting the n-GaN layer 704, the deterioration of the voltage resistance of the n-GaN layer 704 (drift layer) can be prevented.

Further, since a fourth layer 714 (Pt) is formed between a second layer 712 (Al) and a fifth layer 715 (Au) of the first metallic film 710 so as to extend to the side faces 703b of the n+GaN layer 703 as shown in FIG. 50(C), the increase in the electric resistance due to the eutectic of Al and Au in the annealing process described later can be prevented.

FIG. 50(C) is an enlarged diagram showing a part surrounded by a circle indicated by the reference character A in FIG. 50(B). The first metallic film 710 includes a first layer 711 made of Ti, the second layer 712 made of Al, a third layer 713 made of Ti, the fourth layer 714 made of Pt, and the fifth layer 715 made of Au. The method of depositing these layers is as explained earlier with reference to FIGS. 12(A) to 12(E) in the second embodiment.

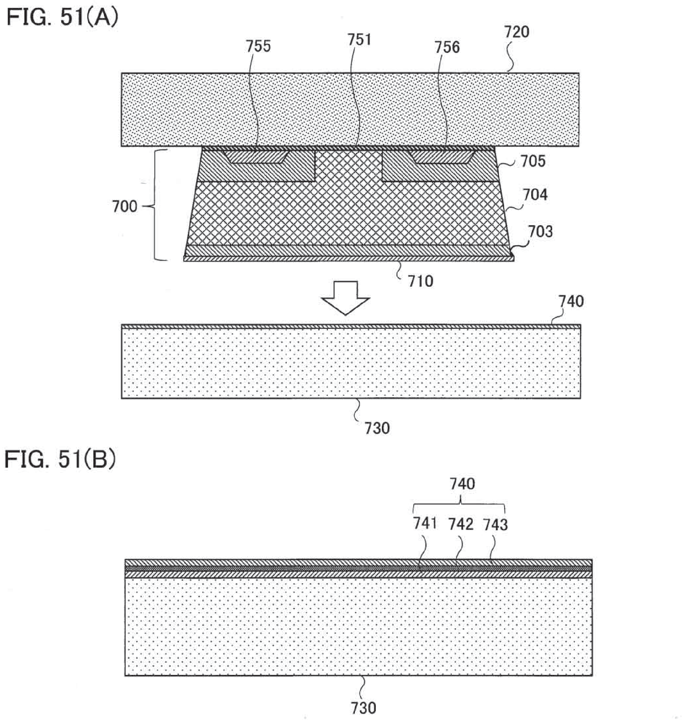

FIG. 51(A) is a cross-sectional view showing a process of transferring the functional part 700 onto a device substrate 730. As shown in FIG. 51(A), the functional part 700 held by the stamp 720 is transferred onto the device substrate 730 as a second substrate. The device substrate 730 is the same as the device substrate 430 described in the fourth embodiment.

A second metallic film 740 is formed on the main surface of the device substrate 730. FIG. 51(B) is an enlarged cross-sectional view showing the second metallic film 740 on the main surface of the device substrate 730. As shown in FIG. 51(B), the second metallic film 740 includes a first layer 741 made of Ti, a second layer 742 made of Pt and a third layer 743 made of Au that are successively stacked from the device substrate 730 side.

The first layer 741 to the third layer 743 are respectively formed in the same way as the first layer 441 to the third layer 443 of the second metallic film 440 described in the fourth embodiment. Further, it is also possible to use the combinations shown in Table 1 in the second embodiment for the metallic films 710 and 740 in the seventh embodiment.

When the functional part 700 is transferred onto the device substrate 730, the first metallic film 710 and the second metallic film 740 are stuck together by applying prescribed pressure thereto. Thereafter, the stamp 720 is peeled off and removed from the upper surface of the functional part 700.

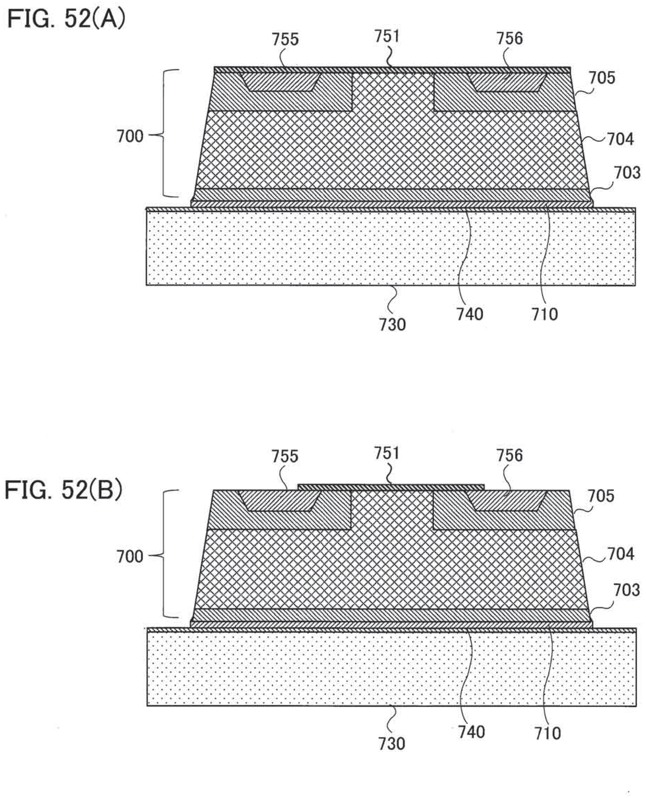

FIG. 52(A) is a cross-sectional view showing a process of joining the metallic films 710 and 740 of the functional part 700 and the device substrate 730 together. In a state where the first metallic film 710 and the second metallic film 740 are stuck together as shown in FIG. 52(A), the annealing process is executed at 500 [°C] to 800 [°C].

By this process, the first metallic film 710 and the second metallic film 740 are joined together. By the pressing at the time of the sticking and the subsequent annealing process, the first metallic film 710 and the second metallic film 740 are joined together with no gap even if the functional part 700 has warpage.

Further, by the annealing process, ohmic contact is obtained between the n+GaN layer 703 of the functional part 700 and the first layer 711 (Ti) and the second layer 712 (Al) of the first metallic film 710. Furthermore, the fifth layer 715 (Au) as the outermost layer of the first metallic film 710 deposited on the functional part 700 and the third layer 743 (Au) as the uppermost layer of the second metallic film 740 on the device substrate 730 are integrated together.

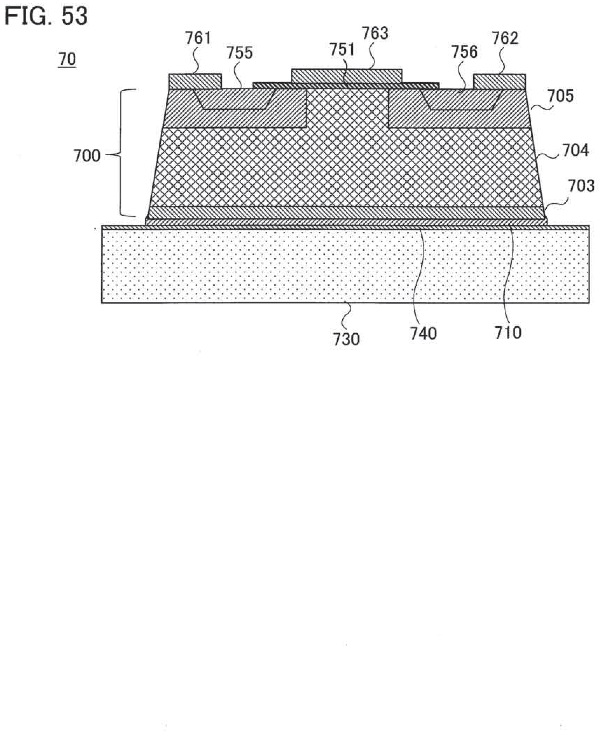

FIG. 52(B) is a cross-sectional view showing a process of patterning the insulation film 751. As shown in FIG. 52(B), the insulation film 751 on the functional part 700 is patterned and removed except for a part for forming a gate electrode 763 (FIG. 53) which will be described below.

FIG. 53 is a cross-sectional view showing a process of forming source electrodes 761 and 762 and the gate electrode 763. As shown in FIG. 53, the source electrode 761 is formed so as to straddle the n+GaN layer 755 on one side and the pGaN layer 705, and the source electrode 762 is formed so as to straddle the n+GaN layer 756 on the other side and the pGaN layer 705. The source electrodes 761 and 762 are made of Ti or Al, for example, and are formed by sputtering or vapor deposition.

Further, the gate electrode 763 is formed on the insulation film 751 straddling the two n+GaN layers 755 and 756. The gate electrode 763 is made of Pd or Mo, for example, and is formed by sputtering or vapor deposition.

As above, the source electrodes 761 and 762 and the gate electrode 763 are formed on the functional part 700, and the third layer 743 (Au) of the second metallic film 740 on the device substrate 730 turns into a drain electrode. By this process, the electronic device 70 as a vertical GaN field effect transistor of the planar type is completed.

As described above, the electronic device 70 in the seventh embodiment includes the functional part 700, the device substrate 730 as a substrate supporting the functional part 700, the first metallic film 710 as an electrode deposited on a side of the functional part 700 facing the device substrate 730, and the second metallic film 740 which is formed on the device substrate 730 and to which the first metallic film 710 is joined. The first metallic film 710 is deposited from the lower surface (first surface) 703a of the functional part 700 to parts of the side faces (second surfaces) 703b. Therefore, similarly to the first embodiment, even when the warpage of the functional part 700 has occurred, the functional part 700 can be excellently joined to the device substrate 730 and the peeling of the functional part 700 can be prevented.

The first to seventh embodiments described above can be combined appropriately.

The functional layer 102 (functional part) in the first embodiment is formed of AlN and the functional parts 200, 300, 400, 500, 600 and 700 in the second to seventh embodiments are formed of GaN. However, the functional part in the present disclosure is not limited to AlN and GaN; it is sufficient that the functional part is an epitaxial layer containing a nitride. Further, besides an epitaxial layer containing a nitride, the functional part may also be a GaAs-based semiconductor layer or an InP-based semiconductor layer, or a piezoelectric element layer made of PZT, LN, LT or the like, for example. Various layers of the functional part 200, 300, 400, 500, 600 and 700 are not limited to those described in the above-described embodiments, and the functional part may be a functional layer including a plurality of layers. The functional part may have a multilayer structure including semiconductor layers such as a nitride-containing semiconductor layer, a GaAs-based semiconductor layer, or an InP-based semiconductor layer which are stacked alone or in any combination. The functional part may have a multilayer piezoelectric element including piezoelectric layers such as PZT, LN, or LT which are combined alone or in any combination. Further, the functional part is not limited to only having the configuration described in the above-described embodiments, and may be configured as an element (for example, device) to include the configuration described in any of the above-described embodiments. For example, each of the functional layer 102 and the functional parts 200, 300, 400, 500, 600 and 700 may be configured as an element including an electrode (a Schottky electrode, a source electrode, a gate electrode or a drain electrode) and an insulation film depending on various devices.

While the functional layer (AlN layer, GaN layer) formed on the growth substrate is patterned into each element (each electronic device) and thereafter transferred onto the device substrate in the first to seventh embodiments, the embodiments are not limited to such examples. For example, it is also possible to form a functional layer (AlN layer, GaN layer) including a plurality of elements on the growth substrate, transfer the functional layer onto the device substrate, and thereafter pattern the functional layer into each element.

Furthermore, while the functional part in units of electronic devices is formed on the growth substrate and thereafter transferred onto the device substrate in the first to seventh embodiments, it is also possible to form N (e.g., 4) functional parts in a matrix (for example, two rows and two columns) on the growth substrate. In this case, it is possible to form the first metallic film on each of the N functional parts, form the second metallic film that can be joined to the N functional parts on the device substrate, and transfer the N functional parts onto the second metallic film. Further, it is also possible to form any of the functional layer 102 and the functional parts 200, 300, 400, 500, 600 and 700 as an element including a device structure such as an electrode (a Schottky electrode, a source electrode, a gate electrode or a drain electrode) and an insulation film depending on various devices on the growth substrate, and then the functional part may be transferred to the device substrate.

In the manufacturing method of the electronic device of each of the first to seventh embodiments, .the first substrate (e.g., growth substrate) and the functional part formed on the first substrate are separated from each other, and the first metallic film is deposited on a first surface (which is a surface separated from the growth substrate) of the functional part. Then, the first metallic film deposited on the first substrate and a second metallic film formed on a second substrate (e.g., device substrate) different from the first substrate. Accordingly, the functional part can be excellently joined to the second substrate from the first substrate different from the second substrate. Further, in this manufacturing method, it is not necessary to use an expensive GaN substrate as the first substrate (growth substrate), and therefore the manufacturing cost can be reduced.

In the above-described manufacturing method of the electronic structure, the functional part (which is epitaxially grown on the first substrate (e.g., growth substrate) via a buffer layer) and the buffer layer are separated from the first substrate, the buffer layer is removed from the functional part, and then the first metallic film is deposited on the first surface from which the buffer layer is removed. Since the buffer layer is removed as above, the first metallic film as an electrode can be directly formed on the functional part (e.g., n+GaN layer), and can be joined to the second metallic film on the second substrate (e.g., device substrate). Accordingly, it is possible to achieve, for example, a vertical structure GaN device having low electric resistance.

While preferred embodiments have been described specifically above, the present disclosure is not limited to the above-described embodiments and a variety of improvements or modifications are possible.

The present disclosure is applicable to electronic devices such as piezoelectric devices, photoelectric conversion devices (e.g., LED devices) and semiconductor devices (e.g., Schottky barrier diodes and field effect transistors) and their manufacturing methods.

### DESCRIPTION OF REFERENCE CHARACTERS

10, 20, 30, 40, 60, 70: electronic device, 101, 201, 301, 401, 501, 601, 701: growth substrate (first substrate), 101a, 201a, 301a, 401a, 501a, 601a, 701a: sacrificial layer, 102: functional layer (functional part), 102a, 203a, 303a, 403a, 503a, 603a, 703a: lower surface (first surface), 102b, 203b, 303b, 403b, 503b, 603b, 703b: side face (second surface), 110, 210, 310, 410, 510, 610, 710: first metallic film, 120, 220, 320, 420, 520, 620, 720: stamp (holding member), 130, 230, 330, 430, 530, 630, 730: device substrate (second substrate, substrate), 140, 240, 340, 440, 540, 640, 740: second metallic film, 200, 300, 400, 500, 600, 700: functional part, 202, 302, 402, 502, 602, 702: buffer layer, 203: n+GaN layer (contact layer), 204: n-GaN layer (drift layer), 230: device substrate, 303: nGaN layer (contact layer), 304: nAlGaN layer (cladding layer), 305: InGaN layer (active layer), 306: pAlGaN layer (cladding layer), 307: pGaN layer (contact layer), 403, 503, 603, 703: n+GaN layer (contact layer), 404, 504, 604, 704: n-GaN layer (drift layer), 405, 505, 605, 705: pGaN layer (contact layer), 406, 506, 606: n+GaN layer, 407, 507, 607: trench..

## Claims

1. An electronic device comprising:
a functional part;
a substrate that supports the functional part;
a first metallic film as an electrode deposited on a side of the functional part facing the substrate; and
a second metallic film which is formed on the substrate and to which the first metallic film is joined,
wherein the functional part includes:
a first surface that faces the substrate via the first metallic film; and
a second surface that extends from the first surface in a direction different from an extending direction of the first surface,
wherein the first metallic film is deposited from the first surface of the functional part to a part of the second surface.

2. The electronic device according to claim 1, wherein the functional part has an inclined surface that is inclined so that a size of the functional part in a plane parallel to the first surface decreases as a distance from the first surface increases, and
wherein the second surface is the inclined surface.

3. The electronic device according to claim 1 or 2, wherein the functional part includes:
a contact layer having the first surface and the second surface; and
at least one layer of semiconductor layer formed on the contact layer.

4. The electronic device according to any one of claims 1 to 3, wherein the first metallic film includes a plurality of metallic layers, and
wherein each of the plurality of metallic layers is deposited so as to cover a layer on its side closer to the functional part.

5. The electronic device according to any one of claims 1 to 4, wherein the functional part includes a first part and a second part arranged from a side close to the substrate, and
wherein a side face of the first part and a side face of the second part differ from each other in an inclination angle.

6. The electronic device according to any one of claims 1 to 5, wherein the first metallic film includes an Al layer and an Au layer, and
wherein a metal barrier layer containing at least one of Ti, Pt and Mo is formed between the Al layer and the Au layer.

7. The electronic device according to any one of claims 1 to 6, wherein the second metallic film includes a plurality of metallic layers.

8. The electronic device according to any one of claims 1 to 7, wherein the functional part is an epitaxial layer containing a nitride.

9. A manufacturing method of an electronic device, comprising:
depositing a first metallic film from a first surface of a functional part, which has the first surface and a second surface extending from the first surface in a direction different from an extending direction of the first surface, to a part of the second surface; and
joining the first metallic film deposited on the functional part and a second metallic film formed on a substrate together.

10. The manufacturing method of an electronic device according to claim 9, wherein the functional part is a functional part separated from a first substrate different from a second substrate as the substrate, and
wherein the first surface is a surface of the functional part on a side separated from the first substrate.

11. The manufacturing method of an electronic device according to claim 10, wherein the functional part epitaxially grown on the first substrate via a buffer layer and the buffer layer are separated from the first substrate before the deposition of the first metallic film,
wherein the buffer layer is removed from the functional part, and
wherein the first metallic film is formed on the first surface of the functional part from which the buffer layer was removed.

12. A manufacturing method of an electronic device, comprising:
separating a first substrate and a functional part, which is formed on the first substrate, from each other,
depositing a first metallic film on a first surface of the functional part, the first surface being a surface separated from the first substrate, and
joining the first metallic film deposited on the first substrate and a second metallic film formed on a second substrate different from the first substrate.

13. The manufacturing method of an electronic device according to claim 12, wherein the functional part, which is epitaxially grown on the first substrate via a buffer layer, and the buffer layer are separated from the first substrate, and
wherein the buffer layer is removed from the functional part, and then the first metallic film is deposited on the first surface from which the buffer layer is removed.
